# EUROPÄISCHE PATENTSCHRIFT

(11) **EP 3 721 472 B1**
(45) Veröffentlichungstag und Bekanntmachung des Hinweises auf die Patenterteilung: **30.09.2026**
(21) Anmeldenummer: 19701510.0
(22) Anmeldetag: 23.01.2019
(51) Int. Cl.: H10D 18/00, H10D 62/13, H10D 64/23, H10D 64/27, H10W 42/80, H10D 62/10

(54) **KURZSCHLUSS-HALBLEITERBAUELEMENT UND VERFAHREN ZU DESSEN BETRIEB**
SHORT-CIRCUIT SEMICONDUCTOR COMPONENT AND METHOD FOR OPERATING SAME
COMPOSANT À SEMI-CONDUCTEUR À COURT-CIRCUIT ET PROCÉDÉ DE FONCTIONNEMENT DE CELUI-CI

(30) Priorität: 01.02.2018 DE 102018102234
(43) Veröffentlichungstag der Anmeldung: 14.10.2020
(73) Patentinhaber: Infineon Technologies Bipolar GmbH & Co. KG, 59581 Warstein (DE)
(72) Erfinder: KELLNER-WERDEHAUSEN, Uwe, 91359 Leutenbach (DE); STELTE, Michael, 33178 Borchen-Etteln (DE); DROLDNER, Markus, 59229 Ahlen (DE); PIKORZ, Dirk, 59581 Warstein (DE); WEIDNER, Peter, 59494 Soest (DE); BARTHELMESS, Reiner, 59494 Soest (DE); SCHENK, Mario, 91074 Herzogenaurach (DE); PRZYBILLA, Jens, 59581 Warstein (DE)
(74) Vertreter: Westphal, Mussgnug & Partner, Patentanwälte mbB
(86) Internationale Anmeldenummer: PCT/EP2019/051557
(87) Internationale Veröffentlichungsnummer: WO 2019/149581

(56) Entgegenhaltungen:
- DE-A1- 1 489 092
- DE-A1- 102008 049 678
- JP-A- S57 118 671
- US-A- 5 969 922
- US-B1- 9 741 839

## Beschreibung

Die vorliegende Erfindung betrifft ein Kurzschluss-Halbleiterbauelement nach dem Oberbegriff des Anspruchs 1 sowie ein Verfahren zum Betreiben eines solchen Kurzschluss-Halbleiterbauelements nach dem Oberbegriff des Anspruchs 18.

Nach bestimmten Fehler- oder Störfällen können beispielsweise in Stromrichteranlagen sämtliche Komponenten und insbesondere die Leistungshalbleiter durch zu hohe Kurzschluss- oder Überlastströme, die bis zu mehrere 100 kA betragen können, zerstört werden. Um die Zerstörung der Komponenten in den Anlagen und insbesondere der Halbleiterkomponenten sicher zu vermeiden, ist der Einsatz vielfältiger Schutzeinrichtungen bekannt. Beim Auftreten des Fehlerfalles kann zum Beispiel durch einen Sicherheitsschalter in Form einer Kurzschlusseinrichtung eine definierte, dauerhaft niederohmige Verbindung (Kurzschluss) erzeugt werden. Die Schutzeinrichtung ist dabei einmalig auslösbar und bleibt nach erfolgter Auslösung durch ein elektrisches oder optisches Auslösesignal dauerhaft kurzgeschlossen.

So offenbart beispielsweise die DE 103 23 220 B4 eine Kurzschlussschaltung für einen fehlerhaften Teilumrichter, in der ein elektronisches Halbleiterbauelement im Fehlerfall entweder einen Kurzschlussstrom übernimmt oder in Abhängigkeit von einem solchen Kurzschlussstrom angesteuert wird und anschließend dauerhaft durchlegiert. Als elektronisches Halbleiterbauelement wird ein aktiver Halbleiterschalter vorgeschlagen, der insbesondere als herkömmlicher Thyristor ausgebildet sein kann. Im Fehlerfall wird dieser gezündet, wonach der durch den Thyristor fließende Kurschlussstrom eine lokale Überhitzung des Halbleitermaterials bewirkt, die den Kurzschluss-Thyristor zerstört. Dieser bildet danach einen dauerhaften Kurzschluss. Die Kontaktierung des Kurzschluss-Thyristors ist derart kurzschlussfest ausgelegt, dass sich bei ihm kein Lichtbogen aufgrund des hohen Kurzschlussstroms ausbilden kann. Hierzu wird unter anderem eine Druckkontaktierung vorgeschlagen.

Auch die DE 103 33 798 A1 beschreibt ein Verfahren zum Kurzschließen eines fehlerhaften Teilumrichters, bei dem im Fehlerfall stromführende Leistungshalbleiterschalter, die hier als IGBTs ausgebildet sind, kurzzeitig so eingeschaltet werden, dass diese dauerhaft durchlegieren. Um ein sicheres Durchlegieren der Halbleiterschalter zu gewährleisten, werden verschiedene Methoden vorgeschlagen: 1. Anheben der Gate-Emitter-Spannung der Leistungshalbleiterschalter; 2. Einschalten der Leistungshalbleiterschalter mit anschließendem schnellen Abschalten bei hohem Strom; 3. Extrem schnelles Einschalten der Leistungshalbleiterschalter; und 4. Mehrfaches Ein- und Ausschalten.

Des Weiteren offenbart die EP 3 001 525 A1 einen Kurzschlussschalter mit einem zum Kurschließen einer zwischen zwei Leitern anliegenden Spannung ansteuerbaren Halbleiterschalter. Der Halbleiterschalter ist ein herkömmlicher Thyristor vom Press-Pack-Typ mit flächigen Kontaktelektroden auf einander gegenüberliegenden Kontaktseiten. Bei der Montage des Halbleiterbauteils werden dessen Kontaktelektroden über flächige Anschlusselektroden kontaktiert, die mit hoher Steifigkeit elastisch gegeneinander beaufschlagt werden. Auf diese Weise wird die flächige Kontaktierung des Halbleiterbauteils auch unter hoher thermischer Belastung durch hohe fließende Leistungsströme sichergestellt. Der Thyristor ist in einer mechanischen Press-Pack-Struktur angeordnet, die eine den Thyristor umhüllende Schutzhülle ausbildet. Der Thyristor ist so ausgelegt, dass er durch einen beim Kurzschließen durch ihn fließenden Kurzschlussstrom als ansteuerbarer Halbleiterschalter irreversibel zerstört wird, wobei die Leitfähigkeit zwischen seinen Kontaktelektroden erhalten bleibt. Der Kurschlussstrom soll wenigstens das 50-fache des Nennstroms betragen, zu dessen Schalten der Thyristor ausgelegt ist.

Die Thyristorvorrichtungen sind auch aus den Dokumenten JP S57 118671, US 5 969 922 A und US 9 741 839 B1 bekannt.

Nachteilig bei der Verwendung eines herkömmlichen Thyristors als Kurzschlussschalter ist, dass nicht sichergestellt ist, bei welchem Strom der Thyristor zerstört wird und einen definierten Kurzschluss bildet, da der Stoßstromwert eines herkömmlichen Thyristors nach oben weit streut.

Die Realisierung eines "Short-on-Fail"-Zustandes durch ein gezieltes Durchlegieren wie vorstehend beschrieben kann durch einen geeigneten Modulaufbau wie zum Beispiel der Druckkontaktierung sicher gewährleistet werden. Hierbei befindet sich das Halbleiterbauelement in einem geeigneten Gehäuse, zum Beispiel einer Keramikzelle oder Keramikkapsel, deren äußeren Stromkontakte, üblicherweise der Kathoden- und Anodenanschluss, aus dicken Kupferstempeln (oder anderen leitenden Metallen) bestehen. Durch einen geeigneten Druckverbund wird sichergestellt, dass die beiden Kontaktstempel mit einem ausreichend hohen Druck gegen die jeweiligen metallischen Kontaktelektroden des Halbleiterbauelements kontaktiert sind, um einen besonders niedrigen elektrischen und thermischen Übergang zwischen dem Halbleiterbauelement und den Kupferstempeln des Gehäuses herzustellen. Wenn sich der Ort der Durchlegierung innerhalb des gedrückten Kontaktbereiches befindet, bleibt der Bereich der Zerstörung des Halbleiterbauelements innerhalb der gedrückten Kontaktfläche, sowohl während des Fehlerfalles, in dem es zum Aufschmelzen bzw. Durchlegieren kommt, als auch beim dauerhaften Stromfluss nach dem Fehlerfall. Das Gehäuse nimmt äußerlich keinen oder kaum Schaden, der Energieumsatz während und nach dem Fehlerfall erfolgt im Inneren des Halbleiterbauteils und bleibt dort innerhalb des druckkontaktierten Bereiches begrenzt. Entscheidend ist, dass die elektrische Verbindung im Bauteil durch den Fehlerfall nicht getrennt wird, wie das zum Beispiel bei einem Lötbondbauteil auftreten kann, bei dem der Strom über Bonddrähte fließt. Hier kommt es bei hohen Strömen zu einer galvanischen Trennung der Anschlüsse im Bauteil infolge einer Aufschmelzung der Bonddrähte oder Lötverbindungen. Dies führt zwangsläufig wegen der sehr hohen Energie im Fehlerfall zur kompletten Zerstörung des gesamten Halbleiterbauteils, was auch eine hohe Gefährdung der Anlage in der Umgebung des Bauteiles darstellt. Die Bonddrähte liegen relativ offen innerhalb des das Halbleiterbauteil umgebenden Gehäuses, oft auch in einem Gel eingebettet, weswegen es zu einer explosionsartigen Zerstörung infolge eines Lichtbogens zwischen den unterbrochenen Bonddrähten kommt. Im Gegensatz hierzu wird bei einem druckkontaktierten Bauteil der Energieumsatz im Silizium bzw. der Schmelzbereich bzw. Lichtbogen innerhalb des von den anoden- und kathodenseitigen Kontaktscheiben kontaktierten Bereichs begrenzt, so dass selbst bei höchsten Stromdichten eine Explosion bzw. Zerstörung der unmittelbaren Umgebung des Bauteils weitestgehend vermieden wird.

Wird ein herkömmlicher Thyristor mit seinem Stoßstromgrenzwert belastet, verliert er kurzzeitig, das heißt reversibel, wegen der starken großflächigen Erwärmung in seiner Kathodenfläche, teilweise oder ganz seine Blockier- und Sperrfähigkeit, bis die Sperrschichttemperatur wieder auf den für Dauerbetrieb zulässigen Bereich gesunken ist. Die zulässige Stoßstromdichte im Strommaximum eines einzelnen 10 ms-Impulses, bei der es noch nicht zu einer irreversiblen Zerstörung kommt, liegt typischerweise zwischen 1,0 und 1,5 kA/cm². Wird dieser Grenzwert deutlich überschritten, führt die Erwärmung zu Aufschmelzungen (Durchlegierung) innerhalb der Kathodenfläche, der Thyristor wird zerstört und verliert irreversibel seine Sperrfähigkeit bzw. seine Steuerfunktion. Solange sich die Aufschmelzungen innerhalb des von den Kupferkontaktscheiben bzw. den Kupferstempeln der Kapsel kontaktierten und gedruckten Bereichs und gleichzeitig ausreichend weit weg vom Randbereich des Thyristors befinden, bleiben sowohl die Kapsel als auch die unmittelbare Umgebung weitestgehend intakt.

Ein wesentlicher Nachteil eines beispielsweise in der DE 10 2008 049 678 A1 oder DE 10 2009 045 216 A1 beschriebenen, herkömmlichen Thyristors als Kurzschlussschutzeinrichtung ist jedoch seine große Kathodenfläche, die auf einen möglichst geringen Leit- oder Durchlassverlust bzw. auf eine maximale Stoßstromfähigkeit ausgelegt wird. Ihr Durchmesser entspricht etwa demjenigen der Kontaktscheiben des Kupferstempels oder ist in der Regel noch ein wenig größer (bis zu ca. 0,5 bis 2 mm). Kommt es infolge eines hohen Kurzschlussstromes in der Kathodenfläche zur gewollten Durchlegierung, ist nicht sichergestellt, dass diese weit genug vom Randbereich des Thyristors entfernt auftritt. Als Randbereich kann der radial äußere Bereich des Bauelements verstanden werden, der nicht durch die die Kontaktelektroden (insbesondere die Kathoden- und Anodenanschlüsse) des Halbleiterbauelements gewöhnlich druckkontaktierenden Kontaktscheiben von z. B. Kupferstempeln bedeckt bzw. gedrückt ist. Der durchlegierte Bereich befindet sich irgendwo innerhalb der Kathodenfläche und kann sich auch in den Randbereich hinein ausdehnen. In diesem Fall kann es zu einer Zerstörung des Keramikgehäuses und zum Plasmaaustritt kommen. Ein Plasmaaustritt könnte ebenso in einem Zentrum des Halbleiterbauelements auftreten, wenn nämlich beispielsweise eine Gate-Elektrode oder eine Hilfsthyristorstruktur (Amplifying-Gate-Struktur) im Zentrum des Halbleiterbauelements angeordnet ist, die ebenfalls nicht von den Kontaktscheiben der das Halbleiterbauelements druckkontaktierenden Kupferstempels bedeckt bzw. gedrückt ist/sind.

Auch ist der Randbereich eines Thyristors im Vergleich zur restlichen Fläche, welche durch die Kupferkontaktscheiben direkt kontaktiert bzw. abgedeckt ist, sehr viel anfälliger gegenüber auftretenden Überspannungen. Ein solcher Ausfall führt in Verbindung mit dem dann fließenden Kurzschlussstrom wegen der sehr hohen Energiedichte, besonders bei einer hohen Sperrspannung, zur Zerstörung der Kapsel wie weiter oben bereits beschrieben wurde. Die Festigkeit gegenüber solchen Überspannungen ließe sich zwar durch verschiedene Maßnahmen erheblich verbessern, dies ist aber mit gravierenden Nachteilen verbunden. Zum Beispiel würde ein sehr viel dickerer Siliziumausgangswafer die Sperrfähigkeit deutlich erhöhen und damit ließe sich die Wahrscheinlichkeit für einen Randausfall verursacht durch eine Überspannung weitestgehend vermeiden. Dies ist aber wegen der dann zu hohen dynamischen Verluste und Durchlassverluste bei einer herkömmlichen Thyristorstruktur nicht sinnvoll möglich, da der Thyristor dann die an ihn gestellten Anforderungen, vor allem niedrigste Durchlassverluste und maximales Stoßstromverhalten sowie niedrigste dynamische Verluste nicht mehr erfüllen kann.

Fällt der Thyristor zum Beispiel bei anliegender Sperrspannung U_{R} aus, zum Beispiel hervorgerufen durch eine Überspannung oder einer Sperrinstabilität der Passivierung seiner Randkontur, so befindet sich der Ausfallort meistens im Randbereich des Thyristorbauteils und damit außerhalb des durch die Kupferkontaktscheiben direkt kontaktierten Bereichs. Es fließt ein sehr hoher Kurzschlussstrom in Sperrrichtung, wobei der ungestörte Bereich nicht am Stromfluss beteiligt ist, während es am Ausfallort zu einer Aufschmelzung kommt. Im Inneren der Gehäusekapsel bzw. am Ausfallort kommt es zu einem Lichtbogen, das geschmolzene Material verdampft und es entsteht heißes Plasma, das je nach Stärke zur Zerstörung der Kapsel führen kann. Durch diese explosionsartige Entladung kann in der Nähe der Aufschmelzung die Keramikkapsel reißen, aus der dann heißes Plasma entweicht. Ein solcher Randausfall kann auch bei anliegender Blockierspannung U_{D} auftreten.

Vor diesem Hintergrund liegt der vorliegenden Erfindung die Aufgabe zugrunde, ein Kurzschluss-Halbleiterbauelement bereitzustellen, mit dem in Abhängigkeit von einem Auslöse- bzw. Einschaltsignal eine an dem Halbleiterbauelement anliegende elektrische Spannung sicher und dauerhaft (langzeitstabil) kurzgeschlossen werden kann, ohne dass hierbei Plasma explosionsartig aus dem Halbleiterbauelement austritt. Darüber hinaus soll das Halbleiterbauelement im normalen, nicht kurzgeschlossenen Betriebsfall einen Stromfluss durch dieses hindurch bei an ihm anliegender elektrischer Spannung zuverlässig und langzeitstabil in beiden Richtungen bzw. Polaritäten sperren können. Außerdem sollen die Sperrverluste in diesem Betriebsfall derart gering ausfallen, dass es ohne aktive Kühlung betrieben werden kann. Ferner soll ein Verfahren zum Betreiben eines Kurzschluss-Halbleiterbauelements bereitgestellt werden.

Diese Aufgabe wird durch ein Kurzschluss-Halbleiterbauelement mit den Merkmalen des Anspruchs 1 sowie durch ein Verfahren zum Betreiben eines Kurzschluss-Halbleiterbauelements mit den Merkmalen des Anspruchs 18 gelöst.

Weitere, besonders vorteilhafte Ausgestaltungen der Erfindung offenbaren die Unteransprüche.

Es ist darauf hinzuweisen, dass die in der nachfolgenden Beschreibung einzeln aufgeführten Merkmale in beliebiger, technisch sinnvoller Weise miteinander kombiniert werden können und weitere Ausgestaltungen der Erfindung aufzeigen. Die Beschreibung charakterisiert und spezifiziert die Erfindung insbesondere im Zusammenhang mit den Figuren zusätzlich.

Erfindungsgemäß weist ein Kurzschluss-Halbleiterbauelement einen Halbleiterkörper auf, in dem in einer vertikalen Richtung ausgehend von einer Rückseite mit einem durch ihren geometrischen Schwerpunkt festgelegten rückseitigen Zentrum hin zu einer der Rückseite gegenüberliegenden Vorderseite mit einem durch ihren geometrischen Schwerpunkt festgelegten vorderseitigen Zentrum eine rückseitige Basiszone von einem ersten Leitungstyp, zum Beispiel vom p-Typ, eine Innenzone von einem zum ersten Leitungstyp komplementären zweiten Leitungstyp, zum Beispiel vom n-Typ, und eine vorderseitige Basiszone vom ersten Leitungstyp aufeinanderfolgend angeordnet sind. Ferner ist die rückseitige Basiszone mit einer auf der Rückseite aufgebrachten rückseitigen Elektrode (Metallisierung, zum Beispiel Aluminium) mit einer durch ihre laterale Erstreckung gegebenen lateralen rückseitigen Elektrodenweite elektrisch leitend verbunden. Die vorderseitige Basiszone ist mit einer auf der Vorderseite aufgebrachten vorderseitigen Elektrode (Metallisierung, zum Beispiel Aluminium) mit einer durch ihre laterale Erstreckung gegebenen lateralen vorderseitigen Elektrodenweite elektrisch leitend verbunden. Erfindungsgemäß ist weiterhin in die vorderseitige Basiszone wenigstens eine vorderseitige Einschaltstruktur mit einer durch ihre laterale Erstreckung gegebenen lateralen vorderseitigen Einschaltstrukturweite eingebettet und von der vorderseitigen Elektrode wenigstens teilweise überdeckt und/oder in die rückseitige Basiszone wenigstens eine rückseitige Einschaltstruktur mit einer durch ihre laterale Erstreckung gegebenen lateralen rückseitigen Einschaltstrukturweite eingebettet und von der rückseitigen Elektrode wenigstens teilweise überdeckt. Die Einschaltstruktur ist hierbei derart ausgebildet und angeordnet, in Abhängigkeit von einem dem Halbleiterkörper zugeführten, vorherbestimmbaren Einschaltsignal einzuschalten und einmalig eine dauerhafte, irreversible, elektrisch leitende, niederohmige Verbindung zwischen der vorderseitigen Elektrode und der rückseitigen Elektrode herzustellen. Die Erfindung sieht außerdem vor, dass bei Vorhandensein der vorderseitigen Einschaltstruktur das Verhältnis der lateralen vorderseitigen Einschaltstrukturweite zur lateralen vorderseitigen Elektrodenweite kleiner 1 ist und dass bei Vorhandensein der rückseitigen Einschaltstruktur das Verhältnis der lateralen rückseitigen Einschaltstrukturweite zur lateralen rückseitigen Elektrodenweite kleiner 1 ist, wobei die Einschaltstruktur eine in die vorderseitige oder rückseitige Basiszone eingebettete, mit der auf der jeweiligen Basiszone aufgebrachten Elektrode elektrisch leitend kontaktierte Emitterstruktur vom zweiten Leitungstyp (n) ist, die mittels wenigstens einer auf diese elektrisch über den Halbleiterkörper einwirkende Zündstruktur einschaltbar ist, wobei die Zündstruktur wiederum mittels des Einschaltsignals aktivierbar ist, und wobei ein spezifischer Flächenwiderstand der die Emitterstruktur enthaltenden Basiszone so eingestellt ist, dass ein aus dem Einschaltsignal gewonnener, der Emitterstruktur zugeführter minimaler Einschaltstrom eine Stromstärke von wenigstens 1 A, bevorzugt wenigstens etwa 2 A und noch bevorzugter zwischen etwa 5 A und etwa 10 A zum Einschalten der Emitterstruktur aufweist.

Es sei angemerkt, dass die zwischen zwei Merkmalen stehende und diese miteinander verbindende Konjunktion "und/oder" hierin stets so auszulegen ist, dass in einer ersten Ausgestaltung des erfindungsgemäßen Gegenstands lediglich das erste Merkmal vorhanden sein kann, in einer zweiten Ausgestaltung lediglich das zweite Merkmal vorhanden sein kann und in einer dritten Ausgestaltung sowohl das erste als auch das zweite Merkmal vorhanden sein können.

Als laterale Erstreckungsrichtung im Halbleiterkörper wird hierin eine zur vertikalen Erstreckungsrichtung des Halbleiterkörpers im Wesentlichen senkrechte Richtung verstanden. Im Falle eines beispielsweise als Zylinder (mit geringer Höhe) ausgebildeten Halbleiterkörpers entspricht demnach die vertikale Erstreckungsrichtung der Richtung der Zylinderhöhe und die laterale Richtung der radialen Richtung des Zylinders. Die Begriffe lateral und radial werden hierin gleichbedeutend verwendet.

Weiterhin ist anzumerken, dass sich das vorderseitige Zentrum und das rückseitige Zentrum des Kurzschluss-Halbleiterbauelements unterscheiden können, was jedoch nicht zwingend erforderlich ist und gewöhnlich auch nicht der Fall ist. Die beiden Zentren legen gewöhnlich eine Symmetrieachse des Halbleiterkörpers fest, von dem aus der Radius des Halbleiterkörpers bestimmt wird. Wenn im Folgenden von einem Zentrum bezüglich einer vorderseitigen Komponente des Kurzschluss-Halbleiterbauelements die Rede ist, so ist bei diesem Zentrum stets das vorderseitige Zentrum zu verstehen, sofern dies hierin nicht ausdrücklich anders bestimmt ist. Ebenso ist bei einer Beziehung zwischen einem Zentrum und einer rückseitigen Komponente des Halbleiterkörpers entsprechend das rückseitige Zentrum zu verstehen, sofern dies hierin nicht ausdrücklich anders bestimmt ist.

Die laterale Weite einer Gesamtstruktur, zum Beispiel einer Einschaltstruktur oder einer Elektrode, ergibt sich damit aus einem Abstand einer die Gesamtstruktur radial am weitesten nach innen begrenzenden Innenseite zu einer die Gesamtstruktur radial am weitesten nach außen begrenzenden Außenseite. Dies ist unmittelbar einleuchtend für Strukturen des Halbleiterkörpers, die zu ihrem radialen Zentrum (r = 0), das heißt dem geometrischen Schwer- bzw. Mittelpunkt der Vorder- und/oder Rückseite des Halbleiterkörpers, beabstandet angeordnet sind. In dem Spezialfall, dass die Gesamtstruktur keinen Abstand zum radialen Zentrum aufweist, das heißt mit ihrer radialen Innenseite bis an das radiale Zentrum heranreicht, entspricht die laterale Weite der Gesamtstruktur dem Abstand einer die Gesamtstruktur radial nach außen begrenzenden Außenseite zum radialen Zentrum. Mit anderen Worten entspricht in diesem Fall die laterale Weite dem Radius (gemessen vom radialen Zentrum) der Gesamtstruktur oder auch ihrem halben Durchmesser.

Somit weist der Halbleiterkörper des erfindungsgemäßen Kurzschluss-Halbleiterbauelements zwischen seiner vorderseitigen Elektrode bzw. vorderseitigen Metallisierung und seiner rückseitigen Elektrode bzw. rückseitigen Metallisierung eine pnp- bzw. npn-Struktur auf, die das Bauelement für eine zwischen der vorderseitigen Elektrode und der rückseitigen Elektrode anliegende elektrische Spannung in beiden Richtungen bzw. Polaritäten zuverlässig und langzeitstabil sperrt. Dieser Zustand wird hierin als normaler, nicht kurzgeschlossener Betriebszustand des erfindungsgemäßen Kurzschluss-Halbleiterbauelements bezeichnet.

Kommt es hingegen bei einem Störfall in einer durch das erfindungsgemäße Kurzschluss-Halbleiterbauelement zu schützenden elektrischen Anlage zu einer Überlastung durch einen zu hohen Strom, der bis zu mehrere 100 kA betragen kann, wird das erfindungsgemäße Kurzschluss-Halbleiterbauelement durch das Einschaltsignal mittels der wenigstens einen Einschaltstruktur einmalig eingeschaltet und ist danach dauerhaft und irreversibel zwischen den äußeren Metallanschlüssen, das heißt zwischen der vorderseitigen und rückseitigen Elektrode, kurzgeschlossen. Das erfindungsgemäße Kurzschluss-Halbleiterbauelement ist danach nicht mehr sperrfähig. Dieser Zustand wird hierin als kurzgeschlossener Betriebszustand oder Kurzschlusszustand des erfindungsgemäßen Kurzschluss-Halbleiterbauelements bezeichnet.

Das Einschalten bzw. Aktivieren der Einschaltstruktur infolge des Zuführens des vorherbestimmbaren Einschaltsignals zum Halbleiterkörper führt gezielt zum einmaligen Herstellen der dauerhaften, irreversiblen, elektrisch leitenden, niederohmigen Verbindung zwischen der vorderseitigen Elektrode und der rückseitigen Elektrode (permanenter Kurzschluss).

Der permanente Kurzschluss entsteht hierbei durch das gezielte Einschalten auf einer lokal begrenzten Fläche im Bauelement, die im Wesentlichen durch das jeweilige Verhältnis der lateralen vorderseitigen Einschaltstrukturweite zur lateralen vorderseitigen Elektrodenweite (falls eine vorderseitige Einschaltstruktur im Halbleiterkörper vorhanden ist) bzw. der lateralen rückseitigen Einschaltstrukturweite zur lateralen rückseitigen Elektrodenweite (falls eine rückseitige Einschaltstruktur im Halbleiterkörper vorhanden ist) bestimmt ist, so dass es dort anschließend infolge der hohen Stromdichte zu einer Aufschmelzung im stromführenden Bereich kommt. Bei dieser Aufschmelzung, die auch als Durchlegieren bezeichnet wird, kommt es zu einem Verschmelzen der Materialien der äußeren Metallanschlüsse (z. B. Aluminium, Molybdän und/oder Kupfer) und dem Silizium des Halbleiterkörpers. Nach dem Schmelzvorgang bildet sich eine metallische Zone mit hoher Leitfähigkeit aus, welche die äußeren Metallanschlüsse dauerhaft kurzschließt und prinzipiell auch in der Lage ist, diese Kurzschlussfunktion unter Strombelastung über eine längere Dauer aufrechtzuerhalten, zum Beispiel bis zur nächsten Instandsetzung.

Entsprechend der vorstehenden Beschreibung wird gemäß einem weiteren Aspekt der Erfindung auch ein Verfahren zum Betreiben eines Kurzschluss-Halbleiterbauelements gemäß Anspruch 18, das die hierin beschriebenen erfindungsgemäßen Merkmale aufweist, offenbart.

Bei der Betrachtung des Verhältnisses zwischen der lateralen Einschaltstrukturweite und der jeweiligen lateralen Elektrodenweite wird gemäß der vorliegenden Erfindung stets die laterale Einschaltstrukturweite der vorderseitigen Einschaltstruktur, sofern diese im Halbleiterkörper vorhanden ist, mit der lateralen Elektrodenweite der vorderseitigen Elektrode verglichen und die laterale Einschaltstrukturweite der rückseitigen Einschaltstruktur, sofern diese im Halbleiterkörper vorhanden ist, mit der lateralen Elektrodenweite der rückseitigen Elektrode verglichen. Dementsprechend wird hierin auch von einer Zuordnung der vorderseitigen Einschaltstruktur zur vorderseitigen Elektrode und von einer Zuordnung der rückseitigen Einschaltstruktur zur rückseitigen Elektrode gesprochen.

Bei dem Störfall wird also einmalig ein Einschaltsignal erzeugt, mit dem die wenigstens eine vorderseitige und/oder rückseitige Einschaltstruktur derart aktiviert bzw. eingeschaltet wird, dass eine elektrisch leitende, niederohmige Verbindung zwischen den beiden äußeren elektrischen Anschlüssen, das heißt zwischen der vorderseitigen und rückseitigen Elektrode, des erfindungsgemäßen Kurzschluss-Halbleiterbauelements und der zwischen diesen beiden Elektroden angeordneten pnp- bzw. npn-Struktur hergestellt wird. Es kommt zu einem Stromfluss (Kurzschlussstrom) zwischen der vorderseitigen und rückseitigen Elektrode. Es hat sich gezeigt, dass die Stromtragfähigkeit der vorderseitigen bzw. rückseitigen Einschaltstruktur im Wesentlichen durch das jeweilige Verhältnis ihrer lateralen Einschaltstrukturweite zur lateralen Elektrodenweite der jeweils zugeordneten vorder- bzw. rückseitigen Elektrode bestimmt ist. Im Vergleich zu einem herkömmlichen Thyristor, bei dem dieses Verhältnis im Wesentlichen bei 1 liegt, um einen maximalen Stoßstrom und geringste Leitverluste realisieren zu können, ist die Stromtragfähigkeit der vorder- und/oder rückseitigen Einschaltstruktur bei dem erfindungsgemäßen Kurzschluss-Halbleiterbauelement aufgrund des hierin jeweils definierten Verhältnisses kleiner 1 derart definiert begrenzt, dass das Einschalten des erfindungsgemäßen Kurzschluss-Halbleiterbauelements sicher zu seiner Durchlegierung führt. Nach der Durchlegierung befindet sich das Kurzschluss-Halbleiterbauelement in einem permanenten, nicht reversiblen, niederohmig stromführenden Zustand zwischen der vorderseitigen und rückseitigen Elektrode, so dass eine zwischen diesen beiden Elektroden anliegende elektrische Spannung dauerhaft und langzeitstabil kurzgeschlossen werden kann. Mit anderen Worten ist der Spannungsabfall zwischen der vorderseitigen und rückseitigen Elektrode des erfindungsgemäßen Kurzschluss-Halbleiterbauelements im Kurzschlussfall so gering (niederohmig stromführender Zustand), dass auch bei länger andauerndem Kurzschlussbetrieb die elektrischen Verluste im erfindungsgemäßen Kurzschluss-Halbleiterbauelement gering sind und daher in vorteilhafter Weise auf eine aktive Kühlung verzichtet werden kann.

Im Sinne der vorliegenden Erfindung ist die vorstehende Bedingung "kleiner 1" stets so auszulegen, dass herstellungsbedingte Größenabweichungen zwischen der jeweiligen lateralen Einschaltstrukturweite und der lateralen Elektrodenweite der der betrachteten Einschaltstruktur jeweils zugeordneten Elektrode, die innerhalb der für das jeweilige Herstellungsverfahren des erfindungsgemäßen Kurzschluss-Halbleiterbauelements definierten Herstellungstoleranzen liegen, nicht von der hierin verwendeten Bedingung "kleiner 1" erfasst sind. Mit anderen Worten ist gemäß der vorstehenden Definition ein Verhältnis einer lateralen Einschaltstrukturweite zu einer lateralen Elektrodenweite der entsprechenden Elektrode erst dann als im Sinne der vorliegenden Erfindung "kleiner 1" anzusehen, wenn sich die beiden verglichenen lateralen Weiten in ihrer Größe so sehr voneinander unterscheiden, dass dieser Größenunterschied sicher nicht mehr den herstellungsbedingten Toleranzabweichungen des betreffenden Merkmals zuzurechnen ist, sondern das Ergebnis zielgerichteten Handelns ist.

Es hat sich gezeigt, dass bei einer gegebenen vertikalen Dicke der Halbleiterinnenzone des Halbleiterkörpers der Aufschmelzstrom im Wesentlichen proportional zur Fläche der vorderseitigen und/oder rückseitigen Einschaltstruktur ist und sich somit festlegen lässt. Die im Vergleich zur lateralen Elektrodenweite der jeweiligen Elektrode (wesentlich) kleinere laterale Einschaltstrukturweite der entsprechenden Einschaltstruktur erlaubt zudem eine lokale Begrenzung der Durchlegierung im Kurzschluss-Halbleiterbauelement derart, dass sich die Ausdehnung der Durchlegierung in lateraler bzw. radialer Richtung im Wesentlichen auf die Fläche der vorder- und/oder rückseitigen Einschaltstruktur begrenzen lässt. Somit lässt sich der Bereich der Durchlegierung jedenfalls ausreichend weit von einem äußeren Randbereich des erfindungsgemäßen Kurzschluss-Halbleiterbauelements fernhalten. Die Durchlegierung findet dementsprechend ausschließlich im von der vorderseitigen und rückseitigen Elektrode überdeckten inneren Bereich des Kurzschluss-Halbleiterbauelements statt, so dass im Kurzschlussbetrieb keine mechanische Zerstörung des Kurzschluss-Halbleiterbauelements in seinem Randbereich auftritt, die einen Plasmaaustritt aus dem Kurzschluss-Halbleiterbauelement und damit eine Zerstörung eines das Kurzschluss-Halbleiterbauelement möglicherweise umgebenden Gehäuses zur Folge haben könnte.

Es sei an dieser Stelle noch angemerkt, dass das Verhältnis der lateralen vorderseitigen Einschaltstrukturweite zur lateralen vorderseitigen Elektrodenweite kleiner 1 bzw. das Verhältnis der lateralen rückseitigen Einschaltstrukturweite zur lateralen rückseitigen Elektrodenweite kleiner 1 für jeden beliebig betrachteten Ort des erfindungsgemäßen Kurzschluss-Halbleiterbauelements gelten soll. Wenn das erfindungsgemäße Kurzschluss-Halbleiterbauelement beispielsweise als Zylinder mit vollkommen rotationssymmetrischem Aufbau der vorderseitigen und/oder rückseitigen Einschaltstruktur und der entsprechenden Elektrode (vorderseitig und/oder rückseitig) ausgebildet ist, so gilt die Betrachtung des vorstehend definierten Verhältnisses an genau einem beliebigen Ort am Kurzschluss-Halbleiterbauelement unmittelbar auch für alle anderen Orte am Kurzschluss-Halbleiterbauelement. Verändert sich jedoch die laterale Einschaltstrukturweite und/oder die laterale Elektrodenweite bei dem beispielhaft gewählten zylinderförmigen Kurzschluss-Halbleiterbauelement je nach betrachteter Position entlang des Umfangs des Kurzschluss-Halbleiterbauelements, das heißt das Kurzschluss-Halbleiterbauelement ist hinsichtlich der betrachteten Einschaltstruktur und/oder der dieser zugeordneten Elektrode nicht rotationssymmetrisch aufgebaut, so kann sich auch das Verhältnis der lateralen Einschaltstrukturweite zur lateralen Elektrodenweite abhängig von der betrachteten Umfangsposition ändern. Nach vorstehender Definition soll dieses im Sinne der Erfindung jedoch an jedem beliebig betrachteten Ort am Kurzschluss-Halbleiterbauelement kleiner 1 sein.

Weiterhin ist zu verstehen, dass im Sinne der vorliegenden Erfindung in einem Fall, in dem eine Einschaltstruktur in vertikaler Richtung im Wesentlichen keine konstante Einschaltstrukturweite aufweist, für die Betrachtung des Verhältnisses zwischen der Einschaltstrukturweite und der Elektrodenweite der der Einschaltstruktur entsprechend zugeordneten Elektrode die in vertikaler Richtung größte auftretende Einschaltstrukturweite als für den Vergleich zu verwendende Einschaltstrukturweite heranzuziehen ist.

Besonders bevorzugt kann das Verhältnis der lateralen Einschaltstrukturweite zur lateralen Elektrodenweite der jeweils der vorderseitigen bzw. rückseitigen Einschaltstruktur entsprechend zugeordneten vorderseitigen bzw. rückseitigen Elektrode kleiner als 4/5 gewählt sein, zum Beispiel auch kleiner als 3/4, 2/3, 1/2, 1/3, 1/4, 1/5. Somit wird die laterale Einschaltstrukturweite der vorderseitigen bzw. rückseitigen Einschaltstruktur bei dem erfindungsgemäßen Kurzschluss-Halbleiterbauelement jedenfalls wesentlich kleiner gewählt als die laterale Elektrodenweite der jeweiligen Elektrode. Hierdurch lässt sich der Aufschmelzstrom, bei dem es sicher zur Durchlegierung des erfindungsgemäßen Kurzschluss-Halbleiterbauelements kommt, auf einen gewünscht kleinen Wert festlegen. Somit ist sichergestellt, dass auch ein relativ kleiner, von dem erfindungsgemäßen Kurzschluss-Halbleiterbauelement zwischen der vorderseitigen Elektrode und der rückseitigen Elektrode geführter Fehler- bzw. Kurzschlussstrom das Bauelement in gewünschter Weise sicher durchlegiert und somit den nicht reversiblen, niederohmig stromführenden Zustand herstellt (kurzgeschlossener Betriebszustand).

Eine vorteilhafte Ausgestaltung der Erfindung sieht vor, dass die Einschaltstruktur vollständig von der vorderseitigen Elektrode und der rückseitigen Elektrode überdeckt ist, wobei hierunter die Überdeckung in lateraler Richtung zu verstehen ist. Die vollständige vorder- und rückseitige Überdeckung der wenigstens einen Einschaltstruktur bietet den Vorteil, dass die Möglichkeit eines Plasmaaustritts aus dem Halbleiterkörper infolge der Durchlegierung noch weiter verringert wird, da sich die Durchlegierung beim erfindungsgemäßen Kurzschluss-Halbleiterbauelement im Wesentlichen derart lokal begrenzen lässt, dass diese im von den beiden Elektroden überdeckten Bereich stattfindet, wie bereits vorstehend beschrieben wurde. Damit wird auch eine Zerstörung eines das Kurzschluss-Halbleiterbauelement möglicherweise umgebenden Gehäuses aufgrund eines auf diese Weise unterbundenen Plasmaaustritts aus dem Kurzschluss-Halbleiterbauelement während der Durchlegierung sicher verhindert. Bevorzugt kann die Überdeckung der jeweiligen Einschaltstruktur von der vorder- bzw. rückseitigen Elektrode im äußeren Randbereich (also in Richtung zum radialen Außenrand des erfindungsgemäßen Kurzschluss-Halbleiterbauelements) im Bereich von wenigstens einigen Millimetern liegen, z. B. etwa 1 mm bis 5 mm oder größer.

Weiterhin kann die wenigstens eine Einschaltstruktur vorzugsweise zentrumsnah im Halbleiterkörper angeordnet sein. Hierunter ist zu verstehen, dass der radiale Abstand von einer die Einschaltstruktur radial am weitesten nach innen begrenzenden Innenseite zum entsprechenden Zentrum des Halbleiterkörpers, das heißt dem geometrischen Schwer- bzw. Mittelpunkt der Vorder- und/oder Rückseite des Halbleiterkörpers (hierin auch als radiales Zentrum bezeichnet), kleiner ist als der Abstand von einer die Einschaltstruktur radial am weitesten nach außen begrenzenden Außenseite zu einem radialen Außenrand des Halbleiterkörpers. Auch durch diese Maßnahme wird in erster Linie die Möglichkeit eines Plasmaaustritts bei der Durchlegierung des erfindungsgemäßen Kurzschluss-Halbleiterbauelements im Randbereich des Halbleiterkörpers weiter verringert, da die Durchlegierung auf einen zentrumsnahen Bereich des Halbleiterkörpers zwischen der vorderseitigen und der rückseitigen Elektrode begrenzt wird, der von ebendiesen Elektroden überdeckt ist. Eine Zerstörung eines das Kurzschluss-Halbleiterbauelement möglicherweise umgebenden Gehäuses infolge der Durchlegierung wird somit ebenfalls sicher verhindert.

Eine weitere vorteilhafte Ausgestaltung der Erfindung sieht vor, dass die vorderseitige Elektrode und die rückseitige Elektrode das vorderseitige beziehungsweise rückseitige Zentrum des Halbleiterkörpers überdecken und die Einschaltstruktur in diesem Zentrum angeordnet ist. Hierdurch lässt sich der Abstand von einer die Einschaltstruktur radial nach außen begrenzenden Außenseite zu einem radialen Außenrand des Halbleiterkörpers maximieren und damit der Randbereich des Halbleiterkörpers sowie zusätzlich der Bereich zwischen der radialen Außenseite der Einschaltstruktur und dem radialen Außenrand des Halbleiterkörpers abhängig von der gewählten lateralen Elektrodenweite der vorderseitigen und rückseitigen Elektrode, die erfindungsgemäß stets größer ist als die laterale Einschaltstrukturweite, durch die Überdeckung der Vorder- und Rückseite des Halbleiterkörpers vor einem unerwünschten Plasmaaustritt infolge der Durchlegierung des Kurzschluss-Halbleiterbauelements sicher schützen.

Gemäß der Erfindung ist die Einschaltstruktur eine in die vorderseitige oder rückseitige Basiszone eingebettete, mit der auf der jeweiligen Basiszone aufgebrachten Elektrode (vorderseitige bzw. rückseitige Elektrode) elektrisch leitend kontaktierte Emitterstruktur vom zweiten Leitungstyp, zum Beispiel vom n-Typ, die mittels wenigstens einer auf diese elektrisch über den Halbleiterkörper einwirkende Zündstruktur einschaltbar ist. Die Zündstruktur ist hierbei wiederum mittels des Einschaltsignals aktivierbar. Es ist zu verstehen, dass eine mit der vorderseitigen Elektrode elektrisch leitend kontaktierte Emitterstruktur eine vorderseitige Einschaltstruktur ist, bei welcher die Emitterstruktur vom zweiten Leitungstyp in die vorderseitige Basiszone vom ersten Leitungstyp angrenzend an die Vorderseite des Halbleiterkörpers derart eingebettet ist, dass sie durch das Aufbringen der vorderseitigen Elektrode auf die Vorderseite des Halbleiterkörpers elektrisch leitend kontaktiert ist. Sinngemäß verhält es sich mit einer mit der rückseitigen Elektrode elektrisch leitend kontaktierten Emitterstruktur, die dementsprechend eine rückseitige Einschaltstruktur ist, bei welcher die Emitterstruktur vom zweiten Leitungstyp in die rückseitige Basiszone vom ersten Leitungstyp angrenzend an die Rückseite des Halbleiterkörpers derart eingebettet ist, dass sie durch das Aufbringen der rückseitigen Elektrode auf die Rückseite des Halbleiterkörpers elektrisch leitend kontaktiert ist. Die Kontaktierung der Emitterstruktur mit der jeweiligen vorderseitigen oder rückseitigen Elektrode erfolgt hierbei bevorzugt durch unmittelbaren Kontakt zwischen den jeweiligen Komponenten.

Die als Emitterstruktur ausgebildete Einschaltstruktur mit einer gewissen lateralen Einschaltstrukturweite bietet den Vorteil, dass sich das Stromplasma vor dem Einsetzen der Durchlegierung über die Fläche der Emitterstruktur ausdehnen kann mit dem Ergebnis, dass die Durchlegierung eine größere laterale Weite und damit insgesamt einen größeren Querschnitt aufweist. Der auf diese Weise erzielte größere Leitungsquerschnitt des durchlegierten Bereichs im Halbleiterkörper bringt in vorteilhafter Weise eine Verringerung des elektrischen Widerstands des durch die Durchlegierung gebildeten Kurzschlussgebiets im Halbleiterkörper mit sich. Dementsprechend kann das Kurzschlussgebiet höhere Kurzschlussströme mit geringen Leitungsverlusten dauerhaft führen. Auf eine aktive Kühlung des erfindungsgemäßen Halbleiter-Bauelements kann vorteilhafterweise verzichtet werden.

Gemäß einer noch weiteren vorteilhaften Ausgestaltung der Erfindung ist die Zündstruktur eine Gate-Elektrode und das Einschaltsignal ein der Gate-Elektrode zugeführtes elektrisches Signal. Besonders bevorzugt kann in diesem Fall wenigstens ein Bereich der die Emitterstruktur enthaltenden Basiszone, der die elektrische Wirkverbindung zwischen der Gate-Elektrode und der Emitterstruktur bildet, derart ausgebildet sein, dass ein der Gate-Elektrode zugeführtes elektrisches Signal mit einer Stromstärke von wenigstens etwa 1 A, bevorzugt wenigstens etwa 2 A und noch bevorzugter zwischen etwa 5 A und etwa 10 A zum Einschalten der Emitterstruktur verwendbar ist.

Der Zünd- bzw. Einschaltstrom eines herkömmlichen Thyristors hängt vom spezifischen Flächenwiderstand seiner kathodenseitigen Basiszone ab, in die der kathodenseitige Emitter eingebettet ist, und muss prozesstechnisch so eingestellt werden, dass die Zünd- bzw. Einschaltstromwerte typischerweise im mA-Bereich liegen, insbesondere Werte zwischen 30 mA (125 °C) und 400 mA (Raumtemperatur) annehmen und dementsprechend innerhalb eines relativ engen Bereiches liegen. Damit wird zum Beispiel sichergestellt, dass herkömmliche Thyristoren die hohen Einschaltbelastungen beim Schalten sehr hoher Ströme mit sehr hohen Stromsteilheiten zu Beginn des Einschaltens sicher überstehen, wenn sie von üblichen Zünd- bzw. Einschaltstromgeneratoren mit genau definierten Zünd- bzw. Einschaltstromverläufen (Zünd-/Einschaltstromamplitude und -dauer) angesteuert werden.

Da das erfindungsgemäße Kurzschluss-Halbleiterbauelement nach dem einmaligen Auslösen durchlegiert sein soll, wird für das Kurzschluss-Halbleiterbauelement ein wesentlich höherer minimaler Einschaltstrom gewählt, im Ampere-Bereich, wenigstens 1 A oder wenigstens 2 A oder sogar wenigstens 5 A bis etwa 10 A, da sich hierdurch einerseits der Aufwand für die Kontrolle des spezifischen Flächenwiderstands der die Emitterstruktur enthaltenden Basiszone bei der Herstellung des Kurzschluss-Halbleiterbauelements wesentlich verringern lässt und andererseits an die das elektrische Einschaltsignal erzeugenden Zünd- bzw. Einschaltstromgeneratoren erheblich geringere Anforderungen gestellt werden können, so dass kostengünstigere Ansteuerungskonzepte möglich sind.

Weiterhin ist zu verstehen, dass trotz des bei dem erfindungsgemäßen Kurzschluss-Halbleiterbauelement gemäß dieser Ausführungsform gewählten verhältnismäßig hohen Zünd- bzw. Einschaltstroms das erfindungsgemäße Kurzschluss-Halbleiterbauelement dennoch nur schwach übersteuert angesteuert wird, also z. B. mit einer Übersteuerung von 10 A/5 A = 2. Wird hingegen bei einem herkömmlichen Thyristor ein Zünd- bzw. Einschaltstrom anstatt im mA-Bereich wie vorstehend erläutert im Ampere-Bereich, z. B. im Bereich zwischen 5 A und 10 A, verwendet, führt dies zu einer um ein oder zwei Größenordnung höher liegenden Übersteuerung eines herkömmlichen Thyristors mit einem Übersteuerungsfaktor von beispielsweise 10 A/100 mA = 100. Der große Übersteuerungsfaktor ermöglicht dem herkömmlichen Thyristor ein schnelles Einschalten. Bei dem erfindungsgemäßen Kurzschluss-Halbleiterbauelement fördert eine schwach gewählte Übersteuerung (mit einem dennoch hohen Zünd- bzw. Einschaltstrom im Ampere-Bereich) den gewünschten Ausfall des Bauelements, das heißt die gewünschte einmalige, irreversible Durchlegierung.

Ein hoher Einschaltstrom bringt darüber hinaus weitere Vorteile. So lässt sich beispielsweise eine einfache Detektion zur Überprüfung der Einsatzbereitschaft des Kurzschluss-Halbleiterbauelements durch einen dauerhaften Prüfstrom zwischen den Anschlüssen der Gate-Elektrode und der Elektrode, welche die durch die Gate-Elektrode einzuschaltende Emitterstruktur kontaktiert (vorderseitige oder rückseitige Elektrode), bereitstellen, wobei der Prüfstrom dann sehr viel kleiner als der Einschaltstrom gewählt wird. Darüber hinaus bietet ein hoher Einschaltstrom auch einen höheren EMV-Schutz beispielsweise gegenüber Fehlzündungen verursacht durch schnelle Änderungen von sehr hohen Spannungen und Strömen im Umfeld des Kurzschluss-Halbleiterbauelements, da die Anfälligkeit gegenüber solchen Fehlzündungen mit kleiner werdendem Zünd- bzw. Einschaltstrom zunimmt.

Neben den vorstehend beschriebenen Einschaltstromstärken sind in speziellen Fällen auch Einschaltströme deutlich kleiner als 1 A im Kurzschluss-Halbleiterbauelement gemäß der Erfindung einstellbar, zum Beispiel Einschaltstromstärken kleiner als 1 A bis hinunter zu etwa 500 mA oder noch kleiner bis hin zu etwa 100 mA.

Eine weitere vorteilhafte Ausgestaltung der Erfindung sieht vor, dass die Zündstruktur ein in der die Emitterstruktur enthaltenden Basiszone angeordneter lichtempfindlicher Bereich ist und das Einschaltsignal ein diesem lichtempfindlichen Bereich zugeführtes optisches Signal ist. Als Lichtquelle sind zum Beispiel Laser oder kostengünstigere LEDs geeignet. Der Vorteil des optischen Einschaltsignals gegenüber einem elektrischen Einschaltsignal ist ein besserer EMV-Schutz, da eine optische Zuleitung des Einschaltsignals zur lichtempfindlichen Zündstruktur im Halbleiterkörper (zum Beispiel über Glasfaser) im Vergleich zur elektrischen Zuleitung gänzlich unempfindlich ist gegenüber einer Fehlzündung durch sehr hohe elektrische und magnetische Felder, hervorgerufen durch sehr hohe Strom- und Spannungsänderungen im Umfeld des Kurzschluss-Halbleiterbauelements. Weiterhin bietet ein optisches Einschaltsignal Vorteile bei hohen am Kurzschluss-Halbleiterbauelement anliegenden Potentialunterschieden (Isolation gegenüber sehr hohen Spannungsunterschieden im 10 kV bis 100 kV-Bereich).

Darüber hinaus bietet das im Fehlerfall einmalig durchgeführte Einschalten des Kurzschluss-Halbleiterbauelements mittels des optischen Einschaltsignals gegenüber einem herkömmlichen, lichtzündbaren Thyristor weitere Vorteile. Da das optische Einschaltsignal bei dem erfindungsgemäßen Kurzschluss-Halbleiterbauelement nur einmalig im Fehlerfall erzeugt wird, bestehen keine besonderen Anforderungen hinsichtlich einer Alterung der optischen Ansteuereinheit, wie dies beispielsweise bei einem Laser der Fall ist, wenn dieser periodisch über einen Zeitraum von mehreren Jahrzehnten ein Signal ausreichender Stärke bereitstellen muss. Daher sind auch keine Mindestzündleistungen erforderlich. In vorteilhafter Weise kann anstelle eines Lasers eine wesentlich kostengünstigere LED als optische Ansteuereinheit eingesetzt werden. Im Vergleich zu einem herkömmlichen lichtzündenden Thyristor können weitere integrierte Schutzfunktionen wie beispielsweise ein BOD-Schutz (BOD: Break Over Diode) oder ein du/dt-Schutz entfallen, was ein einfacheres Gate-Design ermöglicht. Hierdurch ist eine erhebliche Vereinfachung der optischen Ansteuereinheit inklusive eines Lichtleitersystems gegenüber herkömmlichen optischen Ansteuereinheiten möglich.

Gemäß einer weiteren vorteilhaften Ausgestaltung der Erfindung ist die Zündstruktur eine Durchbruchstruktur und das Einschaltsignal die zwischen der vorderseitigen Elektrode und der rückseitigen Elektrode anliegende elektrische Spannung. Die Durchbruchstruktur ist dadurch gekennzeichnet, dass sie abhängig von der an den äußeren Elektroden des Kurzschluss-Halbleiterbauelements anliegenden elektrischen Spannung, die einen entsprechenden Spannungsabfall über der Durchbruchstruktur bewirkt, bei Erreichen bzw. Überschreiten einer für die Durchbruchstruktur bestimmbaren Durchbruchspannung einen steilen Stromanstieg in Form eines Avalanchestroms, der vorzugsweise nicht durch einen Schutzwiderstand begrenzt ist, zulässt, durch den die mit der als Zündstruktur ausgebildete Durchbruchstruktur elektrisch wirkverbundene Emitterstruktur (Einschaltstruktur) einschaltbar ist.

Die Durchbruchstruktur kann beispielsweise als BOD-Struktur (BOD: Break Over Diode) ausgebildet sein. Andere funktionell ähnlich wirkende, an sich beispielsweise von herkömmlichen lichtzündbaren Thyristoren (LTT) bekannte Durchbruchstrukturen sind ebenfalls verwendbar, zum Beispiel eine einen gewöhnlichen du/dt-Schutz aufweisende Durchbruchstruktur und/oder eine einen gewöhnlichen Freiwerdezeitschutz mit lokaler Anhebung der Ladungsträgerlebensdauer aufweisende Durchbruchstruktur. Die Durchbruchstruktur stellt darüber hinaus eine weitere Maßnahme zur Vermeidung eines Sperrausfalls in einem radial äußeren Randbereich des Kurzschluss-Halbleiterbauelements im Falle einer nicht vorhersehbaren Überspannung dar. Die Höhe der Durchbruchspannung der Durchbruchstruktur wird dabei so eingestellt, dass sie an genau dem Ort der Durchbruchstruktur ihren niedrigsten Wert des ganzen Halbleiterkörpers annimmt und so einen Durchbruch im Randbereich sicher verhindert. Hierzu ist die Durchbruchstruktur bevorzugt randfern, insbesondere zentrumsnah, im Halbleiterkörper angeordnet. Beispielsweise kann die Durchbruchstruktur in Form einer das Zentrum umgebenden, jedoch von diesem (geringfügig) beabstandeten, umfänglich geschlossenen Struktur wie zum Beispiel einer Ring- und/oder Polygonstruktur ausgebildet sein. Sie kann jedoch in anderen Fällen auch direkt im Zentrum des Halbleiterkörpers angeordnet sein. Als umfängliche Richtung ist hierin eine Erstreckungsrichtung parallel zur Vorderseite bzw. Rückseite des Halbleiterkörpers und im Wesentlichen senkrecht zur radialen bzw. lateralen Richtung des Halbleiterkörpers zu verstehen.

Eine noch weitere vorteilhafte Ausgestaltung der Erfindung sieht vor, dass in der die Emitterstruktur enthaltenden Basiszone zwischen der Zündstruktur und der mit dieser elektrisch wirkverbundenen Emitterstruktur eine Amplifying-Gate-Struktur mit wenigstens einem Amplifying-Gate angeordnet ist. Insbesondere bei Vorhandensein einer als Durchbruchstruktur ausgebildeten Zündstruktur bietet die wenigstens eine Amplifying-Gate-Stufe (hierin auch als AG-Stufe bezeichnet) den wesentlichen Vorteil, eine Temperaturabhängigkeit der Höhe der Durchbruchspannung der Durchbruchstruktur, insbesondere einer BOD-Struktur, im Halbleiterkörper und damit einhergehend auch die Höhe der Stromdichte des Sperrstroms, welcher zum Einschalten der Einschaltstruktur und letztendlich zur Durchlegierung des Kurzschluss-Halbleiterbauelements führen soll, sowie die Abhängigkeit der Höhe der Durchbruchspannung vom spezifischen Widerstand des die Durchbruchstruktur umgebenden Halbleitermaterials, das heißt seiner Dotierstoffkonzentration, weitestgehend zu begrenzen bzw. zu verringern, da eine oder mehrere AG-Stufen das temperaturabhängige Verhalten der Durchbruchstruktur, zum Beispiel einer BOD-Struktur, wenigstens teilweise kompensieren kann. Der Durchbruchstrom (Avalanchestrom) wirkt beim Durchbruch der Durchbruchstruktur bei Erreichen bzw. Überschreiten der Durchbruchspannung als Einschaltsignal für das wenigstens eine Amplifying-Gate, was wiederum zum Einschalten eventuell nachgeschalteter weiterer Amplifying-Gate-Stufen und letztendlich zum Einschalten der eigentlichen Einschaltstruktur führt.

In einer konstruktiv besonders günstig herzustellenden Ausgestaltung der Erfindung weist eine Einschaltstruktur, die zum Beispiel aufgrund einer im Zentrum des Halbleiterkörpers angeordneten Zündstruktur dieses Zentrum und die Zündstruktur beabstandend umgebend angeordnet ist, einen geschlossenen Umfang auf. Die Einschaltstruktur kann beispielsweise als geschlossene Ring- und/oder Polygonstruktur ausgebildet sein. Als umfängliche Richtung ist hierin eine Erstreckungsrichtung der Einschaltstruktur parallel zur Vorderseite bzw. Rückseite des Halbleiterkörpers und im Wesentlichen senkrecht zur radialen bzw. lateralen Richtung des Halbleiterkörpers zu verstehen.

Gemäß einer noch weiteren vorteilhaften Ausgestaltung der Erfindung ist die Einschaltstruktur in radialer Richtung von der Zündstruktur beabstandet und weist wenigstens ein in einer Umfangsrichtung des Halbleiterkörpers offenes Einschaltstruktursegment mit einer umfänglichen Einschaltstrukturweite auf. Mit anderen Worten ist die Einschaltstruktur in diesem Ausführungsbeispiel umfänglich nicht geschlossen, wie dies zum Beispiel bei einer geschlossenen Ring- und/oder Polygonstruktur der Fall ist. Das heißt die umfängliche Einschaltstrukturweite des wenigstens einen Einschaltstruktursegments ist jedenfalls kleiner als eine umfängliche Einschaltstrukturweite, die einer geschlossenen Ring- und/oder Polygonstruktur der Einschaltstruktur und damit einem Umfangswinkel der geschlossenen ring- und/oder polygonförmigen Einschaltstruktur von 360 Grad entsprechen würde. Da eine zum Zentrum des Halbleiterkörpers in radialer Richtung beabstandete Einschaltstruktur mit einer umfänglich geschlossenen Polygon- und/oder Ringstruktur herstellungsbedingt eine gewisse Mindestfläche aufweist, da beispielsweise die laterale Einschaltstrukturweite prozesstechnisch nicht kleiner als eine bestimmte laterale Mindeststrukturweite herstellbar ist, die zum Beispiel wenigstens etwa 50 µm betragen kann, lässt sich durch die vorliegende vorteilhafte Ausgestaltung des erfindungsgemäßen Kurzschluss-Halbleiterbauelements die für die Aufschmelzung des Halbleiterkörpers wirksame Fläche der Einschaltstruktur noch weiter verkleinern, wodurch sich auch besonders kleine Aufschmelzströme, die zum sicheren Durchlegieren des Halbleiterkörpers führen, realisieren lassen. Es wäre demnach zum Beispiel möglich, ein minimales, einzelnes Einschaltstruktursegment mit einer lateralen Einschaltstrukturweite von etwa 50 µm und einer umfänglichen Einschaltstrukturweite, das heißt einer Umfangslänge, von ebenfalls etwa 50 µm im Halbleiterkörper vorzusehen, was die Auslegung eines erfindungsgemäßen Kurzschluss-Halbleiterbauelements mit einem Aufschmelzstrom in der Größenordnung von wenigen mA ermöglicht.

Gemäß einer noch weiteren vorteilhaften Ausgestaltung der Erfindung sind in Umfangsrichtung des Halbleiterkörpers wenigstens zwei voneinander getrennte Einschaltstruktursegmente vorgesehen. Diese sind vorzugsweise äquidistant zueinander beabstandet, um eine im Wesentlichen umfänglich symmetrische Ausgestaltung des Kurzschluss-Halbleiterbauelements zu erzielen, die eine gleichmäßigere Stromverteilung im Halbleiterkörper sowohl des Einschaltstroms zum Einschalten der Einschaltstruktur als auch des Aufschmelzstroms zum Herstellen der Durchlegierung im Halbleiterkörper und damit eine gleichmäßigere Wärmeverteilung, insbesondere während des Durchlegierens, über den gesamten Halbleiterkörper, das heißt eine gleichmäßiger verteilte mechanische Belastung, bewirkt.

Eine noch weitere vorteilhafte Ausgestaltung der Erfindung sieht vor, dass der elektrische Widerstand in der die Einschaltstruktur enthaltenden Basiszone wenigstens in einem Abschnitt des radialen Zwischenraums zwischen der Einschaltstruktur und der Zündstruktur (hierin auch als Widerstandsbereich der Basiszone bezeichnet) mit Ausnahme wenigstens eines das wenigstens eine der Einschaltstruktursegmente mit der Zündstruktur elektrisch koppelnden Durchgangskanals erhöht ist. Hierdurch lässt sich der von der Zündstruktur zur Einschaltstruktur fließende Einschaltstrom gezielt auf das einzelne Einschaltstruktursegment lenken, um dieses im Bedarfsfall zum Einleiten der Durchlegierung des erfindungsgemäßen Kurzschluss-Halbleiterbauelements sicher einzuschalten. Durch den gezielt mittels des Durchlasskanals auf das wenigstens eine Einschaltstruktursegment geleiteten Einschaltstrom lässt sich der zum Einschalten des bzw. aller Einschaltstruktursegmente notwendige, von der Zündstruktur bereitgestellte Gesamteinschaltstrom gegenüber einer ansonsten in allen radialen Richtungen homogen verlaufenden Einschaltstromverteilung in vorteilhafter Weise zusätzlich verringern.

Unter einem erhöhten Widerstand im Widerstandsbereich der Basiszone im Vergleich zum Widerstandswert im Durchlasskanal ist ein solcher Größenunterschied der Widerstände zu verstehen, der sicher nicht den herstellungsbedingten Größenabweichungen von gewöhnlich in Kauf genommenen Herstellungstoleranzen zuzurechnen ist, sondern das Ergebnis zielgerichteten Handelns ist. So kann der Widerstand im Widerstandsbereich beispielsweise durch eine im Vergleich zum Rest der Basiszone wesentlich geringere Konzentration der Ladungsträger vom selben Leitungstyp wie jener der restlichen Basiszone gezielt erhöht werden und/oder durch Einbringen eines so genannten Pinch-Widerstands mit einem zum Leitungstyp der Basiszone komplementären Leitungstyp in den Widerstandsbereich der Basiszone, wodurch der Widerstand im Widerstandsbereich der Basiszone aufgrund einer Verkleinerung des wirksamen Leitungsquerschnitts in der Basiszone ebenfalls gezielt erhöht wird.

Eine weitere vorteilhafte Ausgestaltung der Erfindung sieht vor, dass die Einschaltstruktur eine Durchbruchstruktur ist und das Einschaltsignal die zwischen der vorderseitigen Elektrode und der rückseitigen Elektrode anliegende elektrische Spannung ist. Wie bereits vorstehend im Zusammenhang mit der als Zündstruktur ausgebildeten Durchbruchstruktur erläutert, ist auch die als Einschaltstruktur ausgebildete Durchbruchstruktur dadurch gekennzeichnet, dass diese abhängig von der an den äußeren Elektroden des Kurzschluss-Halbleiterbauelements anliegenden elektrischen Spannung, die einen entsprechenden Spannungsabfall über der Durchbruchstruktur bewirkt, bei Erreichen bzw. Überschreiten einer für die Durchbruchstruktur bestimmbaren Durchbruchspannung einen steilen Stromanstieg in Form eines Avalanchestroms, der vorzugsweise nicht durch einen Schutzwiderstand begrenzt ist, zulässt, durch den die gewünschte Durchlegierung des Kurzschluss-Halbleiterbauelements herbeigeführt wird.

Auch die als Einschaltstruktur ausgebildete Durchbruchstruktur kann beispielsweise als BOD-Struktur (BOD: Break Over Diode) ausgebildet sein. Andere funktionell ähnlich wirkende, an sich beispielsweise von herkömmlichen lichtzündbaren Thyristoren (LTT) bekannte Durchbruchstrukturen sind ebenfalls verwendbar, zum Beispiel eine einen gewöhnlichen du/dt-Schutz aufweisende Durchbruchstruktur und/oder eine einen gewöhnlichen Freiwerdezeitschutz mit lokaler Anhebung der Ladungsträgerlebensdauer aufweisende Durchbruchstruktur. Die Durchbruchstruktur stellt darüber hinaus eine weitere Maßnahme zur Vermeidung eines Sperrausfalls in einem radial äußeren Randbereich des Kurzschluss-Halbleiterbauelements im Falle einer nicht vorhersehbaren Überspannung dar. Die Höhe der Durchbruchspannung der Durchbruchstruktur wird dabei so eingestellt, dass sie an genau dem Ort der Durchbruchstruktur ihren niedrigsten Wert des ganzen Halbleiterkörpers annimmt und so einen Durchbruch im Randbereich sicher verhindert. Hierzu ist die Durchbruchstruktur bevorzugt randfern, insbesondere zentrumsnah, im Halbleiterkörper angeordnet. Beispielsweise kann die Durchbruchstruktur in Form einer das Zentrum umgebenden, jedoch von diesem (geringfügig) beabstandeten, umfänglich geschlossenen Struktur wie zum Beispiel einer Ring- und/oder Polygonstruktur ausgebildet sein. Sie kann jedoch in anderen Fällen auch direkt im Zentrum des Halbleiterkörpers angeordnet sein, zum Beispiel in solchen Fällen, in denen wenigstens das Zentrum sowohl auf der Vorderseite als auch auf der Rückseite des erfindungsgemäßen Kurzschluss-Halbleiterbauelements von der jeweiligen Elektrode überdeckt ist, wie vorstehend im Zusammenhang mit einer erfindungsgemäßen Ausgestaltung des Kurzschluss-Halbleiterbauelements bereits beschrieben wurde.

Da eine wie vorstehend beschriebene als Zündstruktur oder Einschaltstruktur ausgebildete Durchbruchstruktur ihr Einschaltsignal aus der an den äußeren beiden Elektroden des Halbleiterkörpers anliegenden elektrischen Spannung bezieht und dem Kurzschluss-Halbleiterbauelement somit kein weiteres externes, zum Beispiel optisches oder elektrisches, Einschaltsignal zugeführt werden muss, sofern die Einschaltstruktur oder die einer Einschaltstruktur zugeordnete Zündstruktur lediglich als Durchbruchstruktur ausgebildet ist, kann zur Aufnahme des derart ausgebildeten Kurzschluss-Halbleiterbauelements in besonders vorteilhafter Weise ein Diodengehäuse verwendet werden, das keinen zusätzlichen Anschluss für ein zusätzliches externes Einschaltsignal aufweist. Besonders bevorzugt kann in einem solchen Fall die Durchbruchstruktur im Zentrum des Halbleiterkörpers angeordnet sein, wobei sich die vorder- und rückseitigen Elektroden vollständig über das Zentrum und damit über die Einschaltstruktur hinweg erstrecken können, da keine Aussparung zur Zuführung eines externen Einschaltsignals vorgesehen werden muss.

Gemäß einer weiteren vorteilhaften Ausgestaltung der Erfindung weist die Einschaltstruktur wenigstens einen sich vom Rest der Einschaltstruktur in lateraler Richtung radial nach außen erstreckenden Einschaltstrukturfinger auf (auch als Verfingerung der Einschaltstruktur bezeichnet). Mit anderen Worten steht der wenigstens eine Einschaltstrukturfinger vom Rest der Einschaltstruktur in radialer Richtung nach außen vor. Wie bereits weiter oben ausgeführt wurde, bestimmt sich das minimale Schmelzstromintegral, bei dem es zur Durchlegierung des Kurzschluss-Halbleiterbauelements kommen soll, im Wesentlichen durch die laterale Einschaltstrukturweite der jeweiligen Einschaltstruktur, zum Beispiel durch eine laterale Emitterstrukturweite einer Emitterstruktur oder durch eine laterale Durchbruchstrukturweite einer Durchbruchstruktur, und damit gleichbedeutend durch die bei der Aufschmelzung des Halbleiterkörpers wirksame Fläche der Einschaltstruktur. Mit anderen Worten hat ein gemäß der Erfindung angestrebtes kleines Verhältnis der lateralen Einschaltstrukturweite der entsprechenden Einschaltstruktur zur lateralen Elektrodenweite der zugehörigen Elektrode, die auf der die Einschaltstruktur aufweisenden Basiszone aufgebracht ist, einen gewünscht kleinen Aufschmelzstrom, bei dem es sicher zur Durchlegierung des Kurzschluss-Halbleiterbauelements kommt, zur Folge, so dass auch ein relativ kleiner von dem Kurzschluss-Halbleiterbauelement zwischen der vorderseitigen und rückseitigen Elektrode geführter Fehler- bzw. Kurzschlussstrom das Kurzschluss-Halbleiterbauelement in gewünschter Weise sicher durchlegiert und somit den nicht reversiblen, niederohmig stromführenden Zustand herstellt (kurzgeschlossener Betriebszustand).

Andererseits sollte die wirksame Fläche der Einschaltstruktur, zum Beispiel einer Emitterstruktur oder einer Durchbruchstruktur, und damit auch die gesamte Fläche des Halbleiterkörpers generell an die Höhe des von dem Kurzschluss-Halbleiterbauelement im Kurschlussfall dauerhaft aufzunehmenden Kurzschlussstromes angepasst sein um zu verhindern, dass bei einer zu kleinen Fläche der Einschaltstruktur der Schmelzvorgang gleich zu Beginn des Stromflusses explosionsartig einsetzt und dies zu einer mechanischen Zerstörung des gesamten Kurzschluss-Halbleiterbauelements führen und damit eine Gefährdung der Umgebung darstellen könnte. Eine größere Fläche der Einschaltstruktur kann sich günstig auf die Größe der lateralen Ausdehnung des durchlegierten Bereichs auswirken, wobei eine lateral weitere Ausdehnung des durchlegierten Bereichs aufgrund eines größer resultierenden Leitungsquerschnitts in vorteilhafter Weise eine Verringerung des elektrischen Widerstands des durch die Durchlegierung gebildeten Kurzschlussgebiets im Halbleiterkörper zur Folge hat. Die Verfingerung der Einschaltstruktur ermöglicht in vorteilhafter Weise einen Kompromiss zwischen den gegensätzlichen Forderungen nach einer möglichst kleinen Fläche der Einschaltstruktur zur Herabsenkung des für die sichere Durchlegierung erforderlichen Kurzschluss- bzw. Aufschmelzstroms und einer ausreichend großen Fläche zum sicheren Führen des Kurzschlussstroms, ohne eine mechanische Zerstörung des Kurzschluss-Halbleiterbauelements in Kauf nehmen zu müssen, denn bei der verfingerten Einschaltstruktur kann sich der durch das Einschaltsignal eingeschaltete, stromführende Bereich des Kurzschluss-Halbleiterbauelements über einen größeren Umfang verteilen.

Die Verfingerung der Einschaltstruktur hilft außerdem, den Aufschmelzbereich vom Zentrum des Kurzschluss-Halbleiterbauelements fernzuhalten. Dies ist insbesondere dann von besonderem Vorteil, wenn sich im Zentrum des Halbleiterkörpers eine Zündstruktur befindet, der ein externes Einschaltsignal (z. B. optisch oder elektrisch) zum Einschalten der Einschaltstruktur bzw. des Kurzschluss-Halbleiterbauelements zugeführt wird. In einem solchen Fall ist nämlich der Bereich, in dem das Einschaltsignal der Zündstruktur zugeführt wird, nicht von der den elektrischen Hauptanschluss für das Kurzschlusshalbleiterbauelement bereitstellenden Elektrode (z. B. Kathoden- oder Anodenelektrode) bedeckt, die auf der die Einschaltstruktur aufweisenden Basiszone aufgebracht ist, so dass Plasma beim Durchlegieren aus dem Bereich der unbedeckten Vorder- und/oder Rückseite des Halbleiterkörpers entweichen könnte und infolgedessen zu einer Beschädigung eines das Kurzschluss-Halbleiterbauelement umgebenden Gehäuses und damit zu einer Gefährdung der Umgebung führen könnte.

Eine weitere vorteilhafte Ausgestaltung der Erfindung sieht vor, dass bei Vorhandensein wenigstens einer Zündstruktur und einer wie vorstehend beschriebenen verfingerten Einschaltstruktur die Zündstruktur wenigstens einen der Kontur bzw. Form des wenigstens einen Einschaltstrukturfingers entsprechenden bzw. folgenden Zündstrukturfinger aufweist. Hierdurch kann ein über den gesamten Verlauf der verfingerten Einschaltstruktur gleichmäßiger Abstand, zum Beispiel in lateraler bzw. radialer Richtung und/oder in vertikaler Richtung, zwischen der Zündstruktur und der Einschaltstruktur gewährleistet werden, so dass die Zündstruktur gleichmäßig über den gesamten Verlauf der Einschaltstruktur auf diese im Sinne der vorliegenden Erfindung einwirken kann.

Gemäß einer weiteren bevorzugten Ausgestaltung der Erfindung weist der wenigstens eine Einschaltstrukturfinger eine maximale laterale, das heißt radiale, Fingerlänge auf, die kleiner ist als 4/5 der lateralen Elektrodenweite der Elektrode, die auf der die Einschaltstruktur aufweisenden Basiszone aufgebracht ist. Somit kann die maximale radiale Fingerlänge beispielsweise auch kleiner sein als 3/4, 2/3, 1/2, 1/3, 1/4, 1/5 der lateralen Elektrodenweite. Bei Vorhandensein einer ebenfalls verfingerten, der Verfingerung der Einschaltstruktur entsprechenden bzw. folgenden Zündstruktur wie vorstehend beschrieben kann ebenso der wenigstens eine Zündstrukturfinger eine Fingerlänge aufweisen, die der Fingerlänge des jeweiligen Einschaltstrukturfingers entspricht.

Gemäß einer noch weiteren vorteilhaften Ausgestaltung der Erfindung ist eine Dicke der Innenzone in vertikaler Richtung größer als 400 µm, bevorzugter größer als 600 µm und noch bevorzugter größer als 800 µm oder 900 µm oder sogar 1000 µm. Generell ist festzustellen, dass der Gefahr eines Randausfalles des Kurzschluss-Halbleiterbauelements im Falle einer Überspannung durch eine im Vergleich zu einem herkömmlichen Thyristor deutlich dickere Innenzone des Halbleiterkörpers vorgebeugt werden kann. Es gibt praktisch keine maximale Dicke für diese Innenzone, wie das bei einem herkömmlichen Thyristor der Fall ist, da es für das erfindungsgemäße Kurzschluss-Halbleiterbauelement keine Leit- oder dynamischen Verluste gibt, die die Dicke der Innenzone nach oben begrenzen. So wäre für eine geforderte Spannungsklasse von zum Beispiel V_{DRM}/V_{RRM} = 2.2 kV ein herkömmlicher Thyristor mit einer Dicke Wₙ₁ im Bereich von etwa 320 µm und einem spezifischen Siliziumwiderstand von 85 Ω·cm einzusetzen. Für das Kurzschluss-Halbleiterbauelement der vorliegenden Erfindung kann hingegen zum Beispiel eine Dicke Wₙ von etwa 850 µm gewählt werden. Mit einem spezifischen Widerstand von 270 Ω·cm ergäbe sich für die Halbleiterstruktur des erfindungsgemäßen Halbleiterkörpers mehr als die zweifache symmetrische Sperrfähigkeit (V_{DRM}/V_{RRM} = 5.2 kV). Selbst Sperrfähigkeiten > 10 kV (Mittelspannungsnetze) sind bei entsprechender Auslegung der Dicke der Innenzone möglich. Zusammen mit der entsprechenden Einstellung der Lebensdauer durch eine hohe Bestrahlungsdosis für die Elektronenbestrahlung kann der Sperrstrom sehr niedrig eingestellt werden. Damit kann das Sperrvermögen des Kurzschluss-Halbleiterbauelements sehr viel höher eingestellt werden als die bei der Verwendung des Kurzschluss-Halbleiterbauelements maximal vorkommende Überspannung, und dies ohne nachteilige Auswirkungen sowohl auf das Kurzschluss-Halbleiterbauelement als auch seine Anwendung. Ein möglichst kleiner Sperrstrom ist für das erfindungsgemäße Kurzschluss-Halbleiterbauelement deshalb von großem Vorteil, da dieses im Einsatz praktisch dauernd an Sperrspannung liegt und daher möglichst kleine Sperrströme erzielt und damit einhergehende Sperrverluste möglichst klein gehalten werden können, so dass das Kurzschluss-Halbleiterbauelement ohne aktive Kühlung betrieben werden kann. Das Auftreten eines Ausfalls im Randbereich des Kurzschluss-Halbleiterbauelements, der für den Gehäusebruchstrom kritisch ist, wird durch diese Maßnahme ebenfalls im Wesentlichen eliminiert.

Gemäß einer noch weiteren vorteilhaften Ausgestaltung der Erfindung sind die vorderseitige Elektrode und die rückseitige Elektrode jeweils mittels einer metallischen Kontaktscheibe elektrisch leitend druckkontaktiert. Hierbei kann die jeweilige Kontaktscheibe vorzugsweise dieselbe laterale Weite wie die entsprechende Elektrode aufweisen, so dass die Kontaktscheibe die entsprechende Elektrode vollständig überdeckt. Die Kontaktscheiben können fest, beispielsweise mittels einer Legierung, mit der entsprechenden Metallelektrode des Halbleiterkörpers verbunden sein oder nur lose auf diesen aufliegen. Die Kontaktscheiben können als reine Molybdänscheiben ausgebildet sein oder aus einer Kombination aus einer Molybdän- und Kupferscheibe bestehen, wobei sich vorzugsweise Molybdän in direktem Kontakt mit der Metallisierung des Halbleiterkörpers befindet. In vorteilhafter Weise stellt die vorliegende Erfindung, wie vorstehend beschrieben, sicher, dass sich das Gebiet der zwischen der vorderseitigen und rückseitigen Elektrode des Kurzschluss-Halbleiterbauelements im Kurzschlussfall erzeugten Durchlegierung stets im von den metallischen Kontaktscheiben druckkontaktierten Bereich des Kurzschluss-Halbleiterbauelements befindet.

Die Dicke der Molybdänscheibe bzw. der Kombination aus Molybdän und Kupfer liegt vorzugsweise zwischen 1 mm und 5 mm. Hierbei ist zu verstehen, dass die Dicke der Kontaktscheiben an die Höhe des durch das Kurzschluss-Halbleiterbauelement fließenden Kurzschlussstromes angepasst werden kann. Bei der Durchlegierung im Kurzschlussbetriebsfall verschmelzen das Silizium des Halbleiterkörpers und die Metallbereiche der Kontaktscheiben so miteinander, dass sich eine metallische Zone bildet. Die Dicke der Kontaktscheiben wird je nach Anwendungsfall bzw. Höhe des dauerhaft maximal zu leitenden Kurzschlussstromes so ausgelegt, dass die den jeweiligen Elektroden des Halbleiterkörpers abgewandten Seiten der Kontaktscheiben im Wesentlichen keine allzu starke mechanische Veränderung nach dem Auftreten der Aufschmelzungen zeigen. Insbesondere soll hierdurch ein eine elektrisch leitfähige, niederohmige und thermische Ankopplung sicherstellender Druckkontakt zwischen den die Metallisierungen des Halbleiterkörpers kontaktierenden Kontaktscheiben und jeweiligen Kontaktstempeln, zum Beispiel Kupferstempeln, eines das Kurzschluss-Halbleiterbauelement aufnehmenden Gehäuses, die mit einem ausreichenden Flächendruck gegen die Kontaktscheiben beaufschlagt sind, im Kurzschlussbetriebsfall des Kurzschluss-Halbleiterbauelements aufrechterhalten werden, so dass die Entstehung eines Lichtbogens außerhalb des von den Kontaktscheiben druckkontaktierten Bereichs nach dem Auslösen des Kurzschluss-Halbleiterbauelements sicher verhindert wird. Auf keinen Fall soll die Schmelzzone während der Durchlegierung durch die (Kupfer-)Kontaktstempel des Gehäuses nach außen dringen.

Es ist zu verstehen, dass die vorstehend beschriebenen unterschiedlichen Arten von Einschaltstrukturen innerhalb eines einzigen Kurzschluss-Halbleiterbauelements gemäß der Erfindung beliebig miteinander kombiniert werden können, insbesondere wenn mehr als eine Einschaltstruktur im Kurzschluss-Halbleiterbauelement vorgesehen ist. In sinngemäßer Weise sind auch die vorstehend beschriebenen unterschiedlichen Arten an Zündstrukturen beliebig miteinander in einem einzigen Kurzschluss-Halbleiterbauelement gemäß der Erfindung kombinierbar, wenn mehr als eine Zündstruktur im Kurzschluss-Halbleiterbauelement vorgesehen ist. Ebenso sind die vorstehend beschriebenen unterschiedlichen Arten an Zündstrukturen beliebig mit den unterschiedlichen Arten an Einschaltstrukturen kombinierbar.

So kann das erfindungsgemäße Kurzschluss-Halbleiterbauelement beispielsweise sowohl über ein oder mehrere elektrische Einschaltsignale als auch über ein oder mehrere optische Einschaltsignale einschaltbar sein, wobei dementsprechende Einschaltstrukturen im Halbleiterkörper vorgesehen werden. Die Einschaltsignale können dem Kurzschluss-Halbleiterbauelement lediglich einseitig, zum Beispiel auf der Vorderseite des Halbleiterkörpers, zugeführt werden, oder auch beidseitig, also auf der Vorder- und Rückseite des Halbleiterkörpers, wobei entsprechende Zündstrukturen an den jeweiligen Seiten des Halbleiterkörpers vorgesehen werden.

Weiterhin kann das erfindungsgemäße Kurzschluss-Halbleiterbauelement eine oder mehrere Durchbruchstrukturen als Zündstruktur oder Einschaltstruktur aufweisen, wobei mehrere vorhandene Durchbruchstrukturen für dieselben oder für jeweils unterschiedliche Durchbruchspannungen ausgelegt sein können.

Die als Zündstruktur dienenden Durchbruchstrukturen, zum Beispiel eine BOD-Struktur, aber auch eine einen du/dt-Schutz aufweisende Durchbruchstruktur sowie eine einen Freiwerdezeitschutz mit lokaler Anhebung der Ladungsträgerlebensdauer aufweisende Durchbruchstruktur, können innerhalb einer Amplifying-Gate-Struktur angeordnet sein, das heißt lateral zur vorder- bzw. rückseitigen Elektrode beabstandet und dementsprechend außerhalb eines von diesen Elektroden elektrisch kontaktierten Bereichs. Die Anordnung innerhalb einer Amplifying-Gate-Struktur ist jedoch nicht zwingend erforderlich.

Die Durchbruchstrukturen, die sowohl als Zündstruktur als auch als Einschaltstruktur dienen, können ebenso vertikal unterhalb der vorder- bzw. rückseitigen Elektrode angeordnet sein, beispielsweise in der von der jeweiligen Elektrode elektrisch kontaktierten Basiszone.

Ferner lassen sich die hierin beschriebenen Zünd- und Einschaltstrukturen lediglich einseitig, das heißt in lediglich der vorderseitigen oder der rückseitigen Basiszone, oder auch beidseitig, also in beiden Basiszonen, des Halbleiterkörpers des erfindungsgemäßen Kurzschluss-Halbleiterbauelements vorsehen.

Zusammenfassend sind im Folgenden nochmals stichpunktartig die hierin verwendeten Begriffsdefinitionen dargelegt:
I. Einschaltstruktur:
   Struktur zum Erzeugen einer Durchlegierung im Halbleiterkörper des erfindungsgemäßen Kurzschluss-Halbleiterbauelements, um nach ihrem Einschalten einen elektrisch niederohmig leitenden Zustand (Kurzschluss) zwischen den mit dem Kurzschluss-Halbleiterbauelement elektrisch verbundenen, externen und von dem Halbleiterkörper im Normalbetriebsfall (Nicht-Kurzschlussfall) elektrisch voneinander getrennten elektrischen Hauptanschlüssen (Kathode/Anode) herzustellen. Mögliche Ausführungsform als:
   a. Emitterstruktur
   b. Durchbruchstruktur (z. B. in Form einer BOD-, du/dt-, Freiwerdezeitschutz-Struktur)
II. Einschaltsignal:
   Signal zum Einleiten des Einschaltens einer Einschaltstruktur.
   Mögliche Ausführungsform als:
      a. Separates, dem erfindungsgemäßen Kurzschluss-Halbleiterkörper extern zugeführtes elektrisches Signal
      b. Separates, dem erfindungsgemäßen Kurzschluss-Halbleiterkörper extern zugeführtes optisches Signal
      c. An den elektrischen Hauptanschlüssen (Kathode/Anode) des erfindungsgemäßen Kurzschluss-Halbleiterbauelements anliegende elektrische Spannung/Betriebsspannung
III. Einschaltstrom:
   Ein aus dem Einschaltsignal gewonnener, einer als Emitterstruktur ausgebildeten Einschaltstruktur zugeführter Strom, um diese zu zünden bzw. einzuschalten.
IV. Aufschmelzstrom:
   Ein eine Durchlegierung im Halbleiterkörper herbeiführender Strom.
V. Zündstruktur:
   Optionale Hilfsstruktur zum Weiterleiten des der Hilfsstruktur stets zugeführten Einschaltsignals an eine Einschaltstruktur.
   Mögliche Ausführungsform als:
      a. Gate-Elektrode - Zugeführtes Einschaltsignal: II.a
      b. Lichtempfindlicher Halbleiterbereich (optisches Gate) - Zugeführtes Einschaltsignal: II.b
      c. Durchbruchstruktur (z. B. in Form einer BOD-, du/dt-, Freiwerdezeitschutz-Struktur) - Zugeführtes Einschaltsignal: II.c
VI. Amplifying-Gate-Struktur (AG-Struktur):
   Optionale, zwischen einer Zündstruktur und einer Einschaltstruktur angeordnete Hilfsstruktur zum Verstärken des über die Zündstruktur in das erfindungsgemäße Kurzschluss-Halbleiterbauelement eingekoppelten Einschaltsignals.

Weitere Merkmale und Vorteile der Erfindung ergeben sich aus der folgenden Beschreibung nicht einschränkend zu verstehender Ausführungsbeispiele der Erfindung, die im Folgenden unter Bezugnahme auf die Zeichnung näher erläutert wird. In dieser Zeichnung zeigen schematisch:
- Fig. 1: einen Vertikalschnitt durch einen Thyristor nach dem Stand der Technik,
- Fig. 2: einen Vertikalschnitt durch ein Ausführungsbeispiel eines Kurzschluss-Halbleiterbauelements gemäß der Erfindung mit einer Einschaltstruktur und einer Zündstruktur,
- Fig. 3: eine Draufsicht auf ein weiteres Ausführungsbeispiel eines Kurzschluss-Halbleiterbauelements gemäß der Erfindung mit einer verfingerten Einschaltstruktur,
- Fig. 4: einen Vertikalschnitt durch ein weiteres Ausführungsbeispiel eines Kurzschluss-Halbleiterbauelements gemäß der Erfindung mit zwei Einschaltstrukturen und einer Zündstruktur,
- Fig. 5: einen Vertikalschnitt durch ein noch weiteres Ausführungsbeispiel eines Kurzschluss-Halbleiterbauelements gemäß der Erfindung mit zwei Einschaltstrukturen und zwei Zündstrukturen,
- Fig. 6: einen Vertikalschnitt durch ein noch weiteres Ausführungsbeispiel eines Kurzschluss-Halbleiterbauelements gemäß der Erfindung mit einer Einschaltstruktur und einer Zündstruktur,
- Fig. 7: einen Vertikalschnitt durch ein weiteres Ausführungsbeispiel eines Kurzschluss-Halbleiterbauelements gemäß der Erfindung mit zwei Einschaltstrukturen und zwei Zündstrukturen,
- Fig. 8: einen Vertikalschnitt durch ein noch weiteres Ausführungsbeispiel eines Kurzschluss-Halbleiterbauelements gemäß der Erfindung mit zwei Einschaltstrukturen,
- Fig. 9: einen Vertikalschnitt durch ein noch weiteres Ausführungsbeispiel eines Kurzschluss-Halbleiterbauelements gemäß der Erfindung mit zwei Einschaltstrukturen und zwei Zündstrukturen,
- Fig. 10: einen Vertikalschnitt durch ein weiteres Ausführungsbeispiel eines Kurzschluss-Halbleiterbauelements gemäß der Erfindung mit zwei Einschaltstrukturen und einer Zündstruktur,
- Fig. 11: in den Ansichten (a), (b) und (c) jeweils einen Konzentrationsverlauf durch das Kurzschluss-Halbleiterbauelement aus Fig. 10 entlang der dort gezeigten Konzentrationsverlaufslinien Na, Nb bzw. Nc,
- Fig. 12: einen Vertikalschnitt durch ein weiteres Ausführungsbeispiel eines Kurzschluss-Halbleiterbauelements gemäß der Erfindung mit zwei Einschaltstrukturen und zwei Zündstrukturen,
- Fig. 13: eine Teildraufsicht auf ein noch weiteres Ausführungsbeispiel eines Kurzschluss-Halbleiterbauelements gemäß der Erfindung mit einer ein in einer Umfangsrichtung des Halbleiterkörpers offenes Einschaltstruktursegment aufweisenden Einschaltstruktur und einer Zündstruktur,
- Fig. 14: eine Teildraufsicht auf ein noch weiteres Ausführungsbeispiel eines Kurzschluss-Halbleiterbauelements gemäß der Erfindung mit einer ein in einer Umfangsrichtung des Halbleiterkörpers offenes Einschaltstruktursegment aufweisenden Einschaltstruktur und einer Zündstruktur,
- Fig. 15: einen Vertikalschnitt durch das Kurzschluss-Halbleiterbauelement aus Fig. 14 entlang der Schnittlinie X-X dar,
- Fig. 16: eine Teildraufsicht auf ein noch weiteres Ausführungsbeispiel eines Kurzschluss-Halbleiterbauelements gemäß der Erfindung mit einer ein in einer Umfangsrichtung des Halbleiterkörpers offenes Einschaltstruktursegment aufweisenden Einschaltstruktur und einer Zündstruktur,
- Fig. 17: eine Teildraufsicht auf ein noch weiteres Ausführungsbeispiel eines Kurzschluss-Halbleiterbauelements gemäß der Erfindung mit einer ein in einer Umfangsrichtung des Halbleiterkörpers offenes Einschaltstruktursegment aufweisenden Einschaltstruktur und einer Zündstruktur,
- Fig. 18: einen Vertikalschnitt durch das Kurzschluss-Halbleiterbauelement aus Fig. 17 entlang der Schnittlinie Y-Y dar,

In den unterschiedlichen Figuren sind hinsichtlich ihrer Funktion gleichwertige Teile stets mit denselben Bezugszeichen versehen, so dass diese in der Regel auch nur einmal beschrieben werden.

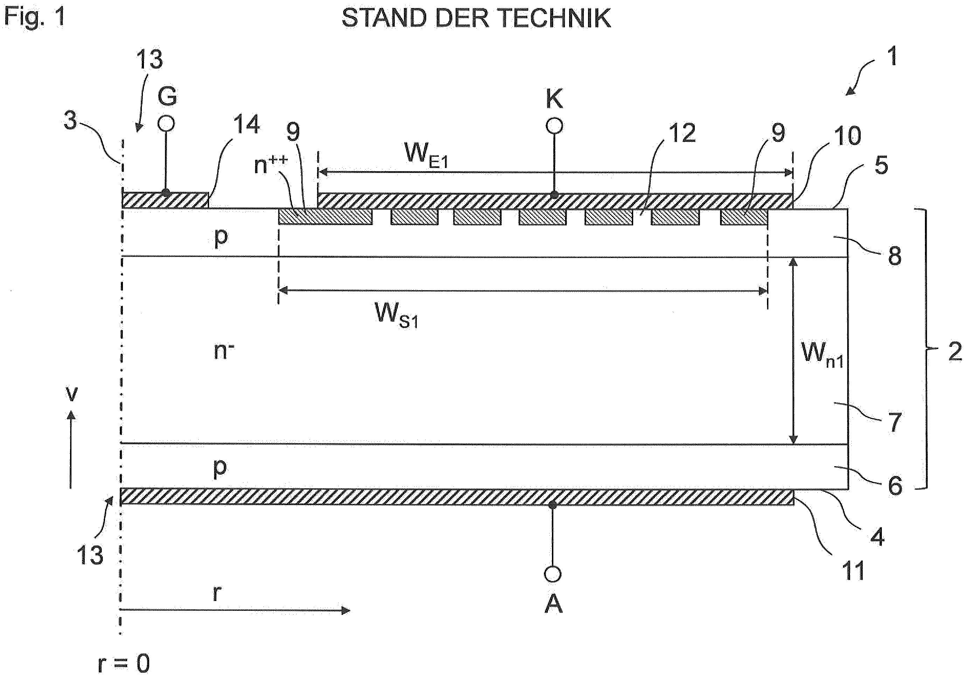

Fig. 1 stellt einen Vertikalschnitt durch einen Thyristor 1 nach dem Stand der Technik dar. Der Thyristor 1 weist einen Halbleiterkörper 2 auf, der im Wesentlichen die Gestalt eines sehr flachen Zylinders aufweist, dessen Grundflächen senkrecht zu einer vertikalen Richtung v verlaufen. Jede Richtung senkrecht zur vertikalen Richtung v wird hierin als radiale oder laterale Richtung bezeichnet, wobei in Fig. 1 die laterale Richtung mit dem Bezugszeichen r dargestellt ist,

Der Halbleiterkörper 2 ist aus einem Halbleitermaterial, zum Beispiel Silizium, gebildet und weist p- und n-leitend dotierte Halbleiterzonen auf, welche die elektrischen Eigenschaften des Thyristors in an sich bekannter Weise festlegen. Der Thyristor 1 und/oder der Halbleiterkörper 2 sind rotationssymmetrisch bezüglich einer in der vertikalen Richtung v verlaufenden Mittelachse 3 ausgebildet.

In dem Halbleiterkörper 2 des dargestellten Thyristors 1 nach dem Stand der Technik sind in der vertikalen Richtung v ausgehend von einer Rückseite 4 hin zu einer der Rückseite 4 gegenüberliegenden Vorderseite 5 eine p-dotierte rückseitige Basiszone 6, eine n-dotierte Innenzone 7 und eine p-dotierte vorderseitige Basiszone 8 aufeinanderfolgend angeordnet.

Angrenzend an die Vorderseite 5 des Halbleiterkörpers 2 ist in die p-dotierte vorderseitige Basiszone 8 ein n-dotierter vorderseitiger Emitter 9 eingebettet, wobei der vorderseitige Emitter 9 eine durch seine laterale Erstreckung gegebene gesamte laterale Emitterweite W_{S1} aufweist. Als laterale Gesamtstrukturweite des Emitters 9 ist hierin der Abstand einer die gezeigte Emitterstruktur 9 radial am weitesten nach innen begrenzenden Innenseite zu einer die gezeigte Emitterstruktur 9 radial am weitesten nach außen begrenzenden Außenseite zu verstehen. Der Emitter 9 weist bei dem in Fig. 1 dargestellten herkömmlichen Thyristor 1 eine die Mittelachse 3 konzentrisch umschließende, umfänglich geschlossene Ringstruktur auf, wobei der Halbleiterkörper 2 bzw. der Thyristor 1 im Wesentlichen als zur Mittelachse 3 rotationssymmetrischer Zylinder ausgebildet ist.

Des Weiteren ist Fig. 1 zu entnehmen, dass der n-dotierte vorderseitige Emitter 9 mit einer auf der Vorderseite 5 aufgebrachten Metallisierungsschicht 10 (zum Beispiel Aluminium) elektrisch leitend verbunden ist, die eine vorderseitige Elektrode 10 des Thyristors 1 bildet, wobei die vorderseitige Elektrode 10 bei dem gezeigten Beispiel des herkömmlichen Thyristors 1 auch als Kathodenelektrode bezeichnet werden kann, die einen Kathodenanschluss K aufweist. Die vorderseitige Elektrode 10 weist eine durch ihre laterale Erstreckung gegebene gesamte laterale vorderseitige Elektrodenweite W_{E1} auf. Die p-dotierte rückseitige Basiszone 6 ist mit einer auf der Rückseite 4 aufgebrachten Metallisierungsschicht 11 (zum Beispiel Aluminium) elektrisch leitend verbunden, die eine rückseitige Elektrode 11 des Thyristors 1 bildet, wobei die rückseitige Elektrode 11 bei dem gezeigten Beispiel des herkömmlichen Thyristors 1 auch als Anodenelektrode bezeichnet werden kann, die einen Anodenanschluss A aufweist.

Wie in Fig. 1 außerdem zu erkennen ist, ist der n-dotierte vorderseitige Emitter 9 in allgemein bekannter Weise von säulenartig ausgebildeten, komplementär zum vorderseitigen Emitter 9 dotierten Kurzschlüssen 12 (auch als Kathodenkurzschluss bezeichnet) durchsetzt, die die p-dotierte vorderseitige Basiszone 8 elektrisch direkt an die vorderseitige Elektrode 10 anschließen.

Des Weiteren ist Fig. 1 zu entnehmen, dass der Thyristor 1 in einem durch den geometrischen Schwerpunkt der Vorderseite 5 festgelegten Zentrum 13 (r = 0) des Halbleiterkörpers 2 eine Zündstruktur in Form einer Gate-Elektrode 14 aufweist, durch die in Abhängigkeit von einem elektrischen Zünd- oder Einschaltsignal (Gate-Strom) eine elektrisch leitende, niederohmige Verbindung zwischen der vorderseitigen Elektrode 10 (hier: Kathode) und der rückseitigen Elektrode 11 (hier: Anode) in allgemein bekannter Weise herstellbar ist. Übrigens ist auch durch den geometrischen Schwerpunkt der Rückseite 4 des Halbleiterkörpers 2 ein Zentrum 13 festgelegt, das aufgrund des symmetrischen Aufbaus des Halbleiterkörpers 2 mit der lateralen Lage des vorderseitigen Zentrums 13 übereinstimmt, weswegen die beiden Zentren mit demselben Bezugszeichen 13 versehen sind. Die beiden Zentren 13 legen den Verlauf der Mittelachse 3 (auch Symmetrieachse) fest.

Liegt zum Beispiel zwischen der rückseitigen Elektrode 11 und der vorderseitigen Elektrode 10 ein positives Potential, wird die in Blockierrichtung (U_{D}) sperrende npnp-Struktur des Thyristors 1 durch den Gate-Strom (positive Stromrichtung von Gate 14 zur vorderseitigen Elektrode 10) gezündet bzw. eingeschaltet. Das Stromplasma breitet sich beim Einschalten ausgehend von der dem Zentrum 13 zugewandten Seite des n-hochdotierten vorderseitigen Emitters 9 mit einer Geschwindigkeit von etwa 0,1 mm/µs radial bzw. lateral nach außen über den ganzen vorderseitigen Elektrodenbereich W_{E1} aus, bis je nach Durchmesser des Thyristors 1 der ganze vorderseitige Elektrodenbereich W_{E1} nach ca. 1 bis 4 ms den Strom führt und zwischen vorderseitiger Elektrode (Kathode) 10 und rückseitiger Elektrode (Anode) 11 ein hoher Laststrom fließt. Dann nimmt die anliegende Durchlassspannung im Leitzustand des Thyristors 1 ihren kleinsten Wert an. Erst wenn der durch den Thyristor 1 fließende Strom wieder einen Nullwert erreicht, "erlischt" er und wechselt in den Sperrzustand (U_{R} bzw. negatives Potential zwischen rückseitiger Elektrode 11 und vorderseitiger Elektrode 10). Zwischen diesen beiden Zuständen ist eine wie in Fig. 1 gezeigte intakte, herkömmliche Thyristorstruktur beliebig oft schaltbar.

Die Sperr- bzw. Blockierspannung des Thyristors 1 ergibt sich aus der minimalen Dicke Wₙ₁ und dem spezifischen Widerstand p der n-dotierten Innenzone 7, während seine minimale Fläche des n-dotierten vorderseitigen Emitters 9 die Höhe des zulässigen Stoßstromes und die Durchlassverluste (Leitverluste) festlegt. Die Dicke Wₙ₁ ist dabei nicht beliebig groß wählbar, um zum Beispiel die Sperrfähigkeit zu erhöhen, da dies den Stoßstrom und die Leitverluste negativ beeinflusst. Die Fläche des Emitters 9 und die Siliziumdicke Wₙ₁ sind dementsprechend genau auf die jeweilige Anwendung des herkömmlichen Thyristors 1 zugeschnitten.

Wie Fig. 1 weiter zu entnehmen ist, ist die laterale Weite W_{S1} des vorderseitigen Emitters 9 im Wesentlichen gleich der lateralen Weite W_{E1} der vorderseitigen Elektrode 10. Somit ist das Verhältnis der lateralen vorderseitigen Emitterweite W_{S1} zur lateralen vorderseitigen Elektrodenweite W_{E1} bei dem herkömmlichen Thyristor 1 im Wesentlichen gleich 1 oder sogar noch etwas größer als 1.

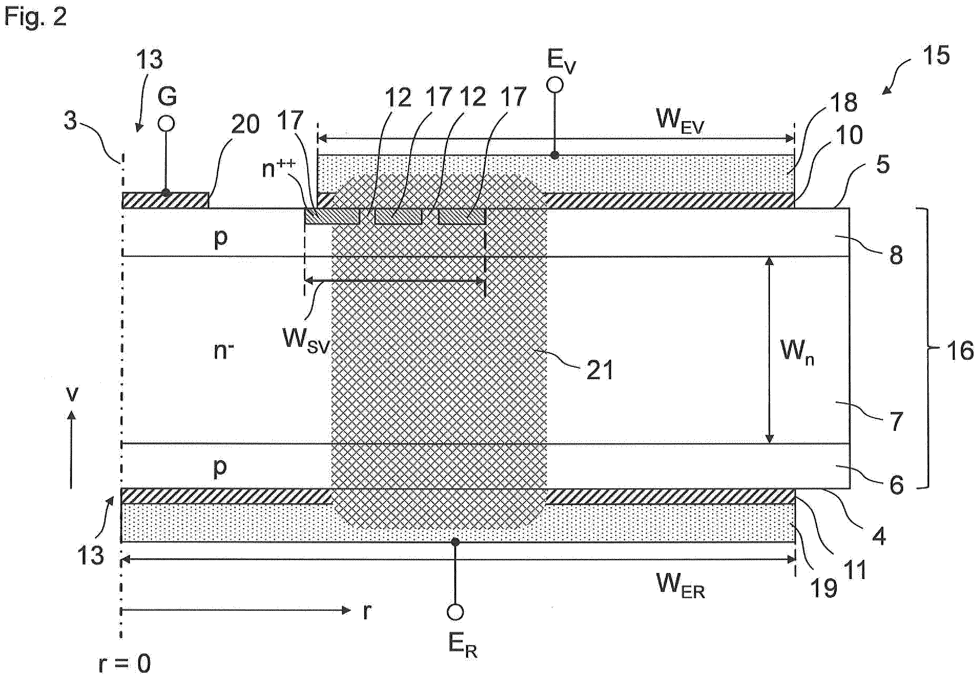

Fig. 2 stellt einen Vertikalschnitt durch ein Ausführungsbeispiel eines Kurzschluss-Halbleiterbauelements 15 gemäß der Erfindung dar. Das Kurzschluss-Halbleiterbauelement 15 weist einen Halbleiterkörper 16 auf, in dem in ähnlicher Weise wie beim in Fig. 1 dargestellten herkömmlichen Thyristor 1 in der vertikalen Richtung v ausgehend von der Rückseite 4 hin zu der der Rückseite 4 gegenüberliegenden Vorderseite 5 eine p-dotierte rückseitige Basiszone 6, eine n-dotierte Innenzone 7 und eine p-dotierte vorderseitige Basiszone 8 aufeinanderfolgend angeordnet sind.

Wie Fig. 2 zu entnehmen ist, ist die rückseitige Basiszone 6 mit der auf der Rückseite 4 aufgebrachten rückseitigen Elektrode 11 mit einer durch ihre laterale Erstreckung gegebenen gesamten lateralen rückseitigen Elektrodenweite W_{ER} elektrisch leitend verbunden und die vorderseitige Basiszone 8 mit der auf der Vorderseite 5 aufgebrachten vorderseitigen Elektrode 10 mit einer durch ihre laterale Erstreckung gegebenen gesamten lateralen vorderseitigen Elektrodenweite W_{EV} elektrisch leitend verbunden.

Angrenzend an die Vorderseite 5 des Halbleiterkörpers 16 ist in die p-dotierte vorderseitige Basiszone 8 eine vorderseitige Einschaltstruktur 17 mit einer durch ihre laterale Erstreckung gegebenen lateralen vorderseitigen Einschaltstrukturweite W_{SV} eingebettet. Die vorderseitige Einschaltstruktur 17 ist bei dem in Fig. 2 gezeigten Ausführungsbeispiel als n-dotierte vorderseitige Emitterstruktur 17 ausgebildet, die beispielsweise als umfänglich geschlossene Ring- und/oder Polygonstruktur ausgebildet sein kann. Wie in Fig. 2 zu erkennen ist, ist die Emitterstruktur 17 mit der auf der Vorderseite 5 aufgebrachten Metallisierungsschicht 10 (zum Beispiel Aluminium) elektrisch leitend verbunden.

Wie weiter zu erkennen ist, überdeckt die vorderseitige Elektrode 10 die vorderseitige Emitterstruktur 17 wenigstens teilweise. Insbesondere ist in Fig. 2 zumindest größenordnungsmäßig dargestellt, dass die Überdeckung der Einschaltstruktur 17 von der vorderseitigen Elektrode 10 im äußeren Randbereich, das heißt in Richtung zum radialen Außenrand des Kurzschluss-Halbleiterbauelements 15 (r > 0), wenigstens im Millimeter-Bereich liegt, z. B. wenigstens etwa 1 mm bis 5 mm oder auch noch größer. Wie in Fig. 2 dargestellt ist, ragt die Emitterstruktur 17 an der radialen, dem Zentrum 13 zugewandten Innenseite der Metallisierungsschicht 10 etwas über diese hinaus. Die n-dotierte vorderseitige Emitterstruktur 17 ist bei dem in Fig. 2 gezeigten Ausführungsbeispiel ebenfalls von den säulenartig ausgebildeten, komplementär zur Emitterstruktur 17 dotierten Kurzschlüssen 12 durchsetzt, die die p-dotierte vorderseitige Basiszone 8 elektrisch an die vorderseitige Elektrode 10 anschließen.

Die Form der Kurzschlüsse 12 kann variieren, je nach Stärke der gewünschten Kurzschlusswirkung. Üblich sind kreisrunde oder mehreckige, zum Beispiel sechseckige, kleine punktuelle Aussparungen innerhalb der durch die laterale vorderseitige Emitterstrukturweite W_{SV} festgelegten, zusammenhängenden Emitterstrukturfläche der gesamten Emitterstruktur 17, wobei die Kurzschlüsse 12 Abmessungen in der Größenordnung von etwa 100 µm aufweisen können. Es sind jedoch auch andere Formen derartiger Kurzschlüsse 12 möglich, zum Beispiel streifenartige Unterbrechungen oder ringförmige Unterbrechungen, die die Emitterstruktur 17 in einzelne, konzentrische Ringe trennen. Die Breite solcher Unterbrechungen liegt typischerweise im Bereich von etwa 100 µm.

Im Vergleich zum in Fig. 1 dargestellten herkömmlichen Thyristor 1 kann bei dem erfindungsgemäßen Kurzschluss-Halbleiterbauelement 15 die Kurzschlusswirkung der Kurzschlüsse 12 durch eine gezielte Ausgestaltung auch sehr stark erhöht werden, indem die Kurzschlussöffnungen der Kurzschlüsse 12 beispielsweise deutlich größer ausgebildet sind als bei dem in Fig. 1 gezeigten herkömmlichen Thyristor 1 und/oder die Dichte der Kurzschlüsse 12 bezogen auf die Emitterstrukturfläche der Emitterstruktur 17 deutlich höher gewählt ist, das heißt der Abstand benachbarter Kurzschlüsse 12 zueinander deutlich geringer gewählt ist, als bei dem herkömmlichen Thyristor 1. Hierdurch lässt sich der flächenspezifische Stoßstrom in kA/cm² bei dem erfindungsgemäßen Kurzschluss-Halbleiterbauelement 15 noch weiter verringern (im Gegensatz zum herkömmlichen Thyristor 1, bei dem der Stoßstrom bekanntlich stets maximiert wird), um die wie hierin beschriebene Durchlegierung des Halbleiterkörpers 16 im Kurzschlussfall sicher zu gewährleisten.

Die auf die vorbeschriebene Weise angeordneten zwei pn- bzw. np-Übergänge im Halbleiterkörper 16 erzeugen ein in beiden Spannungspolaritäten sperrendes Kurzschluss-Halbleiterbauelement 15.

Der wesentliche Unterschied des in Fig. 2 dargestellten Kurzschluss-Halbleiterbauelements 15 zum in Fig. 1 gezeigten herkömmlichen Thyristor 1 ist das Verhältnis der lateralen Einschalt- bzw. Emitterstrukturweite W_{SV} zur lateralen Elektrodenweite W_{EV}, das bei dem Kurzschluss-Halbleiterbauelement 15 deutlich kleiner 1 ist und bevorzugt kleiner 1/2 oder noch kleiner gewählt werden kann.

Ferner ist Fig. 2 zu entnehmen, dass die vorderseitige Elektrode 10 und die rückseitige Elektrode 11 jeweils mittels einer metallischen vorderseitigen und rückseitigen Kontaktscheibe 18 bzw. 19 elektrisch leitend kontaktiert, insbesondere druckkontaktiert, sind. Die Kontaktscheiben 18 und 19 können als reine Molybdänscheiben ausgebildet sein oder aus einer Kombination aus einer Molybdän- und Kupferscheibe bestehen, wobei sich bevorzugt Molybdän in direktem Kontakt mit der jeweiligen Elektrode 10 bzw. 11 des Halbleiterkörpers 16 befindet. Die Dicke der Kontaktscheiben 18 und 19 liegt vorzugsweise zwischen 1 und 5 mm.

Des Weiteren ist in Fig. 2 eine als Gate-Elektrode 20 ausgebildete vorderseitige Zündstruktur 20 des Kurzschluss-Halbleiterbauelements 15 zu erkennen, die die vorderseitige Basiszone 8 elektrisch leitend kontaktiert und in Abhängigkeit von einem der Gate-Elektrode 20 über ihren Gate-Anschluss G zugeführten elektrischen Einschaltsignal aktivierbar ist und infolgedessen die vorderseitige Einschalt- bzw. Emitterstruktur 17 einschalten kann, die über die vorderseitige Basiszone 8 elektrisch mit der Gate-Elektrode 20 wirkverbunden ist. Nach dem Einschalten der Einschalt- bzw. Emitterstruktur 17 stellt diese einmalig eine dauerhafte, irreversible, elektrisch leitende, niederohmige Verbindung zwischen der vorderseitigen Elektrode 10 und der rückseitigen Elektrode 11 her. Die Gate-Elektrode 20 wird im Betrieb über einen mittels Federwirkung angedrückten elektrisch leitenden Draht (nicht dargestellt) kontaktiert.

Wie bereits weiter oben erwähnt wurde und in Fig. 2 zu erkennen ist, ragt die Emitterstruktur 17 an der radialen, dem Zentrum 13 zugewandten Innenseite der Metallisierungsschicht 10 etwas über diese hinaus. Dies ist hier erforderlich, um die Emitterstruktur 17 nicht kurzzuschließen. Bei einem derartigen Kurzschluss würde der Strom des über die Zündstruktur bzw. Gate-Elektrode 20 zugeführten Einschaltsignals direkt von dieser zur Elektrode 10 fließen können, was jedoch die gewünschte Funktion der Einschalt- bzw. Emitterstruktur 17 zumindest teilweise negativ beeinträchtigen könnte.

Des Weiteren ist das Kurzschluss-Halbleiterbauelement 15 im Betrieb gewöhnlich in einer als Gehäuse ausgebildeten hermetisch dichten Keramikkapsel (nicht dargestellt) aufgenommen. Für die Zuführung des externen elektrischen Einschalt- bzw. Gate-Signals ist ein Metallrohr in der Keramikkapsel angebracht, das mit dem metallisierten Gate-Bereich 20 über den Draht zur Einkopplung des externen Einschaltsignals verbunden ist. Das Keramikgehäuse weist ferner zwei Kupferkontaktstempel auf, die auf beiden Seiten des Kurzschluss-Halbleiterbauelements 15 direkt auf den Kontaktscheiben 18 bzw. 19 der vorderseitigen Elektrode 10 bzw. rückseitigen Elektrode 11 aufliegen. Die elektrische Verbindung dieses in der Keramikkapsel befindlichen Kurzschluss-Halbleiterbauelements 15 nach außen geschieht über einen entsprechenden mechanischen Druckverbund, welcher die beiden Kupferkontaktstempel mit einem ausreichenden Flächendruck zusammenpresst, während zur Ansteuerung mittels des Einschaltsignals das in der Keramikkapsel befindliche Metallrohr außerhalb der Kapsel über eine geeignete Steckverbindung oder feste Lötung mit einer elektrischen Leitung verbunden ist.

Die Hauptfunktion des erfindungsgemäßen Kurzschluss-Halbleiterbauelements 15 besteht nun darin, dass bei einem einzigen Impuls des Einschalt- bzw. Gate-Signals mit ausreichender Stromhöhe die zentralnahe, in der Nähe der Gate-Elektrode 20 liegende n-dotierte vorderseitige Emitterstruktur 17 einschaltet und der Halbleiterkörper 16 durch den über die Elektrodenanschlüsse E_{V} und E_{R} fließenden Fehlerstrom derart zerstört wird, dass sich in der Umgebung des initial gezündeten Bereichs des Halbleiterkörpers 16 eine Aufschmelzung bzw. Durchlegierung 21 bildet, deren Größe bzw. radiale/laterale Ausdehnung u. a. auch von der Größe des zwischen den Anschlüssen E_{V} und E_{R} fließenden Kurzschlussstroms abhängt. Nach dem Erkalten der Schmelze bildet sich eine metallische Zone, die sich aus dem geschmolzenen Silizium des Halbleiterkörpers 16 und dem Metall der Kontaktscheiben 18 bzw. 19 zusammensetzt und eine dauerhaft sicher leitende, niederohmige elektrische Verbindung (Kurzschluss) zwischen den beiden Hauptanschlüssen E_{V} und E_{R} bereitstellt. Die Höhe des Aufschmelzstroms wird bestimmt durch eine nach dem dauerhaft aufzunehmenden Kurzschlussstrom auszulegende maximale Fläche für die n-dotierte vorderseitige Emitterstruktur 17, wobei für kleine Aufschmelzströme ein möglichst kleines Verhältnis W_{SV}/W_{EV} angestrebt wird und die laterale Weite W_{EV} der Metallkontaktscheibe 18 bzw. der vorderseitigen Elektrode 10 nach der Höhe des Kurzschlussstroms derart festgelegt wird, dass die räumliche Ausdehnung der durchlegierten Zone 21 nicht in einen äußeren Randbereich des Kurzschluss-Halbleiterbauelements 15 gelangt. Um weiterhin auch einen durch eine mögliche Überspannung hervorgerufenen Randausfall zu vermeiden, kann die Dicke Wₙ der die Sperrfähigkeit des Kurzschluss-Halbleiterbauelements 15 bestimmenden n-dotierten Innenzone 7 nahezu beliebig groß gewählt werden, wobei zusätzlich der spezifische Widerstand der Innenzone 7 an die gewünschte Höhe der Sperrfähigkeit entsprechend angepasst wird.

Im Störfall wird also bei dem in Fig. 2 dargestellten Kurzschluss-Bauelement 15 einmalig ein elektrisches Einschaltsignal erzeugt, das über die elektrische Zuführung zum Gate-Anschluss G auf die Gate-Elektrode 20 im Zentrum 13 des Halbleiterkörpers 16 gegeben wird. Infolgedessen wird die npnp-Struktur des Halbleiterkörpers 16 gezündet bzw. eingeschaltet, woraufhin es zum Stromfluss zwischen der vorderseitigen Elektrode 10 und der rückseitigen Elektrode 11 kommt, der zur Aufschmelzung 21 im stromführenden Bereich des Halbleiterkörpers 16 führt. Danach befindet sich das Kurzschluss-Halbleiterbauelement 15 in einem permanenten, nicht reversiblen, niederohmig stromführenden Zustand.

Die Stromtragfähigkeit der n-dotierten vorderseitigen Emitterstruktur 17 ist gegenüber dem n-dotierten kathodenseitigen Emitter 9 des in Fig. 1 dargestellten herkömmlichen Thyristors 1 sehr stark begrenzt, denn sie ist durch das Verhältnis der lateralen Emitterstrukturweite W_{SV} der n-dotierten vorderseitigen Emitterstruktur 17 zur Gesamtweite W_{EV} der durch die Metallisierung bzw. vorderseitigen Elektrode 10 und der Kontaktscheibe 18 kontaktierten Fläche bestimmt.

Die Lage der n-dotierten vorderseitigen Emitterstruktur 17 nahe dem Zentrum 13 des Halbleiterkörpers 16 hält den durchlegierten Bereich 21 in der Nähe der Initialzündung und verhindert, dass das Plasma den durch die vorderseitige Elektrode 10 und die Kontaktscheibe 18 kontaktierten Bereich des Halbleiterkörpers 16 verlassen und in den radial äußeren Randbereich gelangen kann. Der Aufbau des in Fig. 2 gezeigten Ausführungsbeispiels des Kurzschluss-Halbleiterbauelements 15 stellt also sicher, dass die Durchlegierung 21 stets innerhalb des von der Elektrode 10 und der Kontaktscheibe 18 überdeckten Bereichs, das heißt innerhalb der Elektrodenweite W_{EV}, verbleibt.

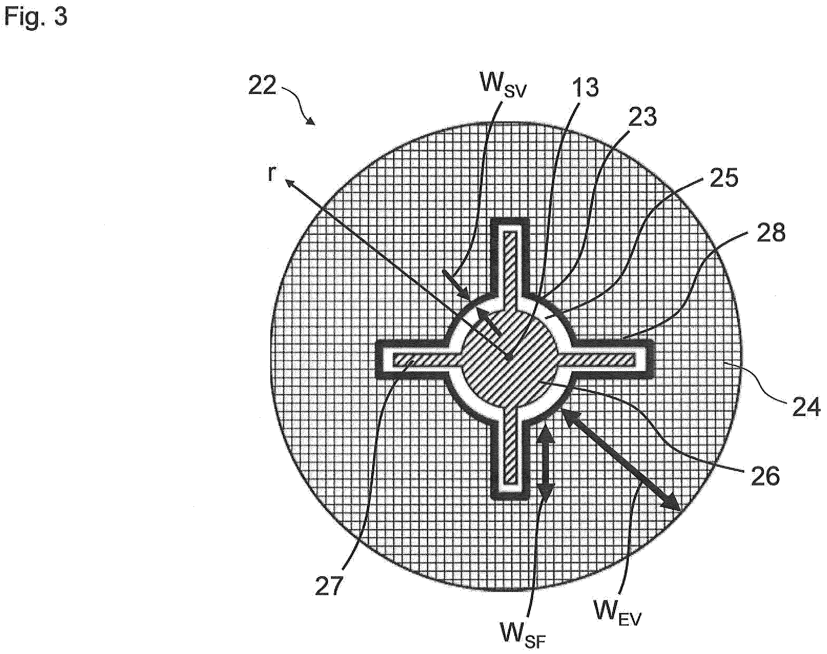

Fig. 3 stellt eine Draufsicht auf ein weiteres Ausführungsbeispiel eines Kurzschluss-Halbleiterbauelements 22 gemäß der Erfindung mit einer verfingerten Einschaltstruktur 23 dar. In Fig. 3 ist eine vorderseitige Elektrode 24 zu erkennen, die auf der Vorderseite eines Halbleiterkörpers 25 mit erfindungsgemäßem Aufbau aufgebracht ist. Im Zentrum 13 des Kurzschluss-Halbleiterbauelements 22 ist eine als Zündstruktur ausgebildete Gate-Elektrode 26 auf den Halbleiterkörper 25 aufgebracht, die, wie in Fig. 3 zu erkennen ist, von der vorderseitigen Elektrode 24 radial beabstandet ist. Wie Fig. 3 weiter zu entnehmen ist, weist die Gate-Elektrode 26 bei dem gezeigten Kurzschluss-Halbleiterbauelement 22 vier sich vom Rest, das heißt vom zentralen Bereich, der Gate-Elektrode 26 radial nach außen erstreckende Zündstruktur- bzw. Gate-Finger 27 auf. Die vorderseitige Elektrode 24 weist den Gate-Fingern 27 entsprechende Ausnehmungen auf, damit sich die Gate-Finger 27 beabstandet zur Elektrode 24 radial nach außen erstrecken können. Entsprechend den Ausnehmungen der Elektrode 24 weist auch die von der Elektrode 24 elektrisch kontaktierte, unterhalb der Elektrode 24 liegende und von dieser wenigstens teilweise überdeckte, in dem Halbleiterkörper 25 eingebettete Einschaltstruktur 23, hier eine Emitterstruktur, einen der Kontur der Elektrodenausnehmungen folgenden Verlauf auf.

Die Emitterstruktur 23 und deren Verlauf ist in Fig. 3 durch eine breit gezeichnete Umrisslinie der Elektrodenausnehmungen angedeutet. Die laterale Emitterstrukturweite W_{SV} entspricht somit anschaulich im Wesentlichen der Breite der in Fig. 3 gezeichneten Umrisslinie. Im Querschnitt gesehen kann die Emitterstruktur 23 beispielsweise ähnlich der Emitterstruktur 17 aus Fig. 2 ausgebildet sein und auch die Kurzschlüsse 12 aufweisen. Dies ist jedoch nicht zwingend erforderlich.

Es ist in Fig. 3 zu erkennen, dass die Emitterstruktur 23 in lateraler Richtung r vier sich radial vom zentrumsnahen Rest der Emitterstruktur 23, das heißt von einem zentrumsnahen Bereich der Emitterstruktur 23, nach außen erstreckende Einschaltstrukturfinger 28 aufweist. Bei dem in Fig. 3 dargestellten Ausführungsbeispiel des Kurzschluss-Halbleiterbauelements 22 ist die Einschalt- bzw. Emitterstruktur 23 linienförmig der Kontur der Elektrodenausnehmungen folgend ausgebildet. Eine solche linienförmige Einschaltstruktur 23 kann vorzugsweise eine laterale Strukturweite W_{SV} (s. Fig. 2) von etwa 500 µm aufweisen. Die in Fig. 3 gezeigte Einschalt- bzw. Emitterstruktur 23 ist somit teilweise als umfänglich geschlossene Ringstruktur und teilweise als umfänglich geschlossene Polygonstruktur (Emitterfinger 28) ausgebildet, die sich aus der Ringstruktur radial nach außen erstreckt.

Es ist zu verstehen, dass die Verfingerung der Einschaltstruktur 23 und die entsprechende Verfingerung der Zündstruktur 26, hier der Gate-Elektrode 26, selbstverständlich viele andere denkbaren Ausgestaltungen annehmen kann. So ist die Anzahl der Einschaltstrukturfinger 28 bzw. Zündstrukturfinger 27 nicht auf die in Fig. 3 dargestellte Anzahl vier beschränkt. Es können mehr oder auch weniger Finger vorhanden sein. Auch ist der Verlauf der Finger 28 bzw. 27 nicht auf den geradlinigen Verlauf des in Fig. 3 dargestellten Ausführungsbeispiels beschränkt. Der Verlauf kann beispielsweise auch gekrümmt sein. Weiterhin ist es denkbar, dass sich von jedem Finger 28 bzw. 27 noch zusätzlich ein oder mehrere verzweigte Fingerabschnitte von jedem in Fig. 3 dargestellten Finger 28 bzw. 27 weg erstrecken können und so ein- oder mehrfach verzweigte Finger bilden.

Aus der Darstellung der Fig. 3 ist zu erkennen, dass die Zündstruktur 26 der Form bzw. Kontur der Einschaltstrukturfinger 28 entsprechende, das heißt folgende Zündstrukturfinger 27 aufweist. Diese Ausgestaltung stellt aufgrund eines über den gesamten Verlauf der verfingerten Einschaltstruktur 23 sich einstellenden gleichmäßigen Abstands, hier insbesondere in lateraler Richtung, zwischen der Zündstruktur 26 und der Einschaltstruktur 23 gleichmäßige elektrische Wirkung der Zündstruktur 26 auf die Einschaltstruktur 23 sicher.

Die verfingerte Einschaltstruktur 23 bietet den wesentlichen Vorteil, dass sich der eingeschaltete bzw. gezündete Bereich des Kurzschluss-Halbleiterbauelements 22 über einen größeren Umfang verteilen kann. Eine laterale Erstreckung der Einschaltstrukturfinger 28 vom zentrumsnahen Rest der Einschaltstruktur 23, das heißt eine radiale Fingerlänge L_{SF} der Einschaltstruktur, wird hierbei bevorzugt kleiner als W_{EV}/2 gewählt. Bei dem hier gezeigten Ausführungsbeispiel des Kurzschluss-Halbleiterbauelements 22 gilt dies ebenfalls für die radiale Fingerlänge der Zündstrukturfinger 27. Diese Maßnahme hilft, den Aufschmelzbereich 21 (s. Fig. 2) einerseits vom Zentrum 13 des Halbleiterkörpers 22 und damit von der Gate-Elektrode 26 fernzuhalten und andererseits ebenso ausreichend weit weg vom radialen Außenrand des Kurzschluss-Halbleiterbauelements 22. Da der zentrale Bereich 13 bei dem in Fig. 3 gezeigten Ausführungsbeispiel des Kurzschluss-Halbleiterbauelements 22 nicht von der Elektrode 24 und damit auch nicht von der dicken Kontaktscheibe 18 (Fig. 2) kontaktiert bzw. bedeckt ist, könnte Plasma im Zentrum 13 auf die elektrische Zuleitung zum Gate-Anschluss G und auf das Metallrohr in der Keramikkapsel (nicht dargestellt) gelenkt werden und dort die Kapsel beschädigen. Dies wird durch das in Fig. 3 gezeigte Ausführungsbeispiel des Kurzschluss-Halbleiterbauelements 22 sicher verhindert, da die Durchlegierung 21 (Fig. 2) im Kurzschlussfall stets innerhalb des von der Elektrode 24 überdeckten Bereichs der Emitterstruktur 23 ausgelöst wird.

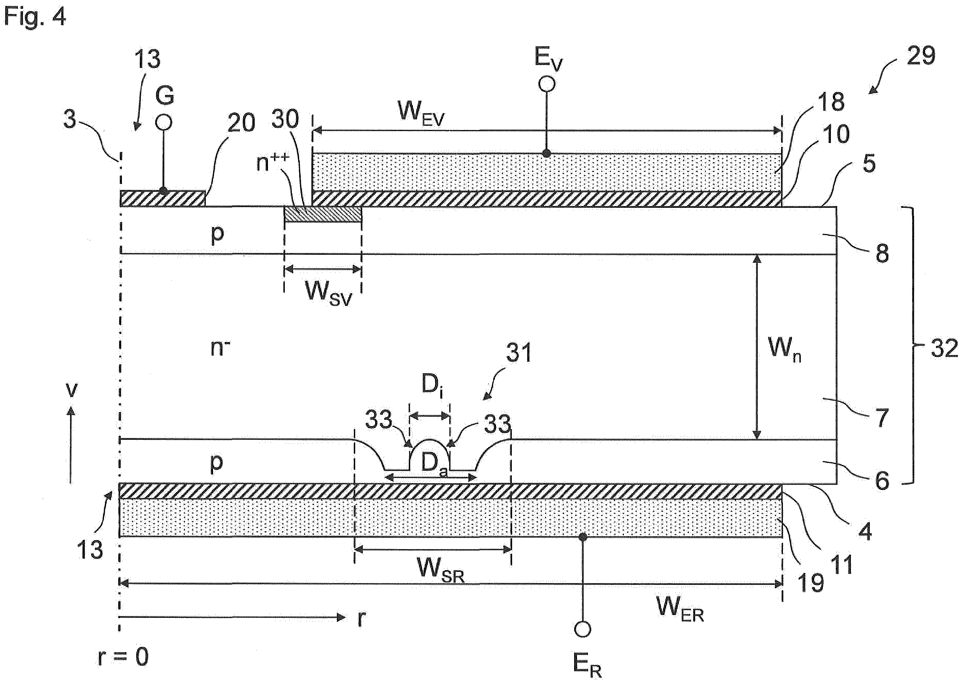

Fig. 4 stellt einen Vertikalschnitt durch ein weiteres Ausführungsbeispiel eines Kurzschluss-Halbleiterbauelements 29 gemäß der Erfindung mit zwei Einschaltstrukturen 30 und 31 und der Zündstruktur 20 (Gate-Elektrode) dar. Wie Fig. 4 zu entnehmen ist, weist das Kurzschluss-Halbleiterbauelement 29 in einem Halbleiterkörper 32 eine n-dotierte vorderseitige Einschalt- bzw. Emitterstruktur 30 auf, deren laterale Emitterstrukturweite W_{SV} im Vergleich zur lateralen vorderseitigen Elektrodenweite W_{EV} noch deutlich kleiner gewählt ist als bei dem Kurzschluss-Halbleiterbauelement 15 aus Fig. 2. Ebenfalls ist in Fig. 4 zu erkennen, dass die Emitterstruktur 30 in diesem Ausführungsbeispiel keine Kurzschlüsse 12 wie in Fig. 2 dargestellt aufweist. Die Einschalt- bzw. Emitterstruktur 30 kann als umfänglich geschlossene Ring- und/oder Polygonstruktur ausgebildet sein, die die Zündstruktur 20 in einem gewissen radialen Abstand umgibt. Auch die Emitterstruktur 30 ragt an der radialen, dem Zentrum 13 zugewandten Innenseite der Elektrode 10 etwas über diese hinaus, wie dies bereits im Zusammenhang mit der Emitterstruktur 17 in Fig. 2 beschrieben wurde.

Außerdem weist der Halbleiterkörper 32 zusätzlich zur durch die Gate-Elektrode 20 gebildeten, im Zentrum 13 des Halbleiterkörpers 32 angeordneten Zündstruktur 20 eine zweite Einschaltstruktur 31 in Form einer Durchbruchstruktur 31 auf, die in diesem Ausführungsbeispiel als umfänglich geschlossene, ringförmige BOD-Struktur ausgebildet ist. Mittels der Durchbruchstruktur 31 ist das Kurzschluss-Halbleiterbauelement 29 abhängig von der an den Elektrodenanschlüssen E_{V} und E_{R} anliegenden Betriebsspannung ebenfalls einschaltbar, in dem gezeigten Ausführungsbeispiel bei einer an der rückseitigen Elektrode 11 gegenüber der vorderseitigen Elektrode 10 anliegenden negativen Polarität. Sie dient außerdem zur zusätzlichen Vermeidung eines Sperrausfalles im radial äußeren Randbereich des Kurzschluss-Halbleiterbauelements 29 im Falle einer nicht vorhersehbaren, an den Elektrodenanschlüssen E_{V} und E_{R} anliegenden Überspannung.

Wie in Fig. 4 zu erkennen ist, befindet sich die Durchbruchstruktur 31 auf der der vorderseitigen Emitterstruktur 30 gegenüberliegenden Seite des Halbleiterkörpers 32 und stellt somit eine rückseitige Einschaltstruktur 31 des Kurzschluss-Halbleiterbauelements 29 dar. Die Höhe der Durchbruchspannung dieser Durchbruchstruktur 31 wird dabei so eingestellt, dass sie an genau dem Ort ihrer Anordnung ihren niedrigsten Wert des ganzen Halbleiterkörpers 32 annimmt und so auch einen Durchbruch im äußeren Randbereich des Halbleiterkörpers 32 verhindert. Der Krümmungsradius des pn-Überganges, d. h. seine geometrische Krümmung, in einem in Fig. 4 mit dem Bezugszeichen 33 gekennzeichneten Bereich bestimmt zusammen mit dem spezifischen Widerstand und dem Verhältnis der Durchmesser Dᵢ (Innendurchmesser) und Dₐ (Außendurchmesser) der Durchbruchstruktur 31 die Höhe der Durchbruchspannung in an sich bekannter Weise, wie dies beispielsweise in der DE 42 15 378 C1 beschrieben ist. Im Falle einer auftretenden Überspannung in Sperrrichtung U_{R} (negative Polarität am rückseitigen Elektrodenanschluss E_{R}) kommt es im Bereich 33 ab einer bestimmten Spannung zu einem steilen Anstieg des zwischen den Hauptanschlüssen E_{V} und E_{R} fließenden Sperrstroms. Die Stromdichte erreicht dabei so hohe Werte, dass am Ende zwischen den beiden Hauptanschlüssen E_{V} und E_{R} ein lokaler Schmelzkanal entsteht. Die Sperrfähigkeit der npnp-Struktur bricht zusammen und der Kurzschlussstrom führt im Bereich der BOD-Struktur 31 zur Durchlegierung.

Da die Durchbruchstruktur 31 bei dem in Fig. 4 gezeigten Ausführungsbeispiel des Kurzschluss-Halbleiterbauelements 29 eine rückseitige Einschaltstruktur ist, die in der rückseitigen Basiszone 6 eingebettet ist, auf welche wiederum die rückseitige Elektrode 11 aufgebracht ist, ist für das Verhältnis der lateralen rückseitigen Einschaltstrukturweite W_{SR} der Durchbruchstruktur 31 zur lateralen rückseitigen Elektrodenweite W_{ER} der rückseitigen Elektrode 11 ebenfalls die erfindungsgemäße Bedingung W_{SR}/W_{ER} < 1 zu erfüllen, was bei dem in Fig. 4 dargestellten Kurzschluss-Halbleiterbauelement 29 offensichtlich der Fall ist.

Wie Fig. 4 zu entnehmen ist, ist die laterale Einschaltstrukturweite W_{SR} der Durchbruchstruktur 31 auf denjenigen lateralen Bereich der Basiszone 6 festgelegt, in dem die Geometrie des zwischen dieser Basiszone 6 und der Innenzone 7 gebildeten pn-Übergangs deutlich gegenüber der Geometrie des restlichen pn-Übergangs, das heißt des pn-Übergangs außerhalb des durch die laterale rückseitige Einschaltstrukturweite W_{SR} festgelegten Bereichs, verändert ist. Hierbei ist insbesondere zu verstehen, dass eine veränderte Geometrie dieses pn-Übergangs im Sinne der vorliegenden Erfindung erst dann vorliegt, wenn diese Veränderung sicher nicht den herstellungsbedingten Toleranzabweichungen bei der Herstellung der Basiszone 6 und der Innenzone 7 zuzurechnen ist, sondern das Ergebnis zielgerichteten Handelns ist.

Die Durchbruchstruktur 31 des in Fig. 4 dargestellten Kurzschluss-Halbleiterbauelements 29 weist eine das Zentrum 13 des Halbleiterkörpers 32 umgebende Ringform auf und ist dementsprechend zum Zentrum 13 radial beabstandet. Insbesondere ist die Durchbruchstruktur bzw. rückseitige Einschaltstruktur 31 bei dem in Fig. 4 gezeigten Ausführungsbeispiel des Kurzschluss-Halbleiterbauelements 29 vollständig von der vorderseitigen Elektrode 10 und der rückseitigen Elektrode 11 überdeckt. Die vollständige vorder- und rückseitige Überdeckung der Durchbruchstruktur 31 bietet den Vorteil, dass ein Plasmaaustritt aus dem Halbleiterkörper 29 aufgrund der lokalen Begrenzung der Durchlegierung im Bereich um die beidseitig von den Elektroden 10 und 11 überdeckte Durchbruchstruktur 31 sicher verhindert wird.

Die als Einschaltstruktur fungierende Durchbruchstruktur 31 kann prinzipiell jedoch auch im Zentrum 13 des Halbleiterkörpers 32 angeordnet sein, wie dies beispielsweise ebenfalls in der DE 42 15 378 C1 beschrieben ist. In einem solchen, in Fig. 4 nicht dargestellten Fall wäre die Durchbruchstruktur 31 bevorzugt ebenfalls sowohl auf der Vorderseite 5 des Halbleiterkörpers 32 als auch auf seiner Rückseite 4 von den jeweiligen Elektroden 10 und 11 überdeckt, um dieselbe Wirkung bezüglich eines Plasmaaustritts zu erzielen wie vorstehend beschrieben. Mit anderen Worten bräuchte ein Kurzschluss-Halbleiterbauelement mit wenigstens einer im Zentrum angeordneten Einschaltstruktur, insbesondere einer als Einschaltstruktur ausgebildeten Durchbruchstruktur, keine dort angeordnete Zündstruktur wie zum Beispiel die in Fig. 4 gezeigte Gate-Elektrode 20 mit einem Gate-Anschluss G. Da die Durchbruchstruktur 31 das Einschaltsignal aus der an den Elektrodenanschlüssen E_{V} und E_{R} anliegenden Spannung bezieht, kann auf die Zuführung eines zusätzlichen externen Einschaltsignals verzichtet werden.

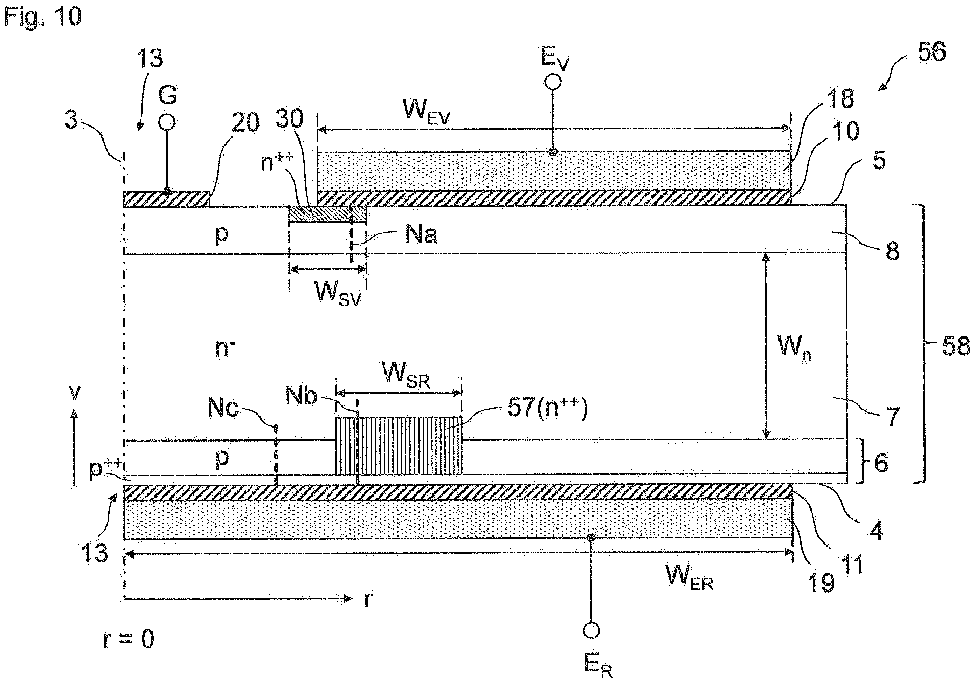

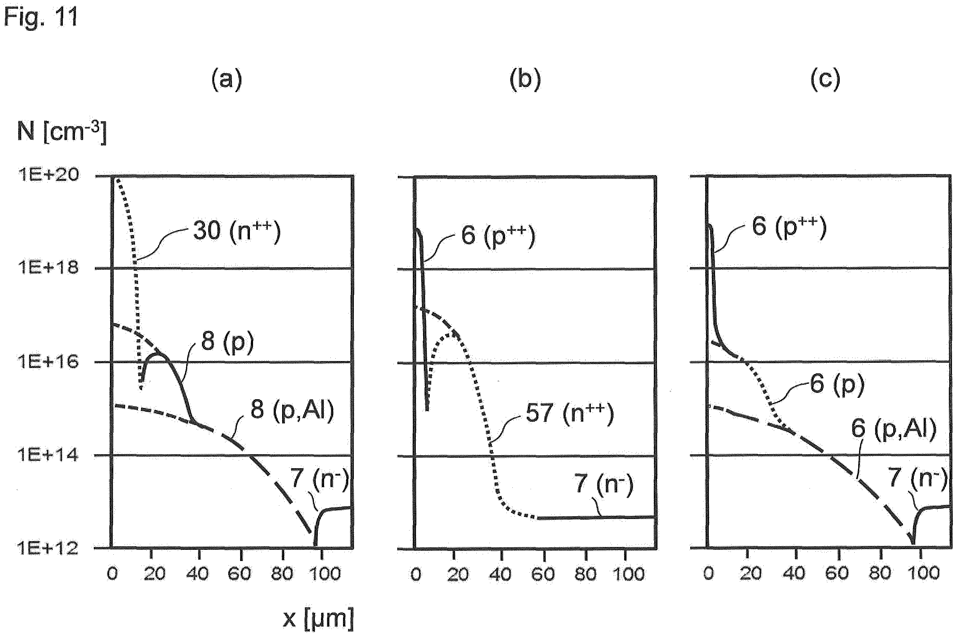

Es sei an dieser Stelle angemerkt, dass die in Fig. 4 als BOD-Struktur gezeigte Durchbruchstruktur 31 auch durch jede andere an sich wohl bekannte Durchbruchstruktur mit ähnlicher Wirkung ersetzt werden kann, sofern sie als Einschaltstruktur dazu ausgebildet ist, die Durchlegierung des entsprechenden Kurzschluss-Halbleiterbauelements in Abhängigkeit von einem Einschaltsignal, das sich bei einer im Halbleiterkörper integrierten Durchbruchstruktur stets implizit aus der an den äußeren Elektroden 10 und 11 anliegenden elektrischen Spannung ergibt, einzuleiten. Derartige andere Durchbruchstrukturen sind zum Beispiel eine einen an sich bekannten du/dt-Schutz aufweisende Durchbruchstruktur oder eine einen an sich bekannten Freiwerdezeitschutz mit lokaler Anhebung der Ladungsträgerlebensdauer aufweisende Durchbruchstruktur. Eine noch weitere, zur Durchbruchstruktur 31 alternative Durchbruchstruktur wird weiter unten im Zusammenhang mit der Erläuterung der Fig. 10 und 11 beschrieben.

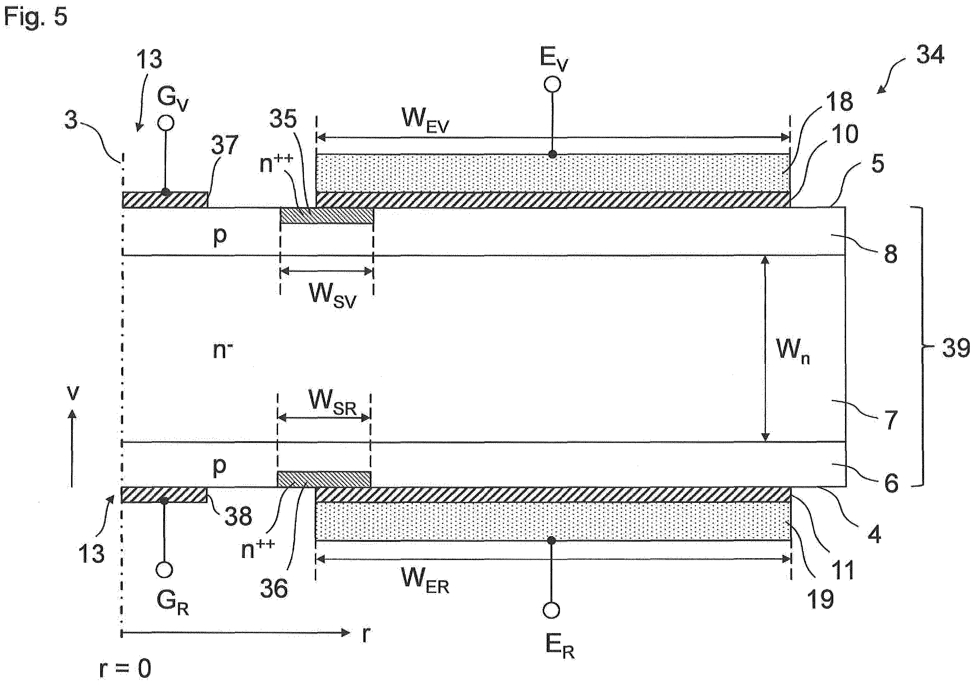

Fig. 5 stellt einen Vertikalschnitt durch ein noch weiteres Ausführungsbeispiel eines Kurzschluss-Halbleiterbauelements 34 gemäß der Erfindung mit zwei Einschaltstrukturen 35, 36 und zwei Zündstrukturen 37, 38 dar. Die zwei Einschaltstrukturen 35 und 36 sind jeweils als n-dotierte Emitterstrukturen ausgebildet, die jeweils in der vorderseitigen bzw. rückseitigen Basiszone 8 bzw. 6 eines Halbleiterkörpers 39 eingebettet sind. Die Einschalt- bzw. Emitterstrukturen 35, 36 können als umfänglich geschlossene Ring- und/oder Polygonstrukturen ausgebildet sein. Wie Fig. 5 deutlich zu entnehmen ist, ragen beide Emitterstrukturen 35 und 36 jeweils etwas über den radialen, dem jeweiligen Zentrum 13 zugewandten Innenrand der jeweiligen Elektrode 10 bzw. 10 hinaus. Die beiden Zündstrukturen 37 und 38 sind jeweils als Gate-Elektroden 37, 38 mit je einem vorder- bzw. rückseitigen Gate-Anschluss G_{V} bzw. G_{R} ausgebildet, wobei die vorderseitige Gate-Elektrode 37 im Zentrum 13 der vorderseitigen Basiszone 8 diese elektrisch kontaktierend angeordnet ist und die Gate-Elektrode 38 im Zentrum 13 der rückseitigen Basiszone 6. Bei dem in Fig. 5 dargestellten Ausführungsbeispiel des Kurzschluss-Halbleiterbauelements 34 weisen beide Einschaltstrukturen 35, 36 dieselbe laterale Einschaltstrukturweite W_{SV} bzw. W_{SR} auf, was jedoch nicht zwingend erforderlich ist. Die lateralen Elektrodenweiten W_{EV} und W_{ER} der vorder- bzw. rückseitigen Elektroden 10 und 11 weisen bei dem Kurzschluss-Halbleiterbauelement 34 ebenfalls dieselbe Größe auf, was ebenfalls nicht zwingend erforderlich ist. Das Kurzschluss-Halbleiterbauelement 34 ist folglich bezüglich der vertikalen Richtung vollkommen symmetrisch aufgebaut. Die lateralen Elektrodenweiten W_{EV} und W_{ER} sind deutlich größer als die entsprechenden lateralen Einschaltstrukturweiten W_{SV} bzw. W_{SR}, so dass auch für dieses Kurzschluss-Halbleiterbauelement 34 die Bedingungen W_{SV}/W_{EV} < 1 und W_{SR}/W_{ER} < 1 gelten. Das Kurzschluss-Halbleiterbauelement 34 lässt sich demnach sowohl über ein dem vorderseitigen Gate-Anschluss G_{V} zugeführtes elektrisches Einschaltsignal als auch über ein dem rückseitigen Gate-Anschluss G_{R} zugeführtes elektrisches Einschaltsignal einschalten.

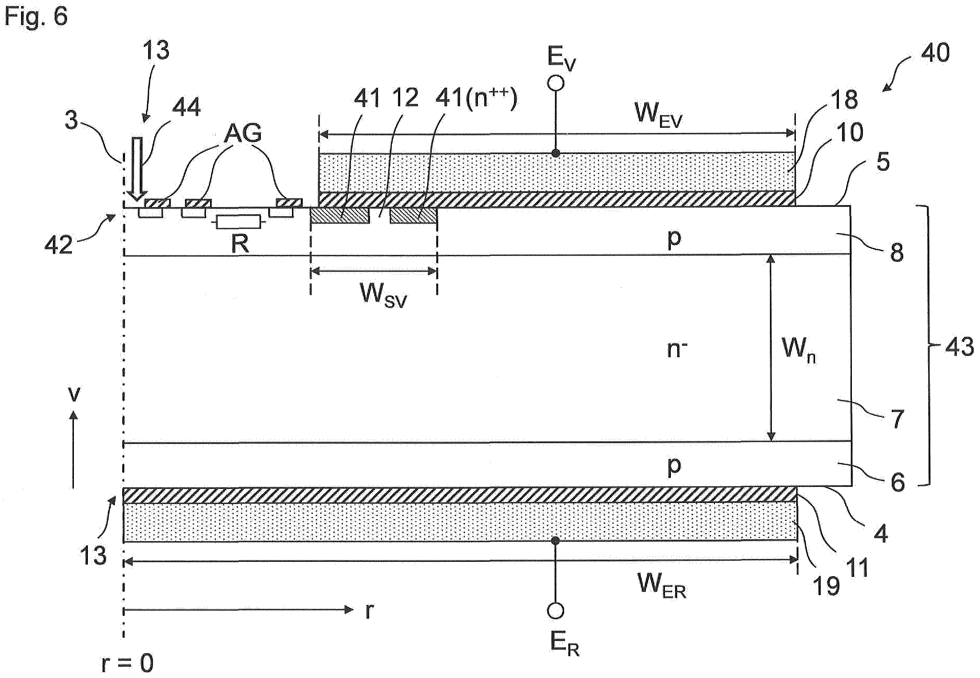

Fig. 6 stellt einen Vertikalschnitt durch ein noch weiteres Ausführungsbeispiel eines Kurzschluss-Halbleiterbauelements 40 gemäß der Erfindung mit einer Einschaltstruktur 41 und einer Zündstruktur 42 dar. In einem Halbleiterkörper 43 ist die Einschaltstruktur 41 als n-dotierte vorderseitige Emitterstruktur 41 mit Kurzschlüssen 12 in die vorderseitige Basiszone 8 eingebettet. Die Zündstruktur 42 ist in diesem Ausführungsbeispiel als lichtempfindlicher Bereich 42 im Zentrum 13 der vorderseitigen Basiszone 8 ausgebildet. Das der Zündstruktur bzw. dem lichtempfindlichen Bereich 42 extern zugeführte Einschaltsignal ist in diesem Fall ein optisches Einschaltsignal 44. Die Einschalt- bzw. Emitterstruktur 41 kann als umfänglich geschlossene Ring- und/oder Polygonstruktur ausgebildet sein und ragt, wie in Fig. 6 zu erkennen ist, etwas über den radialen, dem Zentrum 13 zugewandten Innenrand der Elektrode 10 hinaus. Als Lichtquelle zur Erzeugung des optischen Signals 44 sind Laser oder besonders bevorzugt kostengünstigere LEDs geeignet.

Wie Fig. 6 zu entnehmen ist, schließt sich an den im Zentrum 13 angeordneten lichtempfindlichen Bereich 42 radial nach außen verlaufend eine mit dem lichtempfindlichen Bereich 42 funktional gekoppelte, hier mehrstufige, Amplifying-Gate-Struktur AG an. Der im Zentrum 13 angeordnete lichtempfindliche Bereich 42, der der 1. AG-Stufe (radial innerste AG-Stufe) zugeordnet ist und innerhalb dieser angeordnet ist, weist keine Metallisierung auf, damit das optische Signal 44 in das Silizium des Halbleiterkörpers 43 eindringen kann. Der Durchmesser der 1. AG-Stufe, auch als optisches Gate 42 bezeichnet, da hier das optische Signal 44 eingekoppelt wird, hat einen Wert im Bereich von etwa 1-2 mm. Wegen der im Vergleich zu Gate-Elektroden sehr kleinen Abmessung ist das optische Gate 42 durch einen in der p-dotierten vorderseitigen Basiszone 8 integrierten Begrenzungswiderstand R, wie er auch bei einem herkömmlichen lichtzündbaren Thyristor (LTT) realisiert ist, vor der Zerstörung beim Einschalten des Kurzschluss-Halbleiterbauelements 40 geschützt. Ohne diesen Widerstand R bestünde die Gefahr, dass das Kurzschluss-Halbleiterbauelement 40 nicht im Bereich der durch die vorderseitige Elektrode 10 und die diese kontaktierende Kontaktscheibe 18 bedeckten n-dotierten vorderseitigen Emitterstruktur 41 zerstört wird, sondern im nicht kontaktierten Bereich im optischen Gate 42, was im Kurzschlussfall des Kurzschluss-Halbleiterbauelements 40 dort zum Plasmaaustritt führen könnte. Der Strombegrenzungswiderstand R stellt also sicher, dass im durch das optische Signal 44 ausgelösten Einschaltfall (Kurzschlussfall des Halbleiterbauelements 40) stets die Einschaltstruktur 41, hier die Emitterstruktur 41, eingeschaltet wird, bevor ein Ausfall bzw. eine Zerstörung des nicht durch die Kontaktscheibe 18 kontaktierten Bereichs zwischen der Zündstruktur 42 und der Einschaltstruktur 41 auftreten kann.

Es ist auch ein Kurzschluss-Halbleiterbauelement denkbar (nicht dargestellt), das sowohl elektrisch als auch optisch ansteuerbar, das heißt einschaltbar, ist. Dieses Kurzschluss-Halbleiterbauelement würde dementsprechend zwei parallel geschaltete Zündstrukturen aufweisen, nämlich sowohl eine Gate-Elektrode als auch einen lichtempfindlichen Bereich. Eine solche Struktur ist zum Beispiel in der DE 10 2004 025 082 B4 näher beschrieben. Das optische Gate befindet sich dabei wie das optische Gate 42 des Kurzschluss-Halbleiterbauelements 40 im Zentrum 13 des entsprechenden Halbleiterkörpers und wird auch durch einen vorgeschalteten Begrenzungswiderstand R, wie in Fig. 6 gezeigt, vor einem zu hohen Einschaltstrom geschützt. Der Gate-Anschluss für den elektrischen Anschluss des Einschaltsignals kontaktiert in diesem Fall einen metallisierten Ring, welcher sich radial außerhalb des Widerstands R befindet und das optische Gate umgibt.

Bezüglich der Darstellung des Kurzschluss-Halbleiterbauelements 40 in Fig. 6 sei auch darauf hingewiesen, dass anstelle eines extern zugeführten Einschaltsignals, zum Beispiel anstelle des in Fig. 6 dargestellten optischen Einschaltsignals 44, eine wie bereits hierin beschriebene Durchbruchstruktur (nicht dargestellt) als Zündstruktur ebenfalls im Bereich der zentrumsnahen 1. AG-Stufe angeordnet sein kann, wobei die Durchbruchstruktur, wie hierin bereits an unterschiedlichen Stellen ausgeführt wurde, beispielsweise als eine BOD-Struktur und/oder als eine einen du/dt-Schutz aufweisende Durchbruchstruktur und/oder als eine einen Freiwerdezeitschutz mit lokaler Anhebung der Ladungsträgerlebensdauer aufweisende Durchbruchstruktur ausgebildet sein kann. In diesem Fall würde die Durchlegierung eines derartigen Kurzschluss-Halbleiterbauelements durch Erreichen bzw. Überschreiten der für die vorgesehene Durchbruchstruktur bestimmten Durchbruchspannung, die unmittelbar von der an den äußeren Elektroden 10 und 11 anliegenden elektrischen Spannung abhängt, ausgelöst, wobei der Avalanchestrom der Durchbruchstruktur in diesem Fall eine oder mehrere der die AG-Struktur bildenden Amplifying Gates AG ansteuert, das heißt einschaltet, die dann wiederum die Einschaltstruktur, zum Beispiel eine Emitterstruktur, einschaltet, um die Durchlegierung des Kurzschluss-Halbleiterbauelements letztendlich einzuleiten, die bei dem erfindungsgemäßen Kurzschluss-Halbleiterbauelement stets im von der jeweiligen Elektrode 10 bzw. 11 überdeckten Bereich der Einschaltstruktur stattfindet. Es sei darauf hingewiesen, dass die zentrumsnah angeordnete, sich radial innerhalb der 1. AG-Stufe befindende Durchbruchstruktur in diesem Fall nicht von der entsprechenden Hauptelektrode, das heißt der Elektrode 10 oder 11, die auf die die Durchbruchstruktur enthaltende Basiszone aufgebracht ist, und der diese Elektrode kontaktierenden Kontaktscheibe 18 bzw. 19 überdeckt ist, da die AG-Struktur in radialer Richtung r zwischen der Durchbruchstruktur und der Hauptelektrode 10 bzw. 11 angeordnet ist.

Es sei an dieser Stelle angemerkt, dass die in Fig. 6 gezeigte Amplifying-Gate-Struktur AG mit allen hierin beschriebenen Zündstrukturen alleine oder auch mit zwei oder mehr Zündstrukturen unterschiedlichen Typs kombiniert werden kann. Die AG-Struktur kann lediglich eine einzige oder auch mehrere AG-Stufen, wie in Fig. 6 gezeigt, aufweisen. Das Vorsehen der AG-Stufen ist jedoch nicht zwingend erforderlich. So könnte beispielsweise bei der Gewährleistung eines ausreichend leistungsstarken Einschaltsignals auf eine das Einschaltsignal verstärkende AG-Struktur verzichtet werden, wie zum Beispiel bei einem einem als Zündstruktur ausgebildeten lichtempfindlichen Bereich zugeführten optischen Einschaltsignal mit einer Lichtleistung größer oder gleich etwa 1000 mW.

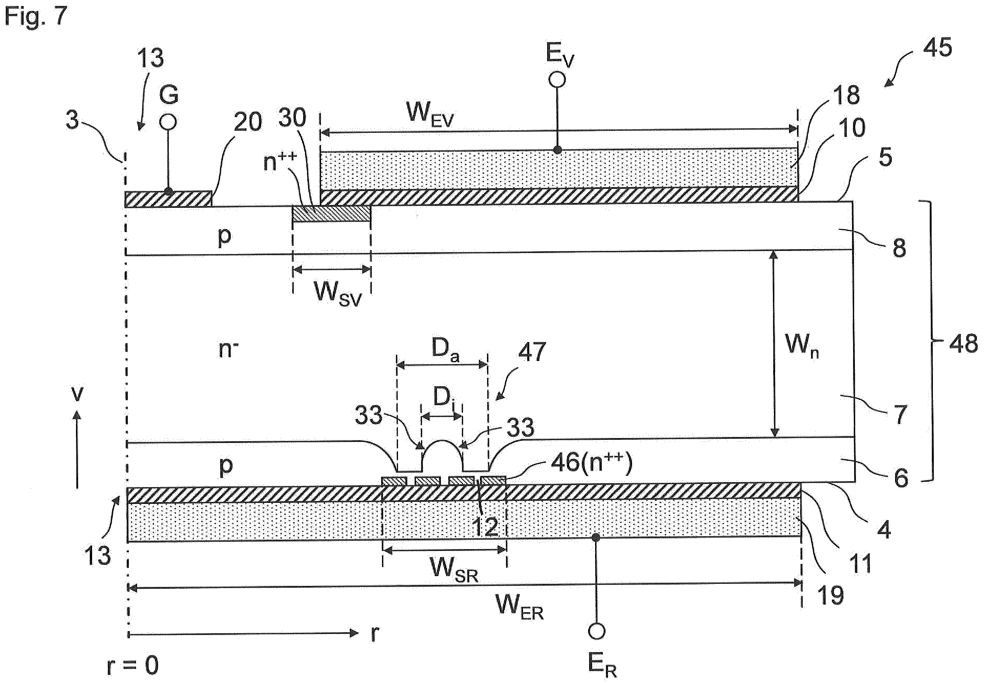

Fig. 7 stellt einen Vertikalschnitt durch ein weiteres Ausführungsbeispiel eines Kurzschluss-Halbleiterbauelements 45 gemäß der Erfindung mit zwei Einschaltstrukturen 30 und 46 und zwei Zündstrukturen 20 und 47 dar. In einem Halbleiterkörper 48 ist die rückseitige Einschaltstruktur 46 als n-dotierte Emitterstruktur 46 mit Kurzschlüssen 12 und einer lateralen rückseitigen Einschaltstrukturweite W_{SR} angrenzend an die Rückseite 4 in die rückseitige Basiszone 6 eingebettet und von der rückseitigen Elektrode 11 elektrisch leitend kontaktiert und vollständig bedeckt. Die Einschalt- bzw. Emitterstruktur 46 kann als umfänglich geschlossene Ring- und/oder Polygonstruktur ausgebildet sein. Im selben lateralen Bereich der Einschaltstruktur 46, jedoch in vertikaler Richtung v hierzu versetzt, ist die als Durchbruchstruktur, zum Beispiel als BOD-Struktur, ausgebildete rückseitige Zündstruktur 47 angeordnet. Wie bereits im Zusammenhang mit Fig. 4 beschrieben wurde, setzt bei Erreichen bzw. Überschreiten der für die Durchbruchstruktur 47 festgelegten Durchbruchspannung, die unmittelbar von der an den äußeren Elektroden 10 und 11 anliegenden, als Einschaltsignal dienenden elektrischen Spannung abhängt, ein steiler, lokal begrenzter Stromanstieg im Bereich 33 ein, der bei dem in Fig. 7 gezeigten Beispiel des Kurzschluss-Halbleiterbauelements 45 zum Einschalten der rückseitigen Emitterstruktur 46 genutzt wird, wodurch letztendlich das Durchlegieren des Kurzschluss-Halbleiterbauelements 45 eingeleitet wird. Das Vorsehen der Emitterstruktur 46 als Einschaltstruktur, die von der Durchbruchstruktur 47 eingeschaltet wird, hat den Vorteil einer lateralen Aufweitung des durchlegierten Bereichs gegenüber der in Fig. 4 gezeigten, als Durchbruchstruktur ausgebildeten Einschaltstruktur 31, bei der der von der Durchbruchstruktur 31 zur Durchlegierung ausgehende Schmelzkanal lokal eng begrenzt ist. Die Emitterstruktur 46 hilft aufgrund der lateralen Aufweitung des Schmelzkanals, die Durchlegierung "weicher" ablaufen zu lassen. Zudem erlaubt ein im Querschnitt größerer Durchlegierungsbereich im Halbleiterkörper 48 aufgrund des verringerten Leitungswiderstands ein dauerhaftes Führen höherer Kurzschlussströme mit geringeren Leitungsverlusten.

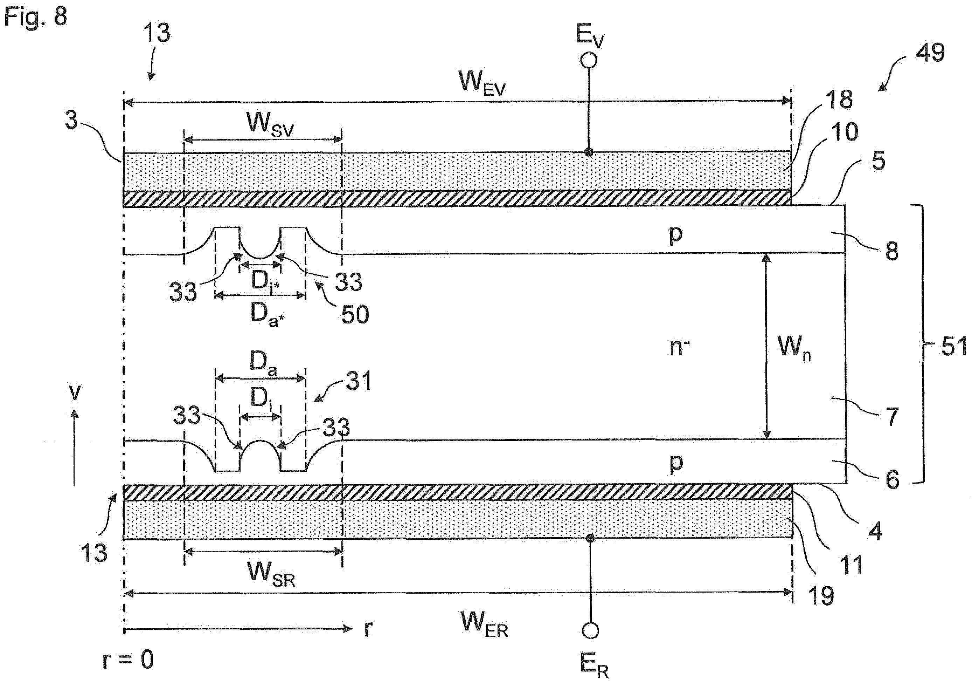

Fig. 8 stellt einen Vertikalschnitt durch ein noch weiteres Ausführungsbeispiel eines Kurzschluss-Halbleiterbauelements 49 gemäß der Erfindung mit zwei Einschaltstrukturen 31 und 50 dar. In einem Halbleiterkörper 51 ist zwischen der rückseitigen Basiszone 6 und der Innenzone 7 die bereits in Fig. 4 gezeigte Durchbruchstruktur 31 als rückseitige Einschaltstruktur angeordnet und zwischen der vorderseitigen Basiszone 8 und der Innenzone 7 die ebenfalls als Durchbruchstruktur ausgebildete vorderseitige Einschaltstruktur 50. Die beiden Durchbruchstrukturen 31 und 50 sind jeweils beispielhaft als umfänglich geschlossene, ringförmige BOD-Strukturen ausgebildet. Der Innendurchmesser D_{i*} und der Außendurchmesser D_{a*} der Durchbruchstruktur 50 können jeweils von dem Innendurchmesser Dᵢ und dem Außendurchmesser Dₐ der Durchbruchstruktur 31 verschieden sein. Die Durchbruchstrukturen 31 und 50 könnten in diesem Fall auf unterschiedliche Durchbruchspannungen ausgelegt sein. Dies ist jedoch nicht zwingend erforderlich, so dass die beiden Durchbruchstrukturen 31 und 50 auch identisch ausgebildet sein können und für beide damit dieselben Durchbruchspannungen festgelegt sein können.

Da eine Durchbruchstruktur lediglich ab einer entsprechend der speziellen Ausgestaltung der Durchbruchstruktur festgelegten Durchbruchspannung einer bestimmten Polarität durchbrochen wird, bietet die Ausgestaltung des in Fig. 8 gezeigten Kurzschluss-Halbleiterbauelements 49 u. a. den Vorteil, dass mit den beiden im Halbleiterkörper 51 vorgesehenen Durchbruchstrukturen 31 und 50, die einmal der vorderseitigen Basiszone 8 und einmal der rückseitigen Basiszone 6 zugeordnet sind, das Kurzschluss-Halbleiterbauelement 49 sowohl für eine an den Hauptelektroden 10 und 11 anliegende elektrische Spannung einer ersten Polarität als auch für eine an den Hauptelektroden 10 und 11 anliegende elektrische Spannung einer zur ersten Polarität invertierten zweiten Polarität durchlegiert werden kann, sobald die entsprechende Durchbruchstruktur 31 bzw. 50 bei Überschreiten ihrer jeweiligen Durchbruchspannung einschaltet.

In Fig. 8 ist weiterhin zu erkennen, dass sowohl die vorderseitige Elektrode 10 als auch die rückseitige Elektrode 11 das jeweilige Zentrum 13 vollständig überdecken, da dem Kurzschluss-Halbleiterbauelement 49 kein zusätzliches externes Einschaltsignal zugeführt werden muss. In Fig. 8 sind die beiden Durchbruchstrukturen 31 und 50 zwar zum Zentrum 13 beabstandet angeordnet dargestellt, es versteht sich jedoch, dass eine oder beide Durchbruchstrukturen 31 und 50 in diesem Fall auch unmittelbar im jeweiligen Zentrum 13 angeordnet werden können mit den hierin bereits erläuterten Vorteilen.

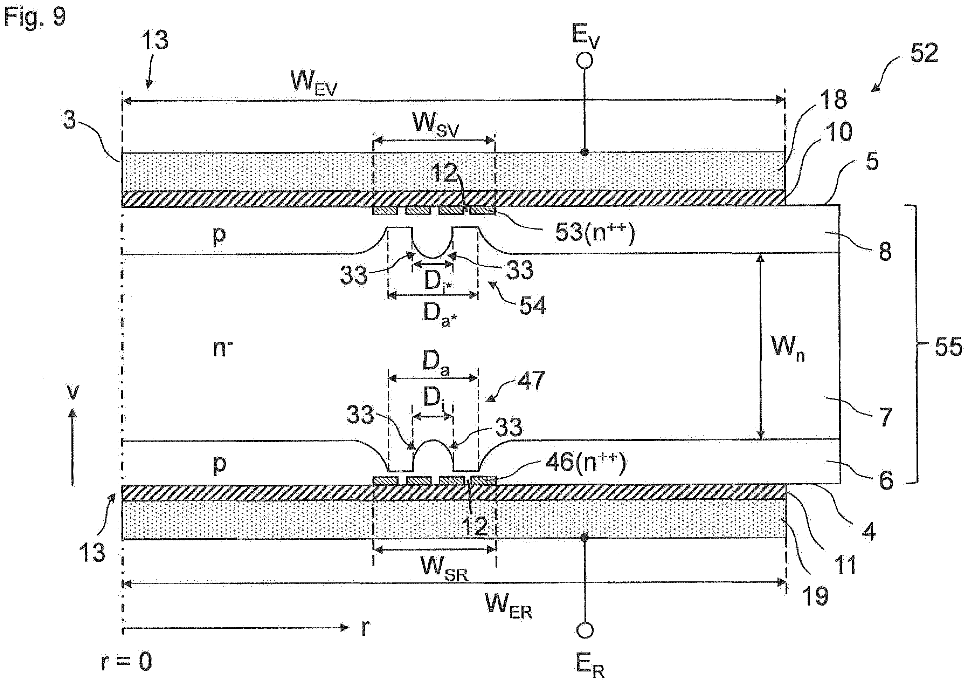

Fig. 9 stellt einen Vertikalschnitt durch ein noch weiteres Ausführungsbeispiel eines Kurzschluss-Halbleiterbauelements 52 gemäß der Erfindung mit zwei Einschaltstrukturen 46 und 53 und zwei Zündstrukturen 47 und 54 dar. In einem Halbleiterkörper 55 sind rückseitig die bereits in Fig. 7 gezeigte, als Emitterstruktur ausgebildete Einschaltstruktur 46 sowie die mit dieser elektrisch wirkverbundene rückseitige, als Durchbruchstruktur ausgebildete Zündstruktur 47 eingebettet. Vorderseitig ist in ähnlicher Weise die als n-dotierte Emitterstruktur ausgebildete vorderseitige Einschaltstruktur 53 in die vorderseitige Basiszone 8 angrenzend an die Vorderseite 5 eingebettet und von der vorderseitigen Elektrode 10 elektrisch kontaktiert. Der vorderseitigen Emitterstruktur 53 ist die vorderseitige Zündstruktur 54 zugeordnet, die ebenfalls als Durchbruchstruktur ausgebildet ist und die Emitterstruktur 53 im Durchbruchfall einschaltet. Die Wirkungsweise der Kombination der vorderseitigen Emitterstruktur 53 mit der vorderseitigen Durchbruchstruktur 54 entspricht der Kombination der rückseitigen Emitterstruktur 46 mit der rückseitigen Durchbruchstruktur 47 und wurde bereits im Zusammenhang mit der Beschreibung der Fig. 7 erläutert. Beide Einschalt- bzw. Emitterstrukturen 46, 53 sowie beide Zündstrukturen 47, 54 können jeweils als umfänglich geschlossene Ring- und/oder Polygonstrukturen ausgebildet sein.

Wie bereits bei der Ausgestaltung des Kurzschluss-Halbleiterbauelements 49 nach Fig. 8 erwähnt, können auch die Einschalt- und Zündstrukturen 46, 53, 46, 54 des Kurzschluss-Halbleiterbauelements 52 exakt mittig, das heißt im jeweiligen Zentrum 13, angeordnet werden.

Fig. 10 stellt einen Vertikalschnitt durch ein weiteres Ausführungsbeispiel eines Kurzschluss-Halbleiterbauelements 56 gemäß der Erfindung mit zwei Einschaltstrukturen 30 und 57 und einer Zündstruktur 20 dar. In einem Halbleiterkörper 58 ist zusätzlich zur bereits aus Fig. 4 bekannten vorderseitigen Einschaltstruktur 30 die rückseitige Einschaltstruktur 57 in Form einer noch weiteren Ausbildung einer Durchbruchstruktur eingebettet. Insbesondere ist in Fig. 10 gut zu erkennen, dass die rückseitige Einschaltstruktur 57 lokal begrenzt ist, insbesondere in radialer Richtung r lokal begrenzt ist, und damit eine laterale Strukturweite W_{SR} aufweist, die deutlich kleiner ist als die laterale Elektrodenweite W_{ER} der zugeordneten rückseitigen Elektrode 11, wie es bei allen hierin offenbarten lateralen Einschaltstrukturweiten bezogen auf die entsprechenden lateralen Elektrodenweiten der jeweiligen Elektroden des erfindungsgemäßen Kurzschluss-Halbleiterbauelements der Fall ist.

Weiterhin ist Fig. 10 zu entnehmen, dass die rückseitige Basiszone 6 einen der Rückseite 4 zugewandten, flachen, im Vergleich zum der Innenzone 7 zugewandten Bereich hoch p-dotierten p⁺⁺-Bereich aufweist. In einem lateralen Abschnitt, welcher der lateralen Einschaltstrukturweite W_{SR} entspricht, ist in den gewöhnlich p-dotierten Bereich der rückseitigen Basiszone 6 ein gegenüber der n-dotierten Innenzone 7 wesentlich höher n-dotierter n⁺⁺-Bereich eingefügt, der in vertikaler Richtung v bis in die Innenzone 7 reicht. Die Rückseite 4 des Halbleiterkörpers 58, auf dem die rückseitige Elektrode 11 aufgebracht ist, erreicht der n⁺⁺-Bereich nicht, da der hochdotierte p⁺⁺-Bereich der Basiszone 6 den eingefügten n⁺⁺-Bereich von der durch die Elektrode 11 kontaktierten Rückseite 4 beabstandet. Die Konzentration des p⁺⁺-Bereichs der rückseitigen Basiszone 6 wird höher gewählt als die Konzentration des den p-Bereich der Basiszone 6 unterbrechenden n⁺⁺-Bereichs, um einen Kurzschluss zwischen der Innenzone 7 und der rückseitigen Elektrode 11 zu verhindern.

Auch für die in Fig. 10 gezeigte Durchbruchstruktur 57 lässt sich eine Durchbruchspannung gezielt einstellen, beispielsweise durch die Wahl der Dotierkonzentration der schwach n-dotierten Innenzone 7 und/oder des hochdotierten n⁺⁺-Bereichs und/oder der p-dotierten Basiszone 6, insbesondere ihres hochdotierten, die Durchbruchstruktur 57 zur Rückseite 4 des Halbleiterkörpers 58 hin beabstandenden p⁺⁺-Bereichs, wobei die Durchbruchspannung der Durchbruchstruktur 57 sinkt je höher die Konzentration ihres n⁺⁺-Bereichs und/oder des p⁺⁺-Bereichs der Basiszone 6 gewählt wird. Es lassen sich auf diese Weise Durchbruchspannungen im Bereich weit unter 10 V bis zur maximal möglichen Sperrfähigkeit des Halbleiterkörpers 58 festlegen.

Fig. 11 stellt in den Ansichten (a), (b) und (c) jeweils einen Konzentrationsverlauf durch das Kurzschluss-Halbleiterbauelement 56 aus Fig. 10 entlang der dort gezeigten Konzentrationsverlaufslinien Na, Nb bzw. Nc dar. In Fig. 11a ist demnach der Konzentrationsverlauf entlang der in Fig. 10 dargestellten Verlaufslinie Na, in Fig. 11b der Konzentrationsverlauf entlang der Verlaufslinie Nb und in Fig. 11c der Konzentrationsverlauf entlang der Verlaufslinie Nc gezeigt. In den jeweiligen Konzentrationsverläufen der Fig. 11a, 11b und 11c ist auf der entsprechenden Abszisse jeweils die Eindringtiefe x in µm des jeweiligen Dotierstoffs aufgetragen. Die Ordinaten stellen jeweils die Konzentration N pro cm⁻³ des jeweiligen Dotierstoffs dar.

In Fig. 11a ist der Konzentrationsverlauf entlang der in Fig. 10 gezeigten Verlaufslinie Na dargestellt, der sich von der Vorderseite 5 des Halbleiterkörpers 58 durch die vorderseitige Einschalt- bzw. Emitterstruktur 30 und die vorderseitige Basiszone 8 bis in die Innenzone 7 erstreckt. In Fig. 11a ist ausgehend von x = 0 der flache Profilverlauf, das heißt ein Verlauf mit geringer Eindringtiefe (hier kleiner etwa 20 µm), der beispielsweise mit Phosphor dotierten n⁺⁺-Emitterstruktur 30 hoher Konzentration (bis etwa 1E20 cm⁻³) in Form einer punktierten Kurve zu erkennen. Hieran schließt mit zunehmender Eindringtiefe x (etwa von 20 µm bis etwa 40 µm) der Konzentrationsverlauf der beispielsweise mit Bor dotierten p-Basiszone 8 in Form einer durchgezogenen Kurve an. Bei dem in Fig. 10 dargestellten Kurzschluss-Halbleiterbauelement 56 ist dem mit Bor dotierten ersten p-Bereich der Basiszone 8 noch ein mit Aluminium (Al) dotierter zweiter p-Bereich der Basiszone 8 mit deutlich geringerer Konzentration (z. B. zwischen etwa 1E13 bis etwa 1E15 cm⁻³) vorgelagert, wie dem Konzentrationsverlauf der Fig. 11a anhand der gestrichelten Kurve zu entnehmen ist. Dieses Al-Profil in der Basiszone 8 ist jedoch nicht zwingend erforderlich. An die Basiszone 8 schließt sich im Konzentrationsverlauf der Fig. 11a mit weiter zunehmender Eindringtiefe x (hier etwa ab 100 µm) der Verlauf der schwach n-dotierten Innenzone 7 mit im Wesentlichen konstanter Konzentration (hier etwa 1E13 cm⁻³) an.

In Fig. 11b ist der Konzentrationsverlauf entlang der in Fig. 10 gezeigten Verlaufslinie Nb dargestellt, der sich von der Rückseite 4 des Halbleiterkörpers 58 durch die rückseitige Basiszone 6 und die rückseitige Einschalt- bzw. Durchbruchstruktur 57 bis in die Innenzone 7 erstreckt. In Fig. 11b ist ausgehend von x = 0 zunächst der sehr flache Profilverlauf des beispielsweise mit Bor dotierten p⁺⁺-Bereichs der Basiszone 6 mit hoher Konzentration von bevorzugt etwa 5E18 cm⁻³ und einer Eindringtiefe von vorzugsweise etwa 5 bis 20 µm in Form einer durchgezogenen Kurve zu sehen. Hieran schließt sich mit zunehmender Eindringtiefe x der Konzentrationsverlauf der beispielsweise mit Phosphor oder Arsen dotierten n⁺⁺-Einschalt- bzw. Durchbruchstruktur 57 an, der in Fig. 11b als punktierte Kurve dargestellt ist. Es ist in Fig. 11b gut zu erkennen, dass die Konzentration N der hochdotierten n⁺⁺-Durchbruchstruktur 57 deutlich geringer ist als die Konzentration N des rückseitig vorgelagerten p⁺⁺-Bereichs der Basiszone 6. Der Konzentrationsverlauf der Durchbruchstruktur 57 geht mit weiter zunehmender Eindringtiefe x in den Verlauf der schwach n⁻-dotierten Innenzone 7 über.

In Fig. 11c ist der Konzentrationsverlauf entlang der in Fig. 10 gezeigten Verlaufslinie Nc dargestellt, der sich von der Rückseite 4 des Halbleiterkörpers 58 durch die rückseitige Basiszone 6 bis in die Innenzone 7 erstreckt. In Fig. 11c ist ausgehend von x = 0 zunächst der sehr flache Profilverlauf des hier mit Bor dotierten p⁺⁺-Bereichs der Basiszone 6 mit hoher Konzentration von bevorzugt etwa 5E18 cm⁻³ und einer Eindringtiefe von vorzugsweise etwa 5 bis 20 µm in Form einer durchgezogenen Kurve zu erkennen. Hieran schließt sich mit zunehmender Eindringtiefe x der Konzentrationsverlauf der restlichen p-dotierten Basiszone 6 mit deutlich geringerer Konzentration N (hier kleiner 1E16 cm⁻³) an, der in Fig. 11c als punktierte Kurve dargestellt ist. Die rückseitige Basiszone 6 weist ebenso wie die vorderseitige Basiszone 8 (siehe Fig. 11a) noch einen Richtung Innenzone 7 vorgelagerten, beispielsweise mit Aluminium Al schwachdotierten p-Bereich der Basiszone 6 mit einer Konzentration um etwa 1E15 cm⁻³ bis in eine Eindringtiefe x von etwa 100 µm auf, wie in Fig. 11c anhand einer gestrichelten Kurve dargestellt ist. Dieser Al-dotierte p-Bereich der Basiszone 6 ist jedoch nicht zwingend erforderlich. An diesen Bereich der Basiszone 6 schließt sich, wie in Fig. 11b dargestellt, erneut die schwach n⁻-dotierte Innenzone 7 an.

Besonders bevorzugt ist es, die vorder- und/oder rückseitigen Basiszonen 8 bzw. 6 im Bereich der in Fig. 10 angegebenen Konzentrationsverlaufslinien Na und Nc mit einer Eindringtiefe bzw. Dicke von wenigstens 50 µm vorzusehen, beispielsweise etwa 100 µm, wie dies auch in den Fig. 11a und 11c zu erkennen ist.

Wie bereits vorstehend zur Beschreibung der Fig. 10 erwähnt, ist die einstellbare Durchbruchspannung der Durchbruchstruktur 57 in Sperrrichtung bestimmt durch die zusätzlich eingebrachte Menge an Donatoratomen, die die in Fig. 10 gezeigte n⁺⁺-Durchbruchstruktur 57 bildet. Je größer diese Konzentration, umso geringer die Durchbruchspannung. Auch die Höhe der Konzentration des p⁺⁺-Bereichs der p-dotierten rückseitigen Basiszone 6 am Übergang zur n⁺⁺-Durchbruchstruktur 57 sowie der Verlauf der Konzentration des p⁺⁺-Profils der Basiszone 6 am Übergang zur n⁺⁺-Durchbruchstruktur 57 (siehe Fig. 11b) bestimmen die Durchbruchspannung: je flacher der Gradient des Konzentrationsverlaufes am Übergang vom p⁺⁺-Bereich der Basiszone 6 zum n⁺⁺-Bereich der Durchbruchstruktur 57, desto größer die Sperrfähigkeit bei sonst gleichen Verhältnissen. So kann zum Beispiel nach dem Eindiffundieren des flachen, hochdotierten p⁺⁺-Bereichs der Basiszone 6 die Sperrfähigkeit der Durchbruchstruktur 57 durch die Eintreibzeit des p⁺⁺-Bereichs eingestellt werden, denn mit zunehmender Eintreibzeit wird der Konzentrationsgradient am Übergang vom p⁺⁺-Bereich der Basiszone 6 zum n⁺⁺-Bereich der Durchbruchstruktur 57 flacher, was die Durchbruchspannung erhöht. Für sehr kleine Durchbruchspannungen der Durchbruchstruktur 57 muss man also ein sehr flaches (geringe Eindringtiefe x) und sehr hochdotiertes p⁺⁺-Profil der Basiszone 6 herstellen. Beispielsweise ergibt sich auf diese Weise für eine angenommene Durchbruchspannung von etwa 30 V eine mittlere Konzentration des n⁺⁺-Bereichs der Durchbruchstruktur 57 von ca. 5E16 cm⁻³.

Die Sperrfähigkeit der Durchbruchstruktur 57 ist über einen weiten Bereich einstellbar. Allerdings kommt sie an ihre Grenze, wenn die Konzentration sehr klein wird und in die Nähe der Konzentration der schwach n⁻-dotierten Innenzone 7 kommt, die beispielsweise für hochsperrende Halbleiterbauelemente eine Konzentration N kleiner 1E14 cm⁻³ aufweisen kann. Die Durchbruchspannung der Durchbruchstruktur 57 lässt sich hingegen sehr gut einstellen, wenn sich ihre Sperrfähigkeit sehr deutlich von der maximal möglichen Sperrfähigkeit des Kurzschluss-Halbleiterbauelements 56, die durch die Siliziumdicke Wₙ und die Konzentration N der schwachdotierten Innenzone 7 vorgegeben ist, unterscheidet, wenn diese also zum Beispiel kleiner 100 V beträgt, wobei die geforderte Sperrfähigkeit des Kurzschluss-Halbleiterbauelements 56 dann deutlich über 1000 V liegt, wenn also das Verhältnis von maximal möglicher Sperrfähigkeit des Kurzschluss-Halbleiterbauelements 56 zur eingestellten Sperrfähigkeit der Durchbruchstruktur 57 in einem Bereich von etwa 50 bis etwa 100 liegt.

Die in Fig. 10 beschriebene Durchbruchstruktur 57 kann in derselben Weise wie die anderen hierin beschriebenen Durchbruchstrukturen als Einschaltstruktur und/oder Zündstruktur im erfindungsgemäßen Kurzschluss-Halbleiterbauelement verwendet werden. Die Einschalt- bzw. Durchbruchstruktur 57 des Kurzschluss-Halbleiterbauelements 56 kann als umfänglich geschlossene Ring- und/oder Polygonstruktur ausgebildet sein.

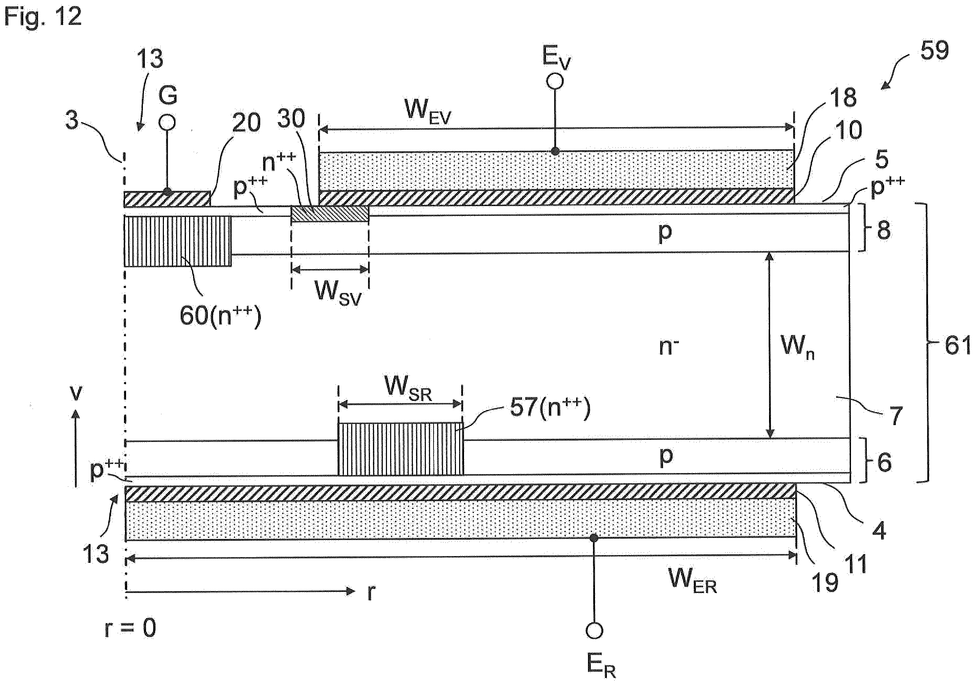

Fig. 12 stellt einen Vertikalschnitt durch ein weiteres Ausführungsbeispiel eines Kurzschluss-Halbleiterbauelements 59 gemäß der Erfindung mit zwei Einschaltstrukturen 30 und 57 und zwei Zündstrukturen 20 und 60 dar. In einem Halbleiterkörper 61 ist zusätzlich zur in Fig. 10 gezeigten Ausgestaltung des Kurzschluss-Halbleiterbauelements 56 die vorderseitige als Zündstruktur 60 ausgebildete Durchbruchstruktur in vertikaler Richtung v unterhalb der als Gate-Elektrode 20 ausgebildeten vorderseitigen Zündstruktur 20 angeordnet. Die Zündstruktur 60 weist strukturell denselben Aufbau auf wie die rückseitige Einschaltstruktur 57, wie Fig. 12 zu entnehmen ist. Zur Einbettung der Durchbruchstruktur 60 in die vorderseitige Basiszone 8 ist diese wie die rückseitige Basiszone 6 in einen der Vorderseite 5 zugewandten, hochdotierten, flachen p⁺⁺-Bereich und den der Innenzone 7 zugewandten gewöhnlichen p-Bereich aufgeteilt, so dass der p⁺⁺-Bereich in vertikaler Richtung v zwischen der Gate-Elektrode 20 und dem n⁺⁺-Bereich der Durchbruchstruktur 60 angeordnet ist. Die vorderseitige Emitterstruktur 30 ist an die Vorderseite 5 angrenzend in die vorderseitige Basiszone 8 eingebettet und von der vorderseitigen Elektrode 10 elektrisch leitend kontaktiert.

Die vorderseitige Einschaltstruktur 30 kann bei dem in Fig. 12 gezeigten Kurzschluss-Halbleiterbauelement 59 demnach sowohl durch ein dem Gate-Anschluss G extern zugeführtes elektrischen Einschaltsignal eingeschaltet werden, aber zusätzlich auch durch die Zündstruktur 60, wenn die an ihr anliegende, durch die an den Hauptelektroden 10 und 11 anliegende elektrische Spannung vorgegebene Blockierspannung die für die Durchbruchstruktur 60 festgelegte Durchbruchspannung überschreitet. In diesem Fall steigt der Durchbruchstrom an der Durchbruchstruktur 60 soweit an, bis dieser die in derselben Basiszone 8 eingebettete Einschaltstruktur 30 einschaltet, was letztendlich zur gewünschten Durchlegierung des Kurzschluss-Halbleiterbauelements 59 führt.

Bei dem in Fig. 12 gezeigten Fall der Kombination der beiden an bzw. in derselben Basiszone (hier vorderseitige Basiszone 8) angeordneten Zündstrukturen 20 und 60 ist zu verstehen, dass die Zünd- bzw. Eischaltempfindlichkeit der diesen beiden Zündstrukturen 20 und 60 zugeordneten und nachgeschalteten Einschaltstruktur (hier Emitterstruktur 30) an den von den Zündstrukturen 20 bzw. 60 zur Verfügung stellbaren Einschaltstrom angepasst ist, wobei der von einer Zündstruktur kleinste zur Verfügung stellbare Einschaltstrom ausschlaggebend ist. Mit anderen Worten ist die Einschaltstruktur 30 bei dem in Fig. 12 dargestellten Beispiel auf einen minimalen Einschaltstrom, ab dem die Einschaltstruktur 30 sicher einschaltet, aufgrund des Vorhandenseins der als Durchbruchstruktur 60 ausgebildeten Zündstruktur, die typischerweise Einschaltströme lediglich im mA-Bereich liefert, im Bereich von deutlich unter 1 A, bevorzugt etwa um 50 mA, ausgelegt, damit der von der Durchbruchstruktur 60 im Durchbruchfall erzeugte Sperrstrom die Einschaltstruktur 30 sicher einschalten kann, ohne hierbei selbst zerstört zu werden. Dies könnte nämlich passieren, wenn die Zünd- bzw. Einschaltempfindlichkeit der Einschaltstruktur 30 zu hoch gewählt würde. Dann ließe sich die Emitterstruktur 30 zwar durch ein externes, über die Gate-Elektrode 20 zugeführtes Einschaltsignal im Bereich von etwa 1 A zünden, aber die unter der Gate-Elektrode 20 angeordnete Durchbruchstruktur 60 würde hierbei zerstört werden, da diese bei einem über die Gate-Elektrode 20 eingeprägten Einschaltstrom von 1 A überlastet würde. Da sich die Zündstruktur 60 nicht im von der Elektrode 10 und der Kontaktscheibe 18 überdeckten Bereich des Halbleiterkörpers 61 befindet, könnte eine solche Zerstörung der Zündstruktur 60 einen Plasmaaustritt im Bereich des nicht überdeckten Zentrums 13 zur Folge haben, was jedoch durch die vorstehend beschriebene Auslegung der Einschaltstruktur 30 bzgl. ihrer Einschaltempfindlichkeit bei dem in Fig. 12 gezeigten Ausführungsbeispiel des Kurzschluss-Halbleiterbauelements 59 sicher verhindert wird.

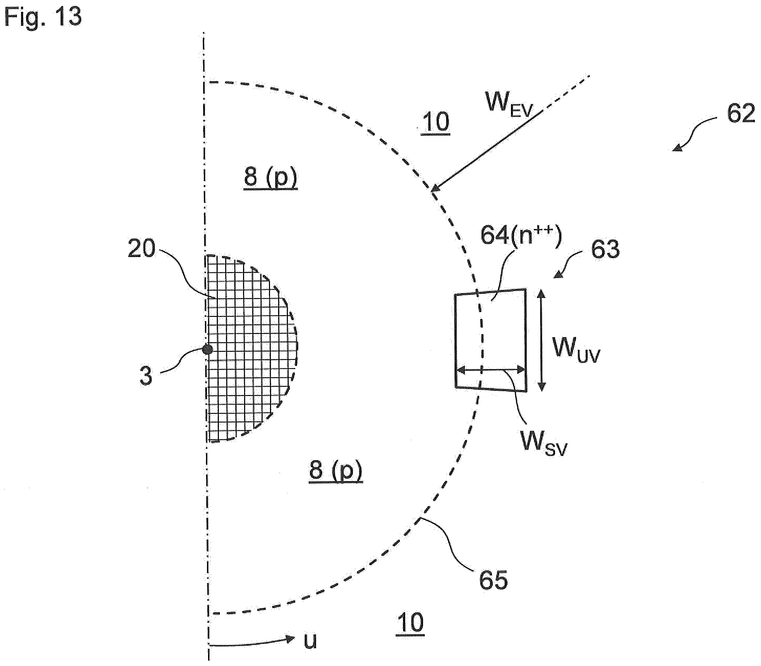

Fig. 13 stellt eine Teildraufsicht auf ein noch weiteres Ausführungsbeispiel eines Kurzschluss-Halbleiterbauelements 62 gemäß der Erfindung mit einer ein in einer Umfangsrichtung u des Halbleiterkörpers offenes Einschaltstruktursegment 64 aufweisenden Einschaltstruktur 63 und einer Zündstruktur 20 dar. In der Draufsicht der Fig. 13 ist von dem Halbleiterkörper lediglich die vorderseitige Basiszone 8 zu erkennen. In der Darstellung der Fig. 13 ist die vorderseitige Elektrode 10 nicht dargestellt, sondern lediglich ihr radialer Innenrand 65, um die unter der Elektrode 10 angeordnete, als Emitterstruktur ausgebildete Einschaltstruktur 63 erkennen zu können. Es ist in Fig. 13 zu erkennen, dass die Emitterstruktur 63 bzw. das Emitterstruktursegment 64 in diesem Ausführungsbeispiel zur Zündstruktur bzw. Gate-Elektrode 20 einen radialen Abstand aufweist. Wie weiter zu erkennen ist, ist die Einschaltstruktur 63 in diesem Fall in Umfangsrichtung u des Halbleiterkörpers nicht geschlossen, das heißt die Einschaltstruktur 63 des in Fig. 13 gezeigten Kurzschluss-Halbleiterbauelements 62 weist keine geschlossene Ring- und/oder Polygonstruktur auf. Das Einschaltstruktursegment 64 weist die laterale Emitterstrukturweite W_{SV} und eine sich in Umfangsrichtung u erstreckende umfängliche Emitterstrukturweite W_{UV} auf. Die umfängliche Emitterstrukturweite W_{UV} ist kleiner als eine umfängliche Einschaltstrukturweite, die einer geschlossenen Ring- und/oder Polygonstruktur der Einschaltstruktur und damit einem Umfangswinkel der geschlossenen ring- und/oder polygonförmigen Einschaltstruktur von 360 Grad entsprechen würde.

Bei dem in Fig. 13 dargestellten Ausführungsbeispiel des Kurzschluss-Halbleiterbauelements 62 ist der Einschaltstrom zum Einschalten der Einschaltstruktur 63 in einem Bereich um etwa 2 A, bevorzugt zwischen etwa 1 A und etwa 5 A festgelegt. W_{SV} kann nun so groß gewählt werden, damit die Einschaltstruktur 63 prozesstechnisch keine Probleme bereitet, also mit einer ausreichenden Weite W_{SV} realisiert werden kann. Wird W_{SV} zu klein gewählt, besteht das Problem, dass der radial innere Elektrodenrand 65 die hier hoch n-dotierte Emitterstruktur 64 nicht mehr sicher und nicht mehr genau genug abdeckt, wobei die umfängliche Strukturweite W_{UV} hierbei weniger kritisch ist. Mit dem in Fig. 13 gezeigten Ausführungsbeispiel lassen sich in besonders vorteilhafter Weise relativ kleine Aufschmelzströme aufgrund im Vergleich zu einer geschlossenen Ring- und/oder Polygonstruktur relativ kleiner Abmessungen W_{SV} und W_{UV} realisieren, wobei der zum Einschalten der Einschaltstruktur 63 erforderliche Einschaltstrom eher große Werte im Bereich von vorzugsweise etwa 1 A bis etwa 5 A mit den hierin bereits beschriebenen Vorteilen annehmen kann.

Es ist zu verstehen, dass ein wie in Fig. 13 dargestelltes Kurzschluss-Halbleiterbauelement 62 auch mehr als eine Einschaltstruktur 63 aufweisen kann, die dann in Umfangsrichtung u des Halbleiterkörpers verteilt angeordnet sind, vorzugsweise mit äquidistantem Abstand zueinander, um einen umfänglich im Wesentlichen symmetrischen Aufbau eines solchen Kurzschluss-Halbleiterbauelements mit den hierein bereits beschriebenen Vorteilen zu erzielen.

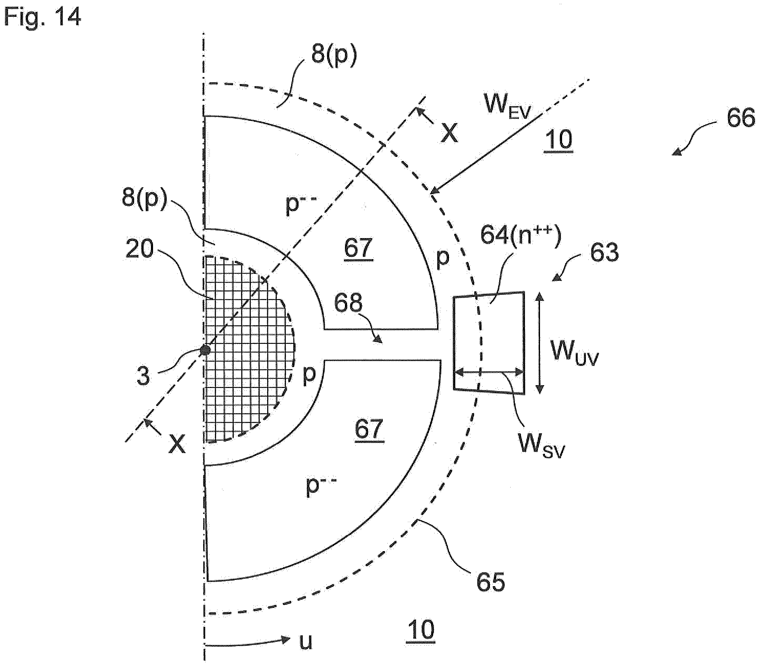

Fig. 14 stellt eine Teildraufsicht auf ein noch weiteres Ausführungsbeispiel eines Kurzschluss-Halbleiterbauelements 66 gemäß der Erfindung mit der bereits in Fig. 13 gezeigten, wenigstens ein Einschaltstruktursegment 64 aufweisenden Einschaltstruktur 63 und einer Zündstruktur 20 dar. In der Darstellung der Fig. 14 ist die vorderseitige Elektrode 10 nicht dargestellt, sondern lediglich ihr radialer Innenrand 65, um die unter der Elektrode 10 angeordnete, als Emitterstruktur ausgebildete Einschaltstruktur 63 erkennen zu können.

Wie Fig. 14 zu entnehmen ist, ist bei dem Kurzschluss-Halbleiterbauelement 66 in der p-dotierten vorderseitigen Basiszone 8, in der die Einschaltstruktur 63 eingebettet ist, ein im Vergleich zu dem gewöhnlich p-dotierten Basiszonenbereich wesentlich niedriger p-dotierter p⁻⁻-Abschnitt 67 vorgesehen, der gegenüber dem Rest der Basiszone 8 einen deutlich höheren elektrischen Widerstand darstellt. Die Dotierstoffkonzentration dieses Widerstandsabschnitts 67 beträgt bevorzugte etwa 1E15 cm⁻³ bis etwa 1E16 cm⁻³ bei einer Eindringtiefe von bevorzugt etwa 60 bis 120 µm. Dieser Widerstandsabschnitt 67 weist dem Einschaltstruktursegment 64 gegenüberliegend einen Durchlasskanal 68 auf, der von dem gewöhnlich dotierten, restlichen p-Bereich der Basiszone 8 gebildet ist und das Einschaltstruktursegment 64 unmittelbar über den p-Bereich der Basiszone 8 elektrisch an die Zündstruktur bzw. Gate-Elektrode 20 ankoppelt.

Durch die in Fig. 14 gezeigte Ausgestaltung des Kurzschluss-Halbleiterbauelements 66 wird erreicht, dass einerseits sehr kleine zur Durchlegierung führende Aufschmelzströme durch die segmentartige Ausbildung der Einschaltstruktur 63 realisiert werden können, wie beispielsweise auch bei dem in Fig. 13 gezeigten Kurzschluss-Halbleiterbauelement 62, und andererseits der von der Zündstruktur 20 zur Einschaltstruktur 63 fließende Einschaltstrom gezielt auf das Einschaltstruktursegment 64 gelenkt wird, um dieses im Bedarfsfall zum Einleiten der Durchlegierung sicher einzuschalten. Hierdurch ist die gezielte Auslegung des Kurzschluss-Halbleiterbauelements 66 mit Einschaltströmen möglich, die, anders als bei dem in Fig. 13 gezeigte Kurzschluss-Halbleiterbauelement 62, im mA-Bereich liegen, zum Beispiel bei etwa 150 mA.

Der Kanal 68 kann übrigens unterschiedliche Formen annehmen, zum Beispiel auch eine Trapezform, bei der sich der Kanal 68 ausgehend von der Zündstruktur 20 hin zum Einschaltstruktursegment 64 verjüngt, um eine noch gezieltere Lenkung des durch diesen Kanal 68 fließenden Einschaltstroms auf das Einschaltstruktursegment 64 zu erreichen und damit den am Einschaltstruktursegment 64 vorbeifließenden Einschaltstrom so gering wie möglich zu halten.

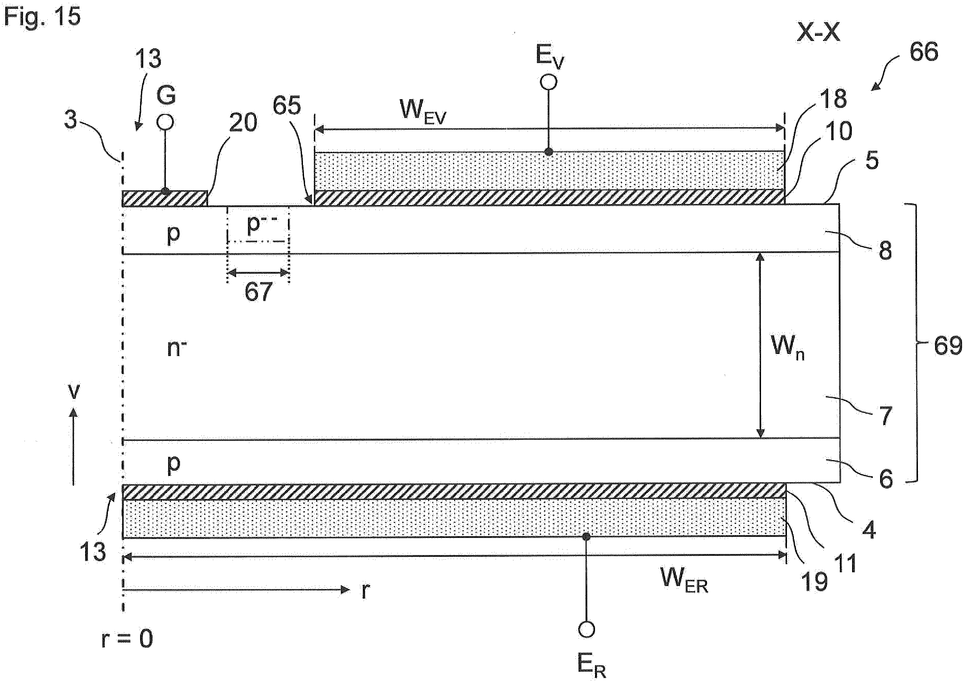

Fig. 15 zeigt einen Vertikalschnitt durch das in Fig. 14 dargestellte Kurzschluss-Halbleiterbauelement 66 entlang der in Fig. 14 dargestellten Schnittlinie X-X. Es ist zu erkennen, dass sich in einem Halbleiterkörper 69, insbesondere in der vorderseitigen p-dotierten Basiszone 8, der p⁻⁻-Widerstandsabschnitt 67 lateral zwischen der Zündstruktur bzw. Gate-Elektrode 20 und dem Innenrand 65 der vorderseitigen Elektrode 10 erstreckt. Das Einschaltstruktursegment 64 ist in dem Vertikalschnitt X-X nicht zu erkennen.

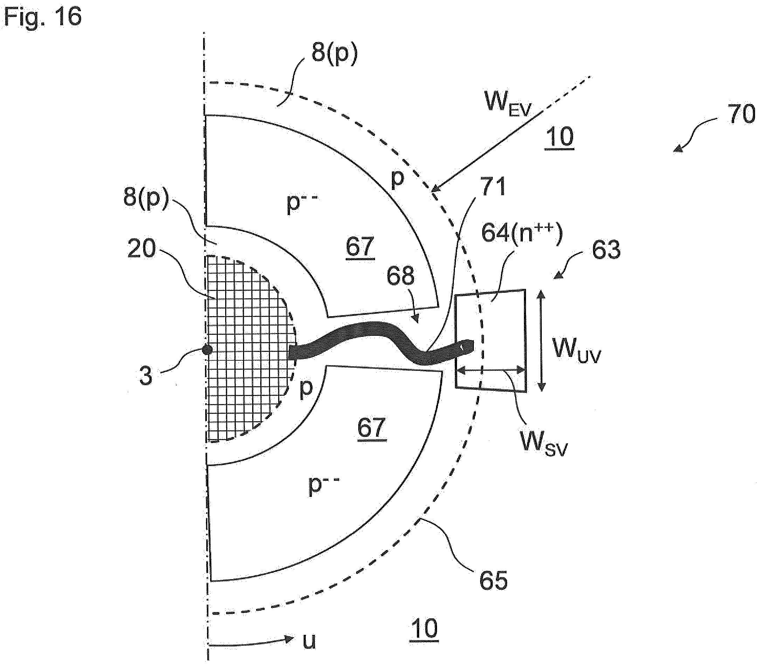

Fig. 16 stellt eine Teildraufsicht auf ein noch weiteres Ausführungsbeispiel eines Kurzschluss-Halbleiterbauelements 70 gemäß der Erfindung dar, das im Wesentlichen dem Ausführungsbeispiel des in Fig. 14 gezeigten Kurzschluss-Halbleiterbauelements 66 entspricht, wobei das Einschaltstruktursegment 64 des Kurzschluss-Halbleiterbauelements 70 in Fig. 16 über einen Shuntwiderstand 71 in Form eines im Kanal 68 angeordneten n-dotierten (z. B. mit Phosphor dotierten) Gebietsstreifens elektrisch direkt mit der Zündstruktur bzw. Gate-Elektrode 20 verbunden ist. Die Breite dieses Shuntwiderstands 71 kann vorzugsweise auf etwa 55 µm festgelegt sein. Auf diese Weise lässt sich der erforderliche Einschaltstrom zum Einschalten der Einschaltstruktur 63 gegenüber dem Kurzschluss-Halbleiterbauelement 66 der Fig. 14 wieder etwas anheben, zum Beispiel auf etwa 400 mA und bevorzugt in einen Bereich von etwa 400 mA bis etwa 1000 mA, bei ansonsten gleichen Abmessungen.

Die in Fig. 16 dargestellte Schlangenform des Shuntwiderstands 71 erlaubt es, eine Länge des Shuntwiderstands 71 in gewünschter Weise zu variieren, um hierdurch den Einschaltstrom in dem vorstehend genannten Bereich nahezu beliebig einzustellen. Die Länge des in Fig. 16 dargestellten schlangenförmigen Shuntwiderstands 71 innerhalb des Kanals 68 kann zum Beispiel auf einen Wert aus einem Bereich um etwa 200 µm, also zum Beispiel etwa 150 µm bis etwa 250 µm, festgelegt werden.

Der Shuntwiderstand 71 ist mit seinem radial inneren Ende elektrisch direkt mit der Gate-Elektrode 20 kontaktiert. Bei dem in Fig. 16 gezeigten Kurzschluss-Halbleiterbauelement 70 mündet das gegenüberliegende, radial äußere Ende des Shuntwiderstands 71 direkt in das Emitterstruktursegment 64.

Der Shuntwiderstand 71 könnte anstelle der in Fig. 16 gezeigten Anordnung im Durchlasskanal 68 auch über den Widerstandsabschnitt 67 gelegt sein. In diesem Fall wäre das radial äußere Ende des Shuntwiderstands 71 elektrisch direkt mit der vorderseitigen Elektrode 10, zum Beispiel am Elektrodenrand 65, kontaktiert.

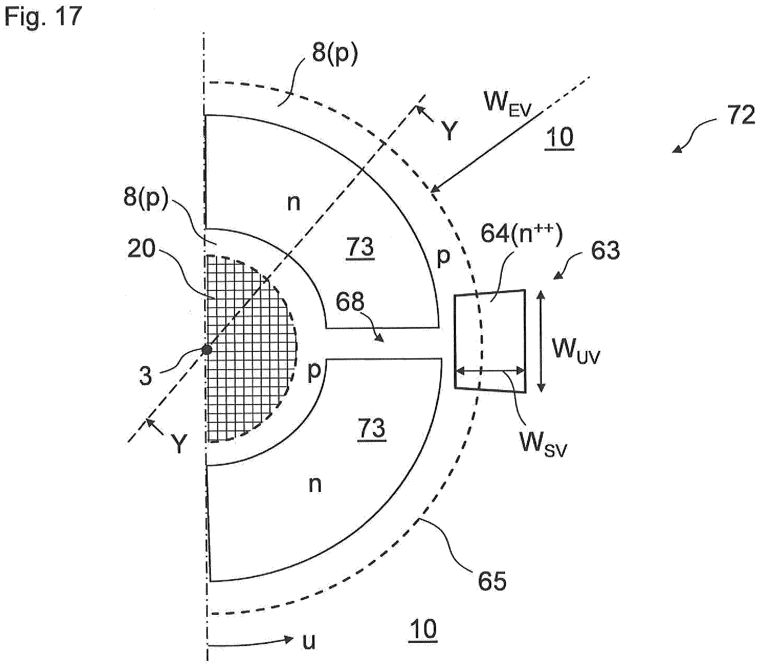

Fig. 17 stellt eine Teildraufsicht auf ein noch weiteres Ausführungsbeispiel eines Kurzschluss-Halbleiterbauelements 72 gemäß der Erfindung mit einer ein in einer Umfangsrichtung u des Halbleiterkörpers offenes Einschaltstruktursegment 64 aufweisenden Einschaltstruktur 63 und einer Zündstruktur 20 dar. Die Darstellung der Fig. 17 entspricht im Wesentlichen der Darstellung der Fig. 14 mit der Ausnahme, dass bei dem in Fig. 17 dargestellten Kurzschluss-Halbleiterbauelement 72 in die p-dotierte vorderseitige Basiszone 8 ein n-dotierter Widerstandsabschnitt 73 eingebracht ist, der auch als Pinch-Widerstand 73 bezeichnet wird.

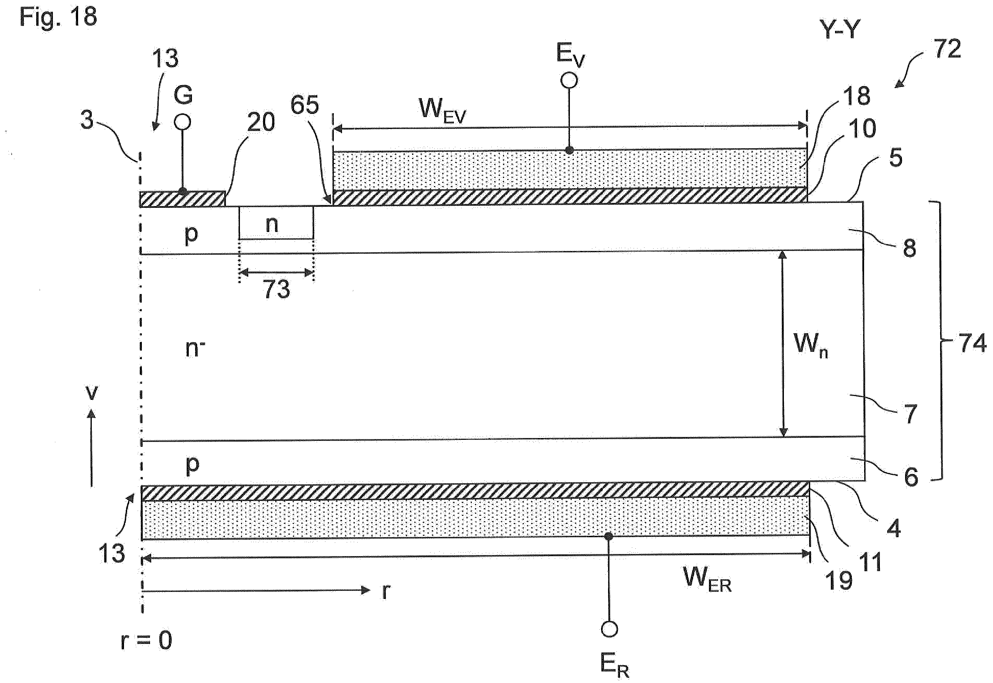

Fig. 18 zeigt einen Vertikalschnitt durch das in Fig. 17 dargestellte Kurzschluss-Halbleiterbauelement 72 entlang der in Fig. 17 dargestellten Schnittlinie Y-Y. In dieser Ansicht ist zu erkennen, dass der Widerstandsabschnitt 73 durch einen Pinch-Widerstand gebildet ist, der als in einem Halbleiterkörper 74 und speziell in der vorderseitigen Basiszone 8 von der Vorderseite 5 und an diese angrenzend eingebrachtes n-Gebiet den wirksamen Leitungsquerschnitt der vorderseitigen Basiszone 8 zwischen der Zündstruktur 20 und der vorderseitigen Elektrode 10 deutlich verringert, wodurch der Pinch-Widerstand 73 eine Erhöhung des flächenspezifischen Widerstands in diesem Bereich der Basiszone 8 bewirkt. Die Auswirkungen dieser Widerstandserhöhung sind bereits vorstehend zu den Fig. 14 bis 16 beschrieben worden.

Es ist zu verstehen, dass die im Zusammenhang mit den Fig. 13 bis 18 beschrienen Ausgestaltungen der Einschaltstruktur 63 mit einzelnen Einschaltstruktursegmenten 64 in Kombination mit der lokalen Widerstandserhöhung in der Basiszone 8 zwischen der Zündstruktur 20 und dem Einschaltstruktursegment 64 mit allen anderen hierin beschriebenen Einschaltstrukturen und/oder Zündstrukturen beliebig kombinierbar sind und damit weitere, in den Figuren nicht dargestellte vorteilhafte Ausgestaltungen der Erfindung beinhalten. So können beispielsweise auch zwei radial zueinander beabstandete, elektrisch voneinander isolierte Einschaltstrukturen vorgesehen sein, zum Beispiel wenigstens ein wie in den Fig. 13 bis 18 gezeigtes Einschaltstruktursegment 63, das von einer radial weiter außen angeordneten, ring- und/oder polygonförmig geschlossenen, verringerten Einschaltstruktur, beispielsweise ähnlich der in Fig. 3 gezeigten, umgeben ist. Hierdurch lässt sich in vorteilhafter Weise der nach dem Einschalten des Kurzschluss-Halbleiterbauelements entstehende durchlegierte Bereich innerhalb des von der vorder- und/oder rückseitigen Elektrode überdeckten Bereichs des Halbleiterkörpers in radialer Richtung mit den hierin bereits beschriebenen Vorteilen aufweiten.

Das vorstehend beschriebene erfindungsgemäße Kurzschluss-Halbleiterbauelement ist nicht auf die hierin offenbarten Ausführungsformen beschränkt, sondern umfasst auch gleich wirkende weitere Ausführungsformen, die sich aus technisch sinnvollen weiteren Kombinationen der hierin beschriebenen Merkmale des Kurzschluss-Halbleiterbauelements ergeben. Insbesondere ist auch eine zur in den Ausführungsbeispielen gezeigten pnp-Struktur des Halbleiterkörpers inverse npn-Schichtenfolge denkbar. In diesem Fall besteht die schwach n-dotierte Halbleiterinnenzone aus einer schwach p-dotierten Innenzone und die vorder- und rückseitigen Basiszonen jeweils aus einer n-dotierten Schicht usw. Die Leitungstypen der hierin beschriebenen Einschaltstrukturen wären in einem solchen Fall ebenfalls entsprechend zu invertieren.

In bevorzugter Ausführung wird das erfindungsgemäße Kurzschluss-Halbleiterbauelement als Berührschutz bzw. Personenschutz sowie zum Anlagenschutz verwendet.

### Bezugszeichenliste:

- 1: Thyristor nach Stand der Technik
- 2: Halbleiterkörper
- 3: Mittelachse
- 4: Rückseite
- 5: Vorderseite
- 6: Rückseitige Basiszone
- 7: Innenzone
- 8: Vorderseitige Basiszone
- 9: Vorderseitiger Emitter
- 10: Vorderseitige Elektrode
- 11: Rückseitige Elektrode
- 12: Kurzschluss
- 13: Vorder- und rückseitiges Zentrum
- 14: Gate-Elektrode
- 15: Kurzschluss-Halbleiterbauelement
- 16: Halbleiterkörper
- 17: Vorderseitige Einschaltstruktur / Emitterstruktur
- 18: Vorderseitige Kontaktscheibe
- 19: Rückseitige Kontaktscheibe
- 20: Zündstruktur, Gate-Elektrode
- 21: Durchlegierung
- 22: Kurzschluss-Halbleiterbauelement
- 23: Verfingerte Einschaltstruktur / Emitterstruktur
- 24: Vorderseitige Elektrode
- 25: Halbleiterkörper
- 26: Zündstruktur, Gate-Elektrode
- 27: Zündstrukturfinger / Gate-Finger
- 28: Einschaltstrukturfinger von 23
- 29: Kurzschluss-Halbleiterbauelement
- 30: Vorderseitige Einschaltstruktur / Emitterstruktur
- 31: Rückseitige Einschaltstruktur / Durchbruchstruktur
- 32: Halbleiterkörper
- 33: Kritischer Krümmungsradius
- 34: Kurzschluss-Halbleiterbauelement
- 35: Vorderseitige Einschaltstruktur / Emitterstruktur
- 36: Rückseitige Einschaltstruktur / Emitterstruktur
- 37: Vorderseitige Zündstruktur / Gate-Elektrode
- 38: Rückseitige Zündstruktur / Gate-Elektrode
- 39: Halbleiterkörper
- 40: Kurzschluss-Halbleiterbauelement
- 41: Vorderseitige Einschaltstruktur / Emitterstruktur
- 42: Vorderseitige Zündstruktur / lichtempfindlicher Bereich / optisches Gate
- 43: Halbleiterkörper
- 44: Optisches Signal
- 45: Kurzschluss-Halbleiterbauelement
- 46: Rückseitige Einschaltstruktur / Emitterstruktur
- 47: Rückseitige Zündstruktur / Durchbruchstruktur
- 48: Halbleiterkörper
- 49: Kurzschluss-Halbleiterbauelement
- 50: Vorderseitige Einschaltstruktur / Durchbruchstruktur
- 51: Halbleiterkörper
- 52: Kurzschluss-Halbleiterbauelement
- 53: Vorderseitige Einschaltstruktur / Emitterstruktur
- 54: Vorderseitige Zündstruktur / Durchbruchstruktur
- 55: Halbleiterkörper
- 56: Kurzschluss-Halbleiterbauelement
- 57: Rückseitige Einschaltstruktur / Durchbruchstruktur
- 58: Halbleiterkörper
- 59: Kurzschluss-Halbleiterbauelement
- 60: Vorderseitige Zündstruktur / Durchbruchstruktur
- 61: Halbleiterkörper
- 62: Kurzschluss-Halbleiterbauelement
- 63: Vorderseitige Einschaltstruktur / Emitterstruktur
- 64: Einschaltstruktursegment / Emitterstruktursegment
- 65: Radialer Innenrand
- 66: Kurzschluss-Halbleiterbauelement
- 67: Widerstandsabschnitt
- 68: Durchlasskanal
- 69: Halbleiterkörper
- 70: Kurzschluss-Halbleiterbauelement
- 71: Shunt-Widerstand
- 72: Kurzschluss-Halbleiterbauelement
- 73: Widerstandsabschnitt / Pinch-Widerstand
- 74: Halbleiterkörper
- A: Anodenanschluss
- Al: Aluminium
- AG: Amplifying Gate
- Dₐ: Außendurchmesser einer BOD-Struktur
- D_{a*}: Außendurchmesser einer BOD-Struktur
- Dᵢ: Innendurchmesser einer BOD-Struktur
- D_{i*}: Innendurchmesser einer BOD-Struktur
- E_{V}: Vorderseitiger Elektrodenanschluss
- E_{R}: Rückseitiger Elektrodenanschluss
- G: Gate-Anschluss
- G_{V}: Vorderseitiger Gate-Anschluss
- G_{R}: Rückseitiger Gate-Anschluss
- K: Kathodenanschluss
- L_{SF}: Radiale Fingerlänge der Einschaltstruktur
- N: Dotierstoffkonzentration
- Na: Konzentrationsverlaufslinie (a)
- Nb: Konzentrationsverlaufslinie (b)
- Nc: Konzentrationsverlaufslinie (c)
- r: Radiale/laterale Richtung
- R: Begrenzungswiderstand
- u: Umfangsrichtung
- v: Vertikale Richtung
- x: Eindringtiefe
- W_{E1}: Laterale Elektrodenweite nach Stand der Technik
- W_{ER}: Laterale rückseitige Elektrodenweite
- W_{EV}: Laterale vorderseitige Elektrodenweite
- Wₙ: Dicke der Innenzone
- Wₙ₁: Dicke der Innenzone nach Stand der Technik
- W_{S1}: Laterale Emitterweite nach Stand der Technik
- W_{SR}: Laterale rückseitige Einschaltstrukturweite
- W_{SV}: Laterale vorderseitige Einschaltstrukturweite
- W_{UV}: Umfängliche vorderseitige Einschaltstrukturweite
- X-X: Schnittlinie Vertikalschnitt
- Y-Y: Schnittlinie Vertikalschnitt

## Patentansprüche

1. Kurzschluss-Halbleiterbauelement aufweisend einen Halbleiterkörper (16, 25, 32, 39, 43, 48, 51, 55, 58, 61, 69, 74), in dem in einer vertikalen Richtung (v) ausgehend von einer Rückseite (4) mit einem durch ihren geometrischen Schwerpunkt festgelegten rückseitigen Zentrum (13) hin zu einer der Rückseite (4) gegenüberliegenden Vorderseite (5) mit einem durch ihren geometrischen Schwerpunkt festgelegten vorderseitigen Zentrum (13) eine rückseitige Basiszone (6) von einem ersten Leitungstyp (p), eine Innenzone (7) von einem zum ersten Leitungstyp (p) komplementären zweiten Leitungstyp (n) und eine vorderseitige Basiszone (8) vom ersten Leitungstyp (p) aufeinanderfolgend angeordnet sind, wobei die rückseitige Basiszone (6) mit einer auf der Rückseite (4) aufgebrachten rückseitigen Elektrode (11) mit einer durch ihre laterale Erstreckung gegebenen lateralen rückseitigen Elektrodenweite (W_{ER}) elektrisch leitend verbunden ist und die vorderseitige Basiszone (8) mit einer auf der Vorderseite (5) aufgebrachten vorderseitigen Elektrode (10) mit einer durch ihre laterale Erstreckung gegebenen lateralen vorderseitigen Elektrodenweite (W_{EV}) elektrisch leitend verbunden ist, wobei in die vorderseitige Basiszone (8) wenigstens eine vorderseitige Einschaltstruktur (17, 23, 30, 35, 41, 50, 53, 63) mit einer durch ihre laterale Erstreckung gegebenen lateralen vorderseitigen Einschaltstrukturweite (W_{SV}) eingebettet und von der vorderseitigen Elektrode (10) wenigstens teilweise überdeckt ist und/oder in die rückseitige Basiszone (6) wenigstens eine rückseitige Einschaltstruktur (31, 36, 46, 57) mit einer durch ihre laterale Erstreckung gegebenen lateralen rückseitigen Einschaltstrukturweite (W_{SR}) eingebettet und von der rückseitigen Elektrode (11) wenigstens teilweise überdeckt ist, wobei die Einschaltstruktur (17, 23, 30, 31, 35, 36, 41, 46, 50, 53, 57, 63) derart ausgebildet und angeordnet ist, dass sie in Abhängigkeit von einem dem Halbleiterkörper (16, 25, 32, 39, 43, 48, 51, 55, 58, 61, 69, 74) zugeführten, vorherbestimmbaren Einschaltsignal einschaltet und einmalig eine dauerhafte, irreversible, elektrisch leitende, niederohmige Verbindung zwischen der vorderseitigen Elektrode (10) und der rückseitigen Elektrode (11) herstellt, indem bei Vorhandensein der vorderseitigen Einschaltstruktur (17, 23, 30, 35, 41, 50, 53, 63) das Verhältnis der lateralen vorderseitigen Einschaltstrukturweite (W_{SV}) zur lateralen vorderseitigen Elektrodenweite (W_{EV}) kleiner 1 ist und bei Vorhandensein der rückseitigen Einschaltstruktur (31, 36, 46, 57) das Verhältnis der lateralen rückseitigen Einschaltstrukturweite (W_{SR}) zur lateralen rückseitigen Elektrodenweite (W_{ER}) kleiner 1 ist, wobei die Einschaltstruktur eine in die vorderseitige oder rückseitige Basiszone (6, 8) eingebettete, mit der auf der jeweiligen Basiszone (6, 8) aufgebrachten Elektrode (10, 11) elektrisch leitend kontaktierte Emitterstruktur (17, 23, 30, 35, 36, 41, 46, 53, 63) vom zweiten Leitungstyp (n) ist, die mittels wenigstens einer auf diese elektrisch über den Halbleiterkörper (16, 25, 32, 39, 43, 48, 51, 55, 58, 61, 69, 74) einwirkende Zündstruktur (20, 26, 37, 38, 42, 47, 54, 60) einschaltbar ist, wobei die Zündstruktur (20, 26, 37, 38, 42, 47, 54, 60) wiederum mittels des Einschaltsignals aktivierbar ist,
**dadurch gekennzeichnet, dass**
ein spezifischer Flächenwiderstand der die Emitterstruktur (17, 23, 30, 35, 36, 41, 46, 53, 63) enthaltenden Basiszone (6, 8) so eingestellt ist, dass ein aus dem Einschaltsignal gewonnener, der Emitterstruktur (17, 23, 30, 35, 36, 41, 46, 53, 63) zugeführter minimaler Einschaltstrom eine Stromstärke von wenigstens A zum Einschalten der Emitterstruktur (17, 23, 30, 35, 36, 41, 46, 53, 63) aufweist.

2. Kurzschluss-Halbleiterbauelement nach Anspruch 1,
**dadurch gekennzeichnet, dass**
das Verhältnis der lateralen Einschaltstrukturweite (W_{SV}, W_{SR}) zur entsprechenden lateralen Elektrodenweite (W_{EV}, W_{ER}) der jeweiligen Elektrode (10, 11) kleiner als 4/5 gewählt ist, bevorzugt kleiner als 3/4, bevorzugter kleiner als 2/3 und noch bevorzugter kleiner als 1/2.

3. Kurzschluss-Halbleiterbauelement nach Anspruch 1 oder 2,
**dadurch gekennzeichnet, dass**
die Einschaltstruktur (31, 46, 50, 53, 57) vollständig von der vorderseitigen Elektrode (10) und der rückseitigen Elektrode (11) überdeckt ist.

4. Kurzschluss-Halbleiterbauelement nach einem der vorhergehenden Ansprüche,
**dadurch gekennzeichnet, dass**
die vorderseitige Elektrode (10) und die rückseitige Elektrode (11) das vorderseitige beziehungsweise rückseitige Zentrum (13) des Halbleiterkörpers (16, 25, 32, 39, 43, 48, 51, 55, 58, 61, 69, 74) überdecken und die Einschaltstruktur (17, 23, 30, 31, 35, 36, 41, 46, 50, 53, 57, 63) in dem entsprechenden Zentrum (13) angeordnet ist.

5. Kurzschluss-Halbleiterbauelement nach einem der vorhergehenden Ansprüche,
**dadurch gekennzeichnet, dass**
die Zündstruktur eine Gate-Elektrode (20, 26, 37, 38) ist und das Einschaltsignal ein der Gate-Elektrode (20, 26, 37, 38) zugeführtes elektrisches Signal ist.

6. Kurzschluss-Halbleiterbauelement nach einem der Ansprüche 1 bis 4,
**dadurch gekennzeichnet, dass**
die Zündstruktur ein in der die Emitterstruktur (17, 23, 30, 35, 36, 41, 46, 53, 63) enthaltenden Basiszone (6, 8) angeordneter lichtempfindlicher Bereich (42) ist und das Einschaltsignal ein diesem lichtempfindlichen Bereich (42) zugeführtes optisches Signal (44) ist.

7. Kurzschluss-Halbleiterbauelement nach einem der Ansprüche 1 bis 4,
**dadurch gekennzeichnet, dass**
die Zündstruktur eine Durchbruchstruktur (47, 54, 60) ist und das Einschaltsignal die zwischen der vorderseitigen Elektrode (10) und der rückseitigen Elektrode (11) anliegende elektrische Spannung ist.

8. Kurzschluss-Halbleiterbauelement nach einem der vorhergehenden Ansprüche,
**dadurch gekennzeichnet, dass**
in der die Emitterstruktur (17, 23, 30, 35, 36, 41, 46, 53, 63) enthaltenden Basiszone (6, 8) zwischen der Zündstruktur (20, 26, 37, 38, 42, 47, 54, 60) und der mit dieser elektrisch wirkverbundenen Emitterstruktur (17, 23, 30, 35, 36, 41, 46, 53, 63) eine Amplifying-Gate-Struktur mit wenigstens einem Amplifying-Gate (AG) angeordnet ist.

9. Kurzschluss-Halbleiterbauelement nach einem der vorhergehenden Ansprüche,
**dadurch gekennzeichnet, dass**
die Einschaltstruktur (17, 23, 30, 35, 36, 41, 46, 53, 63) in radialer Richtung (r) von der Zündstruktur (20, 26, 37, 38, 42, 60) beabstandet ist und wenigstens ein in einer Umfangsrichtung (u) des Halbleiterkörpers (16, 25, 32, 39, 43, 48, 51, 55, 58, 61, 69, 74) offenes Einschaltstruktursegment (64) mit einer umfänglichen Einschaltstrukturweite (W_{UV}) aufweist.

10. Kurzschluss-Halbleiterbauelement nach dem vorhergehenden Anspruch,
**dadurch gekennzeichnet, dass**
in Umfangsrichtung (u) des Halbleiterkörpers (16, 25, 32, 39, 43, 48, 51, 55, 58, 61, 69, 74) wenigstens zwei voneinander getrennte Einschaltstruktursegmente (64) vorgesehen sind.

11. Kurzschluss-Halbleiterbauelement nach einem der beiden vorhergehenden Ansprüche,
**dadurch gekennzeichnet, dass**
der elektrische Widerstand in der die Einschaltstruktur (17, 23, 30, 35, 36, 41, 46, 53, 63) enthaltenden Basiszone (6, 8) wenigstens in einem Abschnitt (67, 73) des radialen Zwischenraums zwischen der Einschaltstruktur (17, 23, 30, 35, 36, 41, 46, 53, 63) und der Zündstruktur (20, 26, 37, 38, 42, 60) mit Ausnahme wenigstens eines das wenigstens eine der Einschaltstruktursegmente (64) mit der Zündstruktur (20, 26, 37, 38, 42, 60) elektrisch koppelnden Durchgangskanals (67) erhöht ist.

12. Kurzschluss-Halbleiterbauelement nach einem der vorhergehenden Ansprüche,
**dadurch gekennzeichnet, dass**
die Einschaltstruktur (17, 23, 30, 31, 35, 36, 41, 46, 50, 53, 57, 63) wenigstens einen sich vom Rest der Einschaltstruktur (17, 23, 30, 31, 35, 36, 41, 46, 50, 53, 57, 63) in lateraler Richtung (r) radial nach außen erstreckenden Einschaltstrukturfinger (28) aufweist.

13. Kurzschluss-Halbleiterbauelement nach dem vorhergehenden Anspruch,
**dadurch gekennzeichnet, dass**
die Zündstruktur (20, 26, 37, 38, 42, 47, 54, 60) wenigstens einen der Kontur des wenigstens einen Einschaltstrukturfingers (28) folgenden Zündstrukturfinger (27) aufweist.

14. Kurzschluss-Halbleiterbauelement nach einem der beiden vorhergehenden Ansprüche,
**dadurch gekennzeichnet, dass**
der wenigstens eine Einschaltstrukturfinger (28) eine maximale radiale Fingerlänge (L_{SF}) aufweist, die kleiner ist als 4/5 der lateralen Elektrodenweite (W_{EV}, W_{ER}) der Elektrode (10, 11), die auf der die Einschaltstruktur (17, 23, 30, 31, 35, 36, 41, 46, 50, 53, 57, 63) enthaltenden Basiszone (6, 8) aufgebracht ist.

15. Kurzschluss-Halbleiterbauelement nach einem der vorhergehenden Ansprüche,
**dadurch gekennzeichnet, dass**
eine Dicke (Wₙ) der Innenzone (7) in vertikaler Richtung (v) größer als 400 µm, bevorzugter größer als 600 µm, noch bevorzugter größer als 800 µm und weiter bevorzugt größer als 1000 µm ist.

16. Kurzschluss-Halbleiterbauelement nach einem der vorhergehenden Ansprüche,
**dadurch gekennzeichnet, dass**
die vorderseitige Elektrode (10) und die rückseitige Elektrode (11) jeweils mittels einer metallischen Kontaktscheibe (18, 19) elektrisch leitend druckkontaktiert sind.

17. Kurzschluss-Halbleiterbauelement nach dem vorhergehenden Anspruch,
**dadurch gekennzeichnet, dass**
die laterale Weite der jeweiligen Kontaktscheibe (18, 19) der lateralen Elektrodenweite (W_{EV}, W_{ER}) der entsprechenden druckkontaktieren Elektrode (10, 11) entspricht.

18. Verfahren zum Betreiben eines Kurzschluss-Halbleiterbauelements (15, 22, 29, 34, 40, 45, 49, 52, 56, 59, 62, 66, 70, 72), das einen Halbleiterkörper (16, 25, 32, 39, 43, 48, 51, 55, 58, 61, 69, 74) aufweist, in dem in einer vertikalen Richtung (v) ausgehend von einer Rückseite (4) mit einem durch ihren geometrischen Schwerpunkt festgelegten rückseitigen Zentrum (13) hin zu einer der Rückseite (4) gegenüberliegenden Vorderseite (5) mit einem durch ihren geometrischen Schwerpunkt festgelegten vorderseitigen Zentrum (13) eine rückseitige Basiszone (6) von einem ersten Leitungstyp (p), eine Innenzone (7) von einem zum ersten Leitungstyp (p) komplementären zweiten Leitungstyp (n) und eine vorderseitige Basiszone (8) vom ersten Leitungstyp (p) aufeinanderfolgend angeordnet sind, wobei die rückseitige Basiszone (6) mit einer auf der Rückseite (4) aufgebrachten rückseitigen Elektrode (11) mit einer durch ihre laterale Erstreckung gegebenen lateralen rückseitigen Elektrodenweite (W_{ER}) elektrisch leitend verbunden ist und die vorderseitige Basiszone (8) mit einer auf der Vorderseite (5) aufgebrachten vorderseitigen Elektrode (10) mit einer durch ihre laterale Erstreckung gegebenen lateralen vorderseitigen Elektrodenweite (W_{EV}) elektrisch leitend verbunden ist, wobei in die vorderseitige Basiszone (8) wenigstens eine vorderseitige Einschaltstruktur (17, 23, 30, 35, 41, 50, 53, 63) mit einer durch ihre laterale Erstreckung gegebenen lateralen vorderseitigen Einschaltstrukturweite (W_{SV}) eingebettet und von der vorderseitigen Elektrode (10) wenigstens teilweise überdeckt ist und/oder in die rückseitige Basiszone (6) wenigstens eine rückseitige Einschaltstruktur (31, 36, 46, 57) mit einer durch ihre laterale Erstreckung gegebenen lateralen rückseitigen Einschaltstrukturweite (W_{SR}) eingebettet und von der rückseitigen Elektrode (11) wenigstens teilweise überdeckt ist, wobei bei Vorhandensein der vorderseitigen Einschaltstruktur (17, 23, 30, 35, 41, 50, 53, 63) das Verhältnis der lateralen vorderseitigen Einschaltstrukturweite (W_{SV}) zur lateralen vorderseitigen Elektrodenweite (W_{EV}) kleiner 1 festgelegt wird und bei Vorhandensein der rückseitigen Einschaltstruktur (31, 36, 46, 57) das Verhältnis der lateralen rückseitigen Einschaltstrukturweite (W_{SR}) zur lateralen rückseitigen Elektrodenweite (W_{ER}) kleiner 1 festgelegt wird, so dass in einem nicht kurzgeschlossenen Betriebszustand eine zwischen der vorderseitigen Elektrode (10) und der rückseitigen Elektrode (11) anliegende elektrische Spannung in beiden Polaritäten langzeitstabil gesperrt wird und dem Halbleiterkörper (16, 25, 32, 39, 43, 48, 51, 55, 58, 61, 69, 74) in einer Kurzschlussbetriebsart ein vorherbestimmbares Einschaltsignal einmalig zugeführt wird, das die entsprechend ausgebildete und angeordnete Einschaltstruktur (17, 23, 30, 31, 35, 36, 41, 46, 50, 53, 57, 63) einschaltet, wodurch eine dauerhafte, irreversible, elektrisch leitende, niederohmige Verbindung zwischen der vorderseitigen Elektrode (10) und der rückseitigen Elektrode (11) infolge des durch die zwischen diesen anliegende elektrische Spannung bewirkten Stromflusses in Form einer Aufschmelzung hergestellt wird, wobei die Einschaltstruktur eine in die vorderseitige oder rückseitige Basiszone (6, 8) eingebettete, mit der auf der jeweiligen Basiszone (6, 8) aufgebrachten Elektrode (10, 11) elektrisch leitend kontaktierte Emitterstruktur (17, 23, 30, 35, 36, 41, 46, 53, 63) vom zweiten Leitungstyp (n) ist, die mittels wenigstens einer auf diese elektrisch über den Halbleiterkörper (16, 25, 32, 39, 43, 48, 51, 55, 58, 61, 69, 74) einwirkende Zündstruktur (20, 26, 37, 38, 42, 47, 54, 60) eingeschaltet wird, wobei die Zündstruktur (20, 26, 37, 38, 42, 47, 54, 60) wiederum mittels des Einschaltsignals aktiviert wird,
**dadurch gekennzeichnet, dass**
ein spezifischer Flächenwiderstand der die Emitterstruktur (17, 23, 30, 35, 36, 41, 46, 53, 63) enthaltenden Basiszone (6, 8) so eingestellt wird, dass ein aus dem Einschaltsignal gewonnener, der Emitterstruktur (17, 23, 30, 35, 36, 41, 46, 53, 63) zugeführter minimaler Einschaltstrom eine Stromstärke von wenigstens 1 A zum Einschalten der Emitterstruktur (17, 23, 30, 35, 36, 41, 46, 53, 63) aufweist.

19. Verfahren nach dem vorhergehenden Anspruch,
**dadurch gekennzeichnet, dass**
die Zündstruktur eine Gate-Elektrode (20, 26, 37, 38) ist und als Einschaltsignal ein der Gate-Elektrode (20, 26, 37, 38) zugeführtes elektrisches Signal verwendet wird, das eine Stromstärke von wenigstens etwa 1 A, bevorzugt wenigstens etwa 2 A und noch bevorzugter zwischen etwa 5 A und etwa 10 A zum Einschalten der Emitterstruktur (17, 23, 30, 35, 36, 41, 46, 53, 63) aufweist.

## Claims

1. Short-circuit semiconductor component comprising a semiconductor body (16, 25, 32, 39, 43, 48, 51, 55, 58, 61, 69, 74), in which a rear-side base zone (6) of a first conduction type (p), an inner zone (7) of a second conduction type (n) complementary to the first conduction type (p), and a front-side base zone (8) of the first conduction type (p) are arranged successively in a vertical direction (v) proceeding from a rear side (4) with a rear-side centre (13) defined by its geometric centroid towards a front side (5), situated opposite the rear side (4), with a front-side centre (13) defined by its geometric centroid, wherein the rear-side base zone (6) is electrically conductively connected to a rear-side electrode (11), applied on the rear side (4), with a lateral rear-side electrode width (W_{ER}) given by its lateral extent, and the front-side base zone (8) is electrically conductively connected to a front-side electrode (10), applied on the front side (5), with a lateral front-side electrode width (W_{EV}) given by its lateral extent, wherein at least one front-side switch-on structure (17, 23, 30, 35, 41, 50, 53, 63) with a lateral front-side switch-on structure width (W_{SV}) given by its lateral extent is embedded into the front-side base zone (8) and is at least partly covered by the front-side electrode (10), and/or at least one rear-side switch-on structure (31, 36, 46, 57) with a lateral rear-side switch-on structure width (W_{SR}) given by its lateral extent is embedded into the rear-side base zone (6) and is at least partly covered by the rear-side electrode (11), wherein the switch-on structure (17, 23, 30, 31, 35, 36, 41, 46, 50, 53, 57, 63) is configured and arranged in such a way that it switches on depending on a predeterminable switch-on signal fed to the semiconductor body (16, 25, 32, 39, 43, 48, 51, 55, 58, 61, 69, 74) and, on a one-off basis, establishes a permanent, irreversible, electrically conductive, low-resistance connection between the front-side electrode (10) and the rear-side electrode (11) by virtue of the fact that,
if the front-side switch-on structure (17, 23, 30, 35, 41, 50, 53, 63) is present, the ratio of the lateral front-side switch-on structure width (W_{SV}) to the lateral front-side electrode width (W_{EV}) is less than 1 and, if the rear-side switch-on structure (31, 36, 46, 57) is present, the ratio of the lateral rear-side switch-on structure width (W_{SR}) to the lateral rear-side electrode width (W_{ER}) is less than 1, wherein the switch-on structure is an emitter structure (17, 23, 30, 35, 36, 41, 46, 53, 63) of the second conduction type (n), which is embedded into the front-side or rear-side base zone (6, 8) and is electrically conductively contacted with the electrode (10, 11) applied on the respective base zone (6, 8) and which is able to be switched on by means of at least one triggering structure (20, 26, 37, 38, 42, 47, 54, 60) which acts on it electrically via the semiconductor body (16, 25, 32, 39, 43, 48, 51, 55, 58, 61, 69, 74), wherein the triggering structure (20, 26, 37, 38, 42, 47, 54, 60) is activatable in turn by means of the switch-on signal,
**characterized in that**
a sheet resistivity of the base zone (6, 8) containing the emitter structure (17, 23, 30, 35, 36, 41, 46, 53, 63) is set such that a minimum switch-on current obtained from the switch-on signal and fed to the emitter structure (17, 23, 30, 35, 36, 41, 46, 53, 63) has a current intensity of at least 1 A for switching on the emitter structure (17, 23, 30, 35, 36, 41, 46, 53, 63).

2. Short-circuit semiconductor component according to Claim 1,
**characterized in that**
the ratio of the lateral switch-on structure width (W_{SV}, W_{SR}) to the corresponding lateral electrode width (W_{EV}, W_{ER}) of the respective electrode (10, 11) is chosen to be less than 4/5, preferably less than 3/4, more preferably less than 2/3, and even more preferably less than 1/2.

3. Short-circuit semiconductor component according to Claim 1 or 2,
**characterized in that**
the switch-on structure (31, 46, 50, 53, 57) is completely covered by the front-side electrode (10) and the rear-side electrode (11).

4. Short-circuit semiconductor component according to any of the preceding claims,
**characterized in that**
the front-side electrode (10) and the rear-side electrode (11) cover the front-side and respectively the rear-side centre (13) of the semiconductor body (16, 25, 32, 39, 43, 48, 51, 55, 58, 61, 69, 74), and the switch-on structure (17, 23, 30, 31, 35, 36, 41, 46, 50, 53, 57, 63) is arranged in the corresponding centre (13).

5. Short-circuit semiconductor component according to any of the preceding claims,
**characterized in that**
the triggering structure is a gate electrode (20, 26, 37, 38), and the switch-on signal is an electrical signal fed to the gate electrode (20, 26, 37, 38).

6. Short-circuit semiconductor component according to any of Claims 1 to 4,
**characterized in that**
the triggering structure is a light-sensitive region (42) arranged in the base zone (6, 8) containing the emitter structure (17, 23, 30, 35, 36, 41, 46, 53, 63), and the switch-on signal is an optical signal (44) fed to this light-sensitive region (42).

7. Short-circuit semiconductor component according to any of Claims 1 to 4,
**characterized in that**
the triggering structure is a breakdown structure (47, 54, 60), and the switch-on signal is the electrical voltage present between the front-side electrode (10) and the rear-side electrode (11).

8. Short-circuit semiconductor component according to any of the preceding claims,
**characterized in that**
an amplifying gate structure having at least one amplifying gate (AG) is arranged in the base zone (6, 8) containing the emitter structure (17, 23, 30, 35, 36, 41, 46, 53, 63), between the triggering structure (20, 26, 37, 38, 42, 47, 54, 60) and the emitter structure (17, 23, 30, 35, 36, 41, 46, 53, 63) electrically operatively connected thereto.

9. Short-circuit semiconductor component according to any of the preceding claims,
**characterized in that**
the switch-on structure (17, 23, 30, 35, 36, 41, 46, 53, 63) is spaced apart from the triggering structure (20, 26, 37, 38, 42, 60) in a radial direction (r) and has at least one switch-on structure segment (64) with a circumferential switch-on structure width (W_{UV}), which is open in a circumferential direction (u) of the semiconductor body (16, 25, 32, 39, 43, 48, 51, 55, 58, 61, 69, 74).

10. Short-circuit semiconductor component according to the preceding claim,
**characterized in that**
at least two switch-on structure segments (64) that are separated from one another are provided in the circumferential direction (u) of the semiconductor body (16, 25, 32, 39, 43, 48, 51, 55, 58, 61, 69, 74).

11. Short-circuit semiconductor component according to either of the two preceding claims,
**characterized in that**
the electrical resistance in the base zone (6, 8) containing the switch-on structure (17, 23, 30, 35, 36, 41, 46, 53, 63) is increased at least in a portion (67, 73) of the radial interspace between the switch-on structure (17, 23, 30, 35, 36, 41, 46, 53, 63) and the triggering structure (20, 26, 37, 38, 42, 60) with the exception of at least one passage channel (67) electrically coupling the at least one of the switch-on structure segments (64) to the triggering structure (20, 26, 37, 38, 42, 60).

12. Short-circuit semiconductor component according to any of the preceding claims,
**characterized in that**
the switch-on structure (17, 23, 30, 31, 35, 36, 41, 46, 50, 53, 57, 63) has at least one switch-on structure finger (28) extending radially outwards from the rest of the switch-on structure (17, 23, 30, 31, 35, 36, 41, 46, 50, 53, 57, 63) in the lateral direction (r).

13. Short-circuit semiconductor component according to the preceding claim,
**characterized in that**
the triggering structure (20, 26, 37, 38, 42, 47, 54, 60) has at least one triggering structure finger (27) following the contour of the at least one switch-on structure finger (28).

14. Short-circuit semiconductor component according to either of the two preceding claims,
**characterized in that**
the at least one switch-on structure finger (28) has a maximum radial finger length (L_{SF}) which is less than 4/5 of the lateral electrode width (W_{EV}, W_{ER}) of the electrode (10, 11) applied on the base zone (6, 8) containing the switch-on structure (17, 23, 30, 31, 35, 36, 41, 46, 50, 53, 57, 63).

15. Short-circuit semiconductor component according to any of the preceding claims,
**characterized in that**
a thickness (Wₙ) of the inner zone (7) in the vertical direction (v) is greater than 400 µm, more preferably greater than 600 µm, even more preferably greater than 800 µm, and further preferably greater than 1000 µm.

16. Short-circuit semiconductor component according to any of the preceding claims,
**characterized in that**
the front-side electrode (10) and the rear-side electrode (11) are each electrically conductively pressure-contacted by means of a metallic contact plate (18, 19).

17. Short-circuit semiconductor component according to the preceding claim,
**characterized in that**
the lateral width of the respective contact plate (18, 19) corresponds to the lateral electrode width (W_{EV}, W_{ER}) of the corresponding pressure-contacted electrode (10, 11).

18. Method for operating a short-circuit semiconductor component (15, 22, 29, 34, 40, 45, 49, 52, 56, 59, 62, 66, 70, 72) comprising a semiconductor body (16, 25, 32, 39, 43, 48, 51, 55, 58, 61, 69, 74), in which a rear-side base zone (6) of a first conduction type (p), an inner zone (7) of a second conduction type (n) complementary to the first conduction type (p), and a front-side base zone (8) of the first conduction type (p) are arranged successively in a vertical direction (v) proceeding from a rear side (4) with a rear-side centre (13) defined by its geometric centroid towards a front side (5), situated opposite the rear side (4), with a front-side centre (13) defined by its geometric centroid, wherein the rear-side base zone (6) is electrically conductively connected to a rear-side electrode (11), applied on the rear side (4), with a lateral rear-side electrode width (W_{ER}) given by its lateral extent, and the front-side base zone (8) is electrically conductively connected to a front-side electrode (10), applied on the front side (5), with a lateral front-side electrode width (W_{EV}) given by its lateral extent, wherein at least one front-side switch-on structure (17, 23, 30, 35, 41, 50, 53, 63) with a lateral front-side switch-on structure width (W_{SV}) given by its lateral extent is embedded into the front-side base zone (8) and is at least partly covered by the front-side electrode (10), and/or at least one rear-side switch-on structure (31, 36, 46, 57) with a lateral rear-side switch-on structure width (W_{SR}) given by its lateral extent is embedded into the rear-side base zone (6) and is at least partly covered by the rear-side electrode (11), wherein, if the front-side switch-on structure (17, 23, 30, 35, 41, 50, 53, 63) is present, the ratio of the lateral front-side switch-on structure width (W_{SV}) to the lateral front-side electrode width (W_{EV}) is defined to be less than 1 and, if the rear-side switch-on structure (31, 36, 46, 57) is present, the ratio of the lateral rear-side switch-on structure width (W_{SR}) to the lateral rear-side electrode width (W_{ER}) is defined to be less than 1, such that, in a non-short-circuited operating state, an electrical voltage present between the front-side electrode (10) and the rear-side electrode (11) is blocked with long-term stability in both polarities and, in a short-circuit operating mode, a predeterminable switch-on signal is fed to the semiconductor body (16, 25, 32, 39, 43, 48, 51, 55, 58, 61, 69, 74) on a one-off basis, which signal switches on the correspondingly configured and arranged switch-on structure (17, 23, 30, 31, 35, 36, 41, 46, 50, 53, 57, 63), as a result of which a permanent, irreversible, electrically conductive, low-resistance connection between the front-side electrode (10) and the rear-side electrode (11) is established in the form of a fused portion on account of the current flow caused by the electrical voltage present between them, wherein the switch-on structure is an emitter structure (17, 23, 30, 35, 36, 41, 46, 53, 63) of the second conduction type (n), which is embedded into the front-side or rear-side base zone (6, 8) and is electrically conductively contacted with the electrode (10, 11) applied on the respective base zone (6, 8) and which is switched on by means of at least one triggering structure (20, 26, 37, 38, 42, 47, 54, 60) which acts on it electrically via the semiconductor body (16, 25, 32, 39, 43, 48, 51, 55, 58, 61, 69, 74), wherein the triggering structure (20, 26, 37, 38, 42, 47, 54, 60) is activated in turn by means of the switch-on signal,
**characterized in that**
a sheet resistivity of the base zone (6, 8) containing the emitter structure (17, 23, 30, 35, 36, 41, 46, 53, 63) is set such that a minimum switch-on current obtained from the switch-on signal and fed to the emitter structure (17, 23, 30, 35, 36, 41, 46, 53, 63) has a current intensity of at least 1 A for switching on the emitter structure (17, 23, 30, 35, 36, 41, 46, 53, 63).

19. Method according to the preceding claim, **characterized in that**
the triggering structure is a gate electrode (20, 26, 37, 38), and the switch-on signal used is an electrical signal which is fed to the gate electrode (20, 26, 37, 38) and which has a current intensity of at least approximately 1 A, preferably at least approximately 2 A and even more preferably between approximately 5 A and approximately 10 A for switching on the emitter structure (17, 23, 30, 35, 36, 41, 46, 53, 63).

## Revendications

1. Composant à semiconducteur à court-circuit comportant un corps (16, 25, 32, 39, 43, 48, 51, 55, 58, 61, 69, 74) à semiconducteur, dans lequel, dans une direction (v) verticale en allant d'une face (4) arrière, ayant un centre (13) du côté arrière, fixée par son centre de gravité géométrique à une face (5) avant, opposée à la face (4) arrière et ayant un centre (13) du côté avant, fixée par son centre de gravité géométrique, sont disposées successivement une zone (6) de base du côté arrière d'un premier type (p) de conductivité, une zone (7) intérieure d'un deuxième type (n) de conductivité complémentaire du premier type (p) de conductivité et une zone (8) de base du côté avant du premier type (p) de conductivité, dans lequel la zone (6) de base du côté arrière est reliée d'une manière conductrice de l'électricité à une électrode (11) du côté arrière déposée sur la face (4) arrière et ayant une largeur (W_{ER}) latérale d'électrode du côté arrière donnée par son étendue latérale et la zone (8) de base du côté avant est reliée d'une manière conductrice de l'électricité à une électrode (10) du côté avant disposée sur la face (5) avant et ayant une largeur (W_{EV}) latérale d'électrode du côté avant donnée par son étendue latérale, dans lequel, dans la zone (8) de base du côté avant est incorporée au moins une structure (17, 23, 30, 35, 41, 50, 53, 63) de mise en circuit du côté avant ayant une largeur (W_{SV}) latérale de structure de mise en circuit du côté avant donnée par son étendue latérale et recouverte au moins en partie par l'électrode (10) du côté avant et/ou dans la zone (6) de base du côté arrière, est .
incorporée au moins une structure (31, 36, 46, 57) de mise en circuit du côté arrière ayant une largeur (W_{SR}) latérale de structure de mise en circuit du côté arrière donnée par son étendue latérale et recouverte au moins en partie par l'électrode (11) du côté arrière, dans lequel la structure (17, 23, 30, 31, 35, 36, 41, 46, 50, 53, 57, 63) de mise en circuit est constituée et disposée de manière à mettre en circuit, en fonction d'un signal de mise en circuit pouvant être déterminé à l'avance envoyé au corps (16, 25, 32, 39, 43, 48, 51, 55, 58, 61, 69, 74) à semiconducteur, et à donner une fois une liaison à petite valeur ohmique, permanente, irréversible, conductrice de l'électricité entre l'électrode (10) du côté avant et l'électrode (11) du côté arrière, par le fait que, en présence de la structure (17, 23, 30, 35, 41, 50, 53, 63) de mise en circuit du côté avant, le rapport de la largeur (W_{SV}) latérale de la structure de mise en circuit du côté avant à la largeur (W_{EV}) latérale d'électrode du côté avant est plus petite que 1 et, en présence de la structure (31, 36, 46, 57) de mise en circuit du côté arrière, le rapport de la largeur (W_{SR}) latérale de la structure de mise en circuit du côté arrière à la largeur (W_{ER}) latérale d'électrode du côté arrière est plus petit que 1, dans lequel la structure de mise en circuit est une structure (17, 23, 30, 35, 36, 41, 46, 53, 63) émettrice du deuxième type de conductivité (n) contactée d'une manière conductrice de l'électricité avec l'électrode (10, 11) déposée sur la zone (6, 8) de base respective, incorporée dans la zone (6, 8) de base du côté avant et du côté arrière, qui peut être mise en circuit au moyen d'au moins une structure (20, 26, 37, 38, 42, 47, 54, 60) d'amorçage agissant électriquement par l'intermédiaire du corps (16, 25, 32, 39, 43, 48, 51, 55, 58, 61, 69, 74) à semiconducteur, dans lequel la structure (20, 26, 37, 38, 42, 47, 54, 60) .
d'amorçage peut être activée à nouveau au moyen du signal de mise en circuit,
**caractérisé en ce qu'**
une résistance spécifique de surface de la zone (6, 8) de base contenant la structure (17, 23, 30, 35, 36, 41, 46, 53, 63) émettrice est réglée de manière à ce qu'un courant de mise en circuit minimum, obtenu à partir du signal de mise en circuit et envoyé à la structure (17, 23, 30, 35, 36, 41, 46, 53, 63) émettrice, ait une intensité de courant d'au moins 1 A pour la mise en circuit de la structure (17, 23, 30, 35, 36, 41, 46, 53, 63) émettrice.

2. Composant à semiconducteur à court-circuit suivant la revendication 1,
**caractérisé en ce que**
le rapport de la largeur (W_{SV}, W_{SR}) latérale de mise en circuit à la largeur (W_{EV}, W_{ER}) latérale d'électrode correspondante de l'électrode (10, 11) respective est choisi plus petit que 4/5, de préférence plus petit que 3/4, de préférence plus petit que 2/3, et d'une manière encore plus préférée, plus petit que 1/2.

3. Composant à semiconducteur à court-circuit suivant la revendication 1 ou 2,
**caractérisé en ce que**
la structure (31, 46, 50, 53, 57) de mise en circuit est recouverte complètement par l'électrode (10) du côté avant et l'électrode (11) du côté arrière.

4. Composant à semiconducteur à court-circuit suivant l'une des revendications précédentes,
**caractérisé en ce que**
l'électrode (10) du côté avant et l'électrode (11) du côté arrière recouvrent le centre (13) du côté avant et
.
respectivement du côté arrière du corps (16, 25, 32, 39, 43, 48, 51, 55, 58, 61, 69, 74) à semiconducteur et la structure (17, 23, 30, 31, 35, 36, 41, 46, 50, 53, 57, 63) de mise en circuit est disposée au centre (13) correspondant.

5. Composant à semiconducteur à court-circuit suivant l'une des revendications précédentes,
**caractérisé en ce que**
la structure d'amorçage est une électrode (20, 26, 37, 38) de grille et le signal de mise en circuit est un signal électrique envoyé à l'électrode (20, 26, 37, 38) de grille.

6. Composant à semiconducteur à court-circuit suivant l'une des revendications 1 à 4,
**caractérisé en ce que**
la structure d'amorçage est une zone (42) sensible à la lumière disposée dans la zone (6, 8) de base contenant la structure (17, 23, 30, 35, 36, 41, 46, 53, 63) électrique et le signal de mise en circuit est un signal (44) optique envoyé à cette zone (42) sensible à la lumière.

7. Composant à semiconducteur à court-circuit suivant l'une des revendications 1 à 4,
**caractérisé en ce que**
la structure d'amorçage est une structure (47, 54, 60) de traversée et le signal de mise en circuit est une tension s'appliquant entre l'électrode (10) du côté avant et l'électrode (11) du côté arrière.

8. Composant à semiconducteur à court-circuit suivant l'une des revendications précédentes,
**caractérisé en ce que,**
dans la zone (6, 8) de base contenant la structure (17, 23, 30, 35, 36, 41, 46, 53, 63) émettrice, entre la structure. (20, 26, 37, 38, 42, 47, 54, 60) d'amorçage et la structure (17, 23, 30, 35, 36, 41, 46, 53, 63) émettrice reliée en action électriquement, est disposée une structure de grille d'amplification ayant au moins une grille (AG) d'amplification.

9. Composant à semiconducteur à court-circuit suivant l'une des revendications précédentes,
**caractérisé en ce que**
la structure (17, 23, 30, 35, 36, 41, 46, 53, 63) de mise en circuit est à distance dans la direction (r) radiale de la structure (20, 26, 37, 38, 42, 60) d'amorçage et a au moins un segment (64) ayant une largeur (W_{UV}) de structure d'amorçage faisant le tour, ouvert dans une direction (u) de pourtour du corps (16, 25, 32, 39, 43, 48, 51, 55, 58, 61, 69, 74) à semiconducteur.

10. Composant à semiconducteur à court-circuit suivant la revendication précédente,
**caractérisé en ce que,**
dans la direction (u) de pourtour du corps (16, 25, 32, 39, 43, 48, 51, 55, 58, 61, 69, 74) à semiconducteur, sont prévus au moins deux segments (64) de structure de mise en circuit séparés l'un de l'autre.

11. Composant à semiconducteur à court-circuit suivant l'une des deux revendications précédentes,
**caractérisé en ce que**
la résistance électrique dans la zone (6, 8) de base contenant la structure (17, 23, 30, 35, 36, 41, 46, 53, 63) de mise en circuit est, au moins dans une partie (67, 73) de l'espace intermédiaire radial entre la structure (17, 23, 30, 35, 36, 41, 46, 53, 63) de mise en circuit et la structure (20, 26, 37, 38, 42, 60) d'amorçage, augmentée à .
l'exception d'au moins un passage (67) de traversée couplant électriquement au moins l'un des segments (64) de la structure de mise en circuit à la structure (20, 26, 37, 38, 42, 60) d'amorçage.

12. Composant à semiconducteur à court-circuit suivant l'une des revendications précédentes,
**caractérisé en ce que**
la structure (17, 23, 30, 31, 35, 36, 41, 46, 50, 53, 57, 63) de mise en circuit a au moins un doigt (28) de structure de mise en circuit s'étendant vers l'intérieur radialement dans une direction (r) latérale à partir du reste de la structure (17, 23, 30, 31, 35, 36, 41, 46, 50, 53, 57, 63) de mise en circuit.

13. Composant à semiconducteur à court-circuit suivant la revendication précédente,
**caractérisé en ce que**
la structure (20, 26, 37, 38, 42, 47, 54, 60) d'amorçage a au moins un contour du doigt (27) de structure d'amorçage suivant le contour du au moins un doigt (28) de structure d'amorçage.

14. Composant à semiconducteur à court-circuit suivant l'une des deux revendications précédentes,
**caractérisé en ce que**
le au moins un doigt (28) de structure d'amorçage a une longueur (L_{SF}) radiale de doigt maximum, qui est plus petite que 4/5 de la largeur (W_{EV}, W_{ER}) latérale d'électrode de l'électrode (10, 11), qui est déposée sur la zone (6, 8) de base contenant la structure (17, 23, 30, 31, 35, 36, 41, 46, 50, 53, 57, 63) de mise en circuit.

15. Composant à semiconducteur à court-circuit suivant l'une des revendications précédentes,
**caractérisé en ce qu'**
une épaisseur (Wₙ) de la zone (7) intérieure à la direction (v) verticale est plus grande que 400 µm, de préférence plus grande que 600 µm, d'une manière encore plus préférée plus grande que 800 µm, et d'une manière encore davantage préférée plus grande que 1000 µm.

16. Composant à semiconducteur à court-circuit suivant l'une des revendications précédentes,
**caractérisé en ce que**
l'électrode (10) du côté avant et l'électrode (11) du côté arrière sont contactées en pression d'une manière conductrice de l'électricité respectivement au moyen d'un disque (18, 19) métallique.

17. Composant à semiconducteur à court-circuit suivant la revendication précédente,
**caractérisé en ce que**
la largeur latérale du disque (18, 19) respectif de contact correspond à la largeur (W_{EV}, W_{ER}) latérale d'électrode de l'électrode (10, 11) mise en contact par pression correspondante.

18. Procédé pour faire fonctionner un composant (15, 22, 29, 34, 40, 45, 49, 52, 56, 59, 62, 66, 70, 72) à court-circuit, qui a un corps (16, 25, 32, 39, 43, 48, 51, 55, 58, 61, 69, 74) à semiconducteur, dans lequel, dans une direction (v) verticale, en allant d'une face (4) arrière ayant un centre (13) du côté arrière, fixée par son centre de gravité géométrique à une face (5) avant, opposée à la face (4) arrière et ayant un centre (13) du côté avant, fixée par son centre de gravité géométrique, sont disposées successivement .
une zone (6) de base du côté arrière d'un premier type (p) de conductivité, une zone (7) intérieure d'un deuxième type (n) de conductivité complémentaire du premier type (p) de conductivité et une zone (8) de base du côté avant du premier type (p) de conductivité, dans lequel la zone (6) de base du côté arrière est reliée d'une manière conductrice de l'électricité à une électrode (11) du côté arrière déposée sur la face (4) arrière et ayant une largeur (W_{ER}) latérale d'électrode du côté arrière donnée par son étendue latérale et la zone (8) de base du côté avant est reliée d'une manière conductrice de l'électricité à une électrode (10) du côté avant disposée sur la face (5) avant et ayant une largeur (W_{EV}) latérale d'électrode du côté avant donnée par son étendue latérale, dans lequel, dans la zone (8) de base du côté avant est incorporée au moins une structure (17, 23, 30, 35, 41, 50, 53, 63) de mise en circuit du côté avant ayant une largeur (W_{SV}) latérale de structure de mise en circuit du côté avant donnée par son étendue latérale et recouverte au moins en partie par l'électrode (10) du côté avant et/ou dans la zone (6) de base du côté arrière, est incorporée au moins une structure (31, 36, 46, 57) de mise en circuit du côté arrière ayant une largeur (W_{SR}) latérale de structure de mise en circuit du côté arrière donnée par son étendue latérale et recouverte au moins en partie par l'électrode (11) du côté arrière, dans lequel, en la présence de la structure (17, 23, 30, 35, 41, 50, 53, 63) de mise en circuit du côté avant, le rapport de la largeur (W_{SV}) latérale de mise en circuit du côté avant à la largeur (W_{EV}) latérale d'électrode du côté avant est fixé plus petit que 1, et en présence de la présence de la structure (31, 36, 46, 57) de mise en circuit du côté arrière, le rapport de la largeur (W_{SR}) latérale de la structure de mise en circuit du côté arrière à la largeur (W_{ER}) latérale d'électrode du côté arrière est fixé plus petit que 1, de .
sorte que, dans un état de fonctionnement long en court-circuit, une tension électrique s'appliquant entre l'électrode (10) du côté avant et l'électrode (11) du côté arrière est bloquée dans les deux polarités d'une manière stable en longue durée, et on envoie au corps (16, 25, 32, 39, 43, 48, 51, 55, 58, 61, 69, 74) à semiconducteur, dans un type de fonctionnement à court-circuit, une seule fois un signal de mise en circuit pouvant être déterminé à l'avance, qui met en circuit la structure (17, 23, 30, 31, 35, 36, 41, 46, 50, 53, 57, 63) de mise en circuit constituée et disposée de manière correspondante, grâce à quoi on produit une liaison à petite valeur ohmique, permanente, irréversible, conductrice de l'électricité entre l'électrode (10) du côté avant et l'électrode (11) du côté arrière sous la forme d'une fusion en raison du flux de courant provoqué par la tension électrique s'appliquant entre celles-ci, dans lequel la structure de mise en circuit est une structure (17, 23, 30, 35, 36, 41, 46, 53, 63) émettrice du deuxième type (n) de conductivité incorporée dans la zone (6, 8) de base du côté avant ou du côté arrière, contactée d'une manière conductrice de l'électricité avec l'électrode (10, 11) déposée sur la zone (6, 8) de base respective, que l'on met en circuit au moyen d'une structure (20, 26, 37, 38, 42, 47, 54, 60) d'amorçage agissant électriquement par l'intermédiaire du corps (16, 25, 32, 39, 43, 48, 51, 55, 58, 61, 69, 74) à semiconducteur, dans lequel on active à nouveau la structure (20, 26, 37, 38, 42, 47, 54, 60) d'amorçage au moyen du signal de mise en circuit, **caractérisé en ce qu'**
une résistance spécifique de surface de la zone (6, 8) de base contenant la structure (17, 23, 30, 35, 36, 41, 46, 53, 63) émettrice est réglée de manière à ce qu'un courant de mise en circuit minimum, obtenu à partir du signal de mise en circuit et envoyé à la structure (17, 23, 30, 35, 36, 41, 46, 53, 63) émettrice, ait une intensité de courant d'au moins 1 A pour la mise en circuit de la structure (17, 23, 30, 35, 36, 41, 46, 53, 63) émettrice.

19. Procédé suivant la revendication précédente,
**caractérisé en ce que**
la structure d'amorçage est un électrode (20, 26, 37, 38) de grille et on utilise, comme signal de mise en circuit, un signal électrique envoyé à l'électrode (20, 26, 37, 38) de grille, qui a une intensité du courant d'au moins environ 1 A, de préférence d'au moins environ 2 A, et d'une manière encore plus préférée comprise entre environ 5 A et environ 10 A pour la mise en circuit de la structure (17, 23, 30, 35, 36, 41, 46, 53, 63) émettrice.
